# EUROPEAN PATENT APPLICATION

(11) **EP 4 428 615 A1**
(43) Date of publication of application: **11.09.2024**
(21) Application number: 24161082.3
(22) Date of filing: 04.03.2024
(51) Int. Cl.: G03F 7/095, G03F 7/11

(54) **MATERIAL FOR FORMING ADHESIVE FILM, PATTERNING PROCESS, AND METHOD FOR FORMING ADHESIVE FILM**

(30) Priority: 10.03.2023 JP 2023038031
(71) Applicant: SHIN-ETSU CHEMICAL CO., LTD., Tokyo 1000005 (JP)
(72) Inventor: WATABE, Mamoru, Niigata (JP); IWAMORI, Shohei, Niigata (JP); BIYAJIMA, Yusuke, Niigata (JP)
(74) Representative: Sonnenhauser, Thomas Martin

(57) **Abstract**

The present invention is a material for forming an adhesive film for an adhesive film formed directly under a resist upper layer film, includes: (A) a resin having a structural unit containing an acid-dissociable group and having two or more units represented by the formula (1) where R¹ represents a hydrogen atom or a methyl group, and R² represents a group selected from the formulae (1-1) to (1-3); and (C) an organic solvent, and the material comprises (B) a photo-acid generator and/or the resin (A) having the photo-acid generating unit. This provides a material for forming an adhesive film in a fine patterning process by a multilayer resist method, where the material gives an adhesive film with high adhesiveness to a resist upper layer film, suppresses fine pattern collapse, and can form an excellent pattern profile; a patterning process using the material; and a method for forming the adhesive film.

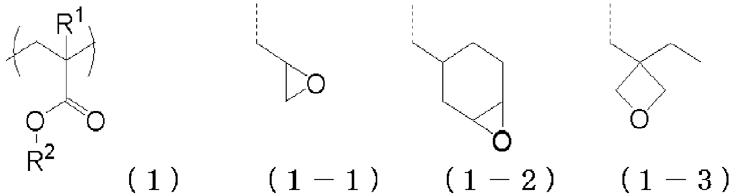

## Description

### TECHNICAL FIELD

The present invention relates to: a material for forming an adhesive film; a patterning process using the material for forming an adhesive film; and a method for forming an adhesive film using the material for forming an adhesive film.

### BACKGROUND ART

As LSI advances toward high integration and high processing speed, miniaturization of pattern size is progressing rapidly. Along with the miniaturization, lithography technology has achieved a fine patterning by shortening the wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a resist mechanism that makes an exposed part soluble, thereby dissolving the exposed part to form a pattern and processing a substrate to be processed coated with a photoresist composition by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the film thickness of the photoresist film has been thinned along with the miniaturization.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus damaged during processing of the substrate to be processed and the photoresist film collapses during processing of the substrate to be processed, so that the resist pattern cannot be transferred accurately to the substrate to be processed. Accordingly, higher dry etching resistance has been required in a photoresist composition accompanying miniaturization of the pattern. In addition, resins used for photoresist compositions have been required to have low absorbance at the wavelength to be used for the exposure owing to the shortening of the exposure wavelength. Accordingly, along with the shift from i-beam to KrF and to ArF, the resin also shifts to novolak resins, polyhydroxystyrene, and resins having an aliphatic polycyclic skeleton. This shift actually accelerates an etching rate under the dry etching conditions, and recent photoresist compositions having high resolution tend to have low etching resistance.

As a result, a substrate to be processed has to be dry-etched with a thinner photoresist film having lower etching resistance. A material for this process and the process itself are urgently needed.

A multilayer resist method is one solution for these problems. This method is as follows: a middle layer film having a different etching selectivity from a photoresist film (i.e., a resist upper layer film) is placed between the resist upper layer film and a substrate to be processed; a pattern is formed in the resist upper layer film; then, the pattern is transferred to the middle layer film by dry etching while using the resist upper layer film pattern as a dry etching mask; and the pattern is further transferred to the substrate to be processed by dry etching while using the middle layer film as a dry etching mask.

One of the multilayer resist methods is a 3-layer resist method, which can be performed with a typical resist composition used in the monolayer resist method. For example, this 3-layer resist method includes the following steps: an organic film containing a novolak or the like is formed as a resist underlayer film on a substrate to be processed; a silicon-containing film is formed thereon as a silicon-containing resist middle layer film; and a usual organic photoresist film is formed thereon as a resist upper layer film. Since the organic resist upper layer film exhibits a favorable etching selectivity ratio relative to the silicon-containing resist middle layer film when dry etching is performed with fluorine-based gas plasma, the resist upper layer film pattern is transferred to the silicon-containing resist middle layer film by dry etching with fluorine-based gas plasma. Furthermore, when etching is performed using oxygen gas or hydrogen gas, the silicon-containing resist middle layer film exhibits a favorable etching selectivity ratio relative to the resist underlayer film, so that the silicon-containing middle layer film pattern is transferred to the resist underlayer film by etching with oxygen gas or hydrogen gas. According to this process, even when using a photoresist composition which is difficult to form a pattern in so that the pattern has a sufficient film thickness for directly processing the substrate to be processed or a photoresist composition which does not have sufficient dry etching resistance for processing the substrate, a pattern can be transferred to a silicon-containing film (silicon-containing resist middle layer film). In this manner, it is possible to obtain a pattern of an organic film (resist underlayer film) containing a novolak or the like having a sufficient dry etching resistance for the processing.

In recent years, as an effective technology to take the place of a combination of ArF immersion lithography and multiple exposure process, vacuum ultraviolet ray (EUV) lithography with a wavelength of 13.5 nm is attracting attention. By using this technology, it has become possible to form a fine pattern with a half pitch of 25 nm or less in one exposure.

Meanwhile, in EUV lithography, higher sensitivity in a resist material is strongly required to compensate for insufficient output of a light source. However, increase in shot noise that accompanies higher sensitization leads to increase in edge roughness (LER and LWR) of line patterns, and compatibility of higher sensitization and low edge roughness is given as an important problem in EUV lithography.

As an attempt to achieve higher sensitivity of a resist or to lower the influence of shot noise, it has been considered in recent years to use a metal material in a resist material. A compound that contains a metallic element such as barium, titanium, hafnium, zirconium, or tin has a higher absorbance of EUV light compared to an organic material that does not contain metal, and improvement of photosensitivity of resists and suppression of the influence of shot noise can be expected. Furthermore, a metal-containing resist pattern is expected to achieve a high-selectivity etching process by combining with an underlayer film made from a non-metal material.

For example, a resist material with added metal salt or organometallic complex (Patent Documents 1, 2) or a non-chemically amplified resist material that uses nanoparticles of metal oxide (Patent Documents 3, 4, Non Patent Document 1) are considered. However, the resolution of these metal-containing resists have not yet reached the level considered necessary for practical use, and further improvement of resolution is required.

Furthermore, advents of ArF immersion lithography, EUV lithography, and so forth start to realize finer pattern formations. On the other hand, ultrafine patterns have such small areas of contact that the patterns quite easily collapse. Suppressing such pattern collapse is an enormous challenge. Recently, it is regarded that the interaction in the interface between the resist upper layer film and the resist underlayer film in fine patterns has an effect on pattern collapse, and the improvement of the performance of resist underlayer films is also considered necessary.

A material is reported that improves adhesiveness to a resist upper layer film by the use of a resist underlayer film containing a polar functional group such as a lactone structure or a urea structure in order to suppress pattern collapse (Patent Documents 4, 5).

There is also a report that the rectangularity of a pattern can be improved by using a composition for forming a resist underlayer film, containing a polymer, an acid generator, and a solvent (Patent Document 6).

However, in the current situation, where finer pattern formation is required, even these materials can still not be said to have sufficient pattern collapse suppression performance. Even in cases where good adhesion can be achieved, there has been a problem that scum is generated in space portions due to the high adhesion.

For the above reasons, there is requirement for a pattern material that has higher pattern collapse suppression performance and adhesiveness, and can also prevent the generation of scum in space portions.

### CITATION LIST

### PATENT LITERATURE

Patent Document 1: JP 5708521 B2
Patent Document 2: JP 5708522 B2
Patent Document 3: US 9310684 B2
Patent Document 4: WO 2003/017002 A1
Patent Document 5: WO 2018/143359 A1
Patent Document 6: WO 2022/244682 A1

### NON PATENT LITERATURE

Non Patent Document 1: Proc. SPIE Vol. 7969, 796915 (2011)

### SUMMARY OF INVENTION

### TECHNICAL PROBLEM

The present invention has been made in view of the above-described circumstances. An object of the present invention is to provide: a material for forming an adhesive film in a fine patterning process by a multilayer resist method in a semiconductor device manufacturing process, where the material gives an adhesive film that has high adhesiveness to a resist upper layer film, has an effect of suppressing fine pattern collapse, and that also makes it possible to form an excellent pattern profile; a patterning process using the material; and a method for forming the adhesive film.

### SOLUTION TO PROBLEM

To achieve the object, the present invention provides a material for forming an adhesive film for an adhesive film formed directly under a resist upper layer film, wherein the material for forming an adhesive film comprises: (A) a resin having a structural unit containing an acid-dissociable group and having at least two kinds of structural units represented by the following general formula (1), the resin optionally having a structural unit that generates an acid due to light; and
(C) an organic solvent, wherein the material for forming an adhesive film comprises
(B) a photo-acid generator, the resin (A) having the structural unit that generates an acid due to light, or both the photo-acid generator (B) and the resin (A) having the acid-generating structural unit, 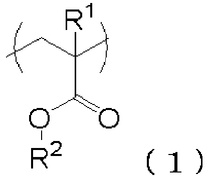 wherein R¹ represents a hydrogen atom or a methyl group and R² represents a group selected from the following formulae (1-1) to (1-3), 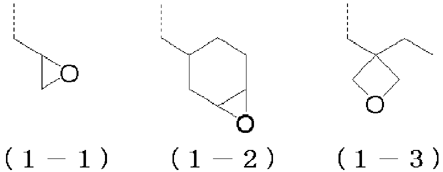 wherein a broken line represents an attachment point.

Using the inventive material for forming an adhesive film, it is possible to give an adhesive film that has high adhesiveness to a resist upper layer film, has an effect of suppressing fine pattern collapse, and also forms a favorable pattern profile.

In the present invention, the structural unit containing an acid-dissociable group is preferably represented by any of the following general formulae (2) to (4), 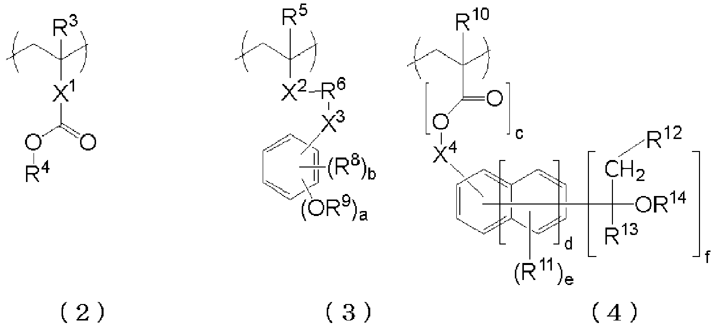 wherein R³, R⁵, and R¹⁰ each independently represent a hydrogen atom or a methyl group; R⁴ and R⁹ each independently represent an acid-dissociable group; X¹ represents a single bond or a linking group having 1 to 14 carbon atoms and containing a phenylene group, a naphthylene group, an ester bond, an ether bond, or a lactone ring; X² represents a single bond, an ester bond, or an amide bond; X³ represents a single bond, an ether bond, or an ester bond; R⁶ represents a single bond or a saturated hydrocarbylene group having 1 to 6 carbon atoms, part of the carbon atoms optionally being substituted with an ether bond or an ester bond; R⁸ represents a fluorine atom, a trifluoromethyl group, a cyano group, or a saturated hydrocarbyl group having 1 to 6 carbon atoms; "a" represents 1 or 2 and "b" represents an integer of 0 to 4, provided that 1 ≤ a + b ≤ 5; X⁴ represents a single bond or an alkylene group having 1 to 10 carbon atoms and optionally containing an ethereal oxygen atom in a chain thereof; each R¹¹ independently represents a hydrogen atom, a halogen atom, a linear, branched, or cyclic acyloxy group having 2 to 8 carbon atoms and optionally being halogenated, a linear, branched, or cyclic alkyl group having 1 to 6 carbon atoms and optionally being halogenated, or a linear, branched, or cyclic alkoxy group having 1 to 6 carbon atoms and optionally being halogenated; R¹² and R¹³ each independently represent a hydrogen atom, a linear or branched alkyl group having 1 to 15 carbon atoms and optionally being substituted with a hydroxy group or an alkoxy group, or a monovalent aromatic ring-containing group optionally having a substituent; R¹⁴ represents a hydrogen atom, a linear, branched, or cyclic monovalent aliphatic hydrocarbon group having 1 to 10 carbon atoms and optionally containing an ethereal oxygen atom in a chain or containing a carbonyl group or a carbonyloxy group in a chain or at an end of a chain, or a monovalent aromatic ring-containing group optionally having a substituent, OR¹⁴ being an acid-dissociable group; "c" represents 0 or 1; "d" represents an integer of 0 to 2; "f" represents an integer of 1 to 3; and "e" equals 5+2d-f.

Such a material for forming an adhesive film can achieve better adhesiveness to a resist upper layer film and a better effect of suppressing pattern collapse.

Furthermore, in the present invention, the resin (A) preferably further has at least one of structural units represented by the following general formulae (5) and (6), 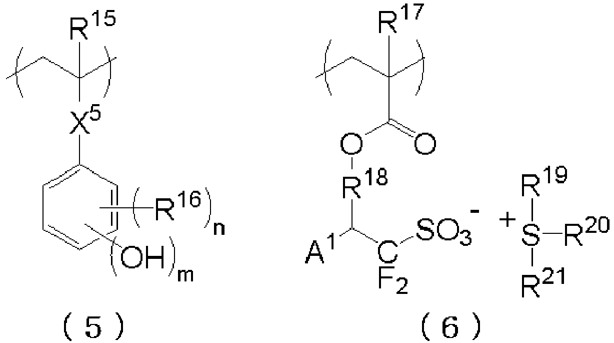 wherein R¹⁵ and R¹⁷ each independently represent a hydrogen atom or a methyl group; R¹⁶ represents an alkyl group having 1 to 3 carbon atoms; "m" represents an integer of 1 or 2 and "n" represents an integer of 0 to 4, provided that m+n is an integer of 1 or more and 5 or less; X³ represents a single bond or an alkylene group having 1 to 10 carbon atoms and optionally containing an oxygen atom; R¹⁸ represents a single bond, -Z²¹-C(=O)-O-, -Z²¹-O-, or -Z²¹-O-C(=O)-; Z²¹ represents a saturated hydrocarbylene group having 1 to 12 carbon atoms and optionally containing a carbonyl group, an ester bond, or an ether bond; R¹⁹ to R²¹ each independently represent a hydrocarbyl group having 1 to 20 carbon atoms and optionally containing a heteroatom, any two of R¹⁹, R²⁰, and R²¹ optionally bonding with each other to form a ring together with a sulfur atom bonded therewith; and A¹ represents a hydrogen atom or a trifluoromethyl group.

The structural unit represented by the general formula (5) contributes to the improvement of adhesiveness, and the structural unit represented by the general formula (6) functions as an acid-generating group. When the resin has such a structural unit, the material can exert good adhesiveness and scum prevention ability without specially adding an acid generator.

Furthermore, in the present invention, a total number of moles of the structural unit represented by the general formula (1) is preferably 0.10 or more and 0.99 or less, a total number of moles of the structural unit containing an acid-dissociable group is preferably 0.001 or more and 0.60 or less, and a total number of moles of the structural units represented by (5) and (6) is preferably 0 or more and 0.60 or less where a total number of moles of all the structural units in the resin (A) is 1.0.

In such a material for forming an adhesive film, the amount of polar groups in the film surface changes due to acid-dissociable groups being eliminated in exposed portions, and it is possible to form an adhesive film that has high adhesiveness to a resist upper layer film and the ability to suppress scum in patterned portions.

In the present invention, the resin (A) preferably has a weight-average molecular weight of 3,000 to 70,000.

A material for forming an adhesive film containing a resin having a weight-average molecular weight within such a range has excellent film-formability. In addition, the generation of a sublimation product during heat-curing can be suppressed and the contamination of apparatuses due to sublimation products can be suppressed.

The present inventive material preferably further comprises one or more of (D) a surfactant, (E) a crosslinking agent, and (F) a thermal acid generator.

It is possible to make fine adjustments to performance according to customer requirements, for example, curability, film-formability, filling property, optical characteristics, and reduction of sublimation products by the presence, absence, or choice of these additives, and this is favorable for practicality.

The present invention also provides: a material for forming an adhesive film for a negative resist film, being the above-described material for forming an adhesive film, wherein the structural unit containing an acid-dissociable group is represented by the general formula (2) or (3); and a material for forming an adhesive film for a positive resist film, being the above-described material for forming an adhesive film, wherein the structural unit containing an acid-dissociable group is represented by the general formula (4) .

In the present invention, it is possible to provide both a material for forming an adhesive film for a negative resist film and a material for forming an adhesive film for a positive resist film by selecting an appropriate structural unit containing an acid-dissociable group in the above-described material for forming an adhesive film.

The present invention also provides a coating film for forming an adhesive film, comprising the above-described material for forming an adhesive film and having a thickness of 2 nm or more and 50 nm or less.

Such a coating film for forming an adhesive film makes it possible for the obtained adhesive film to be removed by etching performed for a short time, and a thinner film can be selected as an upper layer resist.

In addition, the present invention provides a patterning process for forming a pattern in a substrate to be processed, comprising the steps of:
(I-1) applying the inventive material for forming an adhesive film on a substrate to be processed and then performing a heat treatment to form an adhesive film;
(I-2) forming a resist upper layer film on the adhesive film by using a photoresist material;
(I-3) subjecting the resist upper layer film to pattern exposure and then to development with a developer to form a pattern in the resist upper layer film;
(I-4) transferring the pattern to the adhesive film by dry etching while using the resist upper layer film having the formed pattern as a mask; and
(I-5) forming the pattern in the substrate to be processed by etching the substrate to be processed while using the adhesive film having the formed pattern as a mask.

The present invention also provides a patterning process for forming a pattern in a substrate to be processed, comprising the steps of:
(II-1) forming a resist underlayer film on a substrate to be processed;
(II-2) forming a silicon-containing resist middle layer film on the resist underlayer film;
(II-3) applying the inventive material for forming an adhesive film on the silicon-containing resist middle layer film and then performing a heat treatment to form an adhesive film;
(II-4) forming a resist upper layer film on the adhesive film by using a photoresist material;
(II-5) subjecting the resist upper layer film to pattern exposure and then to development with a developer to form a pattern in the resist upper layer film;
(II-6) transferring the pattern to the adhesive film by dry etching while using the resist upper layer film having the formed pattern as a mask;
(II-7) transferring the pattern to the silicon-containing resist middle layer film by dry etching while using the adhesive film having the formed pattern as a mask;
(II-8) transferring the pattern to the resist underlayer film by dry etching while using the silicon-containing resist middle layer film having the transferred pattern as a mask; and
(II-9) forming the pattern in the substrate to be processed by etching the substrate to be processed while using the resist underlayer film having the formed pattern as a mask.

The present invention further provides a patterning process for forming a pattern in a substrate to be processed, comprising the steps of:
(III-1) forming a resist underlayer film on a substrate to be processed;
(III-2) forming an inorganic hard mask middle layer film selected from a silicon oxide film, a silicon nitride film, and a silicon oxynitride film on the resist underlayer film;
(III-3) applying the inventive material for forming an adhesive film on the inorganic hard mask middle layer film and then performing a heat treatment to form an adhesive film;
(III-4) forming a resist upper layer film on the adhesive film by using a photoresist material;
(III-5) subjecting the resist upper layer film to pattern exposure and then to development with a developer to form a pattern in the resist upper layer film;
(III-6) transferring the pattern to the adhesive film by dry etching while using the resist upper layer film having the formed pattern as a mask;
(III-7) transferring the pattern to the inorganic hard mask middle layer film by dry etching while using the adhesive film having the formed pattern as a mask;
(III-8) transferring the pattern to the resist underlayer film by dry etching while using the inorganic hard mask middle layer film having the transferred pattern as a mask; and
(III-9) forming the pattern in the substrate to be processed by etching the substrate to be processed while using the resist underlayer film having the formed pattern as a mask.

As described, the inventive material for forming an adhesive film can be used suitably for various patterning processes such as a 2-layer resist process or a 4-layer resist process in which the adhesive film is formed on the silicon-containing middle layer film (silicon-containing resist middle layer film, inorganic hard mask middle layer film). According to these patterning processes, pattern collapse can be relieved effectively by the formation of the adhesive film, and these patterning processes are suitable for photolithography of a resist upper layer film.

In this event, the inorganic hard mask middle layer film is preferably formed by a CVD method or an ALD method.

In the present invention, photolithography at a wavelength of 10 nm or more to 300 nm or less, a direct drawing by electron beam, a nanoimprinting, or a combination thereof is preferably employed as a method for forming the pattern in the resist upper layer film.

In the present invention, the development can be selected from alkaline development or development with an organic solvent as a development method.

In the present invention, pattern formation can be performed favorably and efficiently according to such a patterning process.

In the present invention, the substrate to be processed is preferably a semiconductor device substrate or the semiconductor device substrate coated with any of a metal film, a metal carbide film, a metal oxide film, a metal nitride film, a metal oxycarbide film, and a metal oxynitride film.

In this event, as the metal, silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof is preferably used.

According to the inventive patterning processes, the substrates to be processed described above can be processed in the above manner to form a pattern.

In the inventive patterning processes, the material for forming an adhesive film is preferably applied to have a thickness of 2 nm or more and 50 nm or less in the step of forming the adhesive film.

According to such a patterning process, it is possible to remove the formed adhesive film by etching performed for a short time, and a thinner film can be selected as an upper layer resist.

In the inventive patterning process, the resist upper layer film can be formed using a resist upper layer film material containing at least an organic metal compound and a solvent.

In this event, the organic metal compound preferably contains at least one selected from titanium, cobalt, copper, zinc, zirconium, lead, indium, tin, antimony, and hafnium.

Such a patterning process has an effect of suppressing fine pattern collapse and allows an appropriate adjustment of pattern profile, exposure sensitivity, and so forth of a resist upper layer film. In addition, it is possible to prevent the contamination of the substrate to be processed due to the metal compound when using a resist upper layer film material containing an organic metal compound and a solvent.

The present invention also provides a method for forming an adhesive film that functions as an adhesive layer employed in a semiconductor device manufacturing process, the method comprising:
spin-coating a substrate to be processed with the inventive material for forming an adhesive film; and
heating the substrate coated with the material for forming an adhesive film at a temperature of 100°C or higher to 300°C or lower for 10 to 600 seconds to form a cured film.

The present invention also provides a method for forming an adhesive film that functions as an adhesive layer employed in a semiconductor device manufacturing process, the method comprising:
spin-coating a substrate to be processed with the inventive material for forming an adhesive film; and
heating the substrate coated with the material for forming an adhesive film in an atmosphere having an oxygen concentration of 0.1% or more to 21% or less to form a cured film.

According to such methods, the crosslinking reaction during formation of the adhesive film can be promoted, so that mixing with the resist upper layer film can be more highly suppressed. Furthermore, by adjusting the heating temperature, time, and oxygen concentration appropriately within the above-described ranges, an effect of suppressing pattern collapse of the adhesive film suited to the usage can be provided, and in addition, pattern profile adjustment properties of the resist upper layer film can be achieved.

The present invention also provides a method for forming an adhesive film that functions as an adhesive layer employed in a semiconductor device manufacturing process, the method comprising:
spin-coating a substrate to be processed with the inventive material for forming an adhesive film; and
heating the substrate coated with the material for forming an adhesive film in an atmosphere having an oxygen concentration of less than 0.1% to form a cured film.

According to such a method, the substrate to be processed is not degraded, the crosslinking reaction during formation of the adhesive film can be promoted, and intermixing with the upper layer film can be suppressed more highly even when the substrate to be processed contains a material that is unstable to heating under an oxygen atmosphere. Therefore, such a method is useful.

### ADVANTAGEOUS EFFECTS OF INVENTION

As described above, according to the present invention, it is possible to provide a material for forming an adhesive film that has high adhesiveness to a resist upper layer film, at the same time, prevents scum in space portions, and also has an effect of suppressing fine pattern collapse. Moreover, this material for forming an adhesive film has high adhesiveness, at the same time, prevents scum in space portions, has an effect of suppressing fine pattern collapse, and also makes it possible to form a fine pattern profile and suppress the generation of scum in space portions. This material makes it possible to make appropriate adjustments to the pattern profile, exposure sensitivity, and so forth of the resist upper layer film. Therefore, the material is extremely useful in multilayer resist processes, for example, a 4-layer resist process in which the adhesive film is formed on a silicon-containing middle layer film. In addition, according to the inventive method for forming an adhesive film, it is possible to form an adhesive film that cures sufficiently on a substrate to be processed and has high adhesiveness to a resist upper layer film. In addition, according to the inventive patterning processes, a fine pattern can be formed in a substrate to be processed with high precision in a multilayer resist process.

### BRIEF DESCRIPTION OF DRAWINGS

FIG. 1 is an explanatory diagram of an example of an inventive patterning process according to a 4-layer resist process.
FIG. 2 is an explanatory diagram showing a method for measuring the adhesiveness in Examples.

### DESCRIPTION OF EMBODIMENTS

As described above, there have been demands for: a material for forming an adhesive film that has high adhesiveness to a resist upper layer film and has an effect of suppressing fine pattern collapse in a fine patterning process according to a multilayer resist method in a semiconductor device manufacturing process; a patterning process using the material; and a method for forming an adhesive film.

Accordingly, the present inventors have considered that if the amount of polar groups can be made different between exposed portions and unexposed portions of a resist, it is possible to realize simultaneously the improvement of the adhesiveness of a resist and the reduction of scum in space portions. As a means of achieving this, the present inventors have focused on a combination of an acid generator and a resin having an acid-dissociable group. That is, the present inventors have considered that, by the acid generator generating an acid in an exposed portion, the elimination of acid-dissociable groups occurs, a change in structure occurs accompanied by a change in the amount of polar groups in the exposed portion, and this manner makes it possible to develop a resist underlayer film that has excellent adhesiveness to a resist upper layer film and can also suppress the generation of scum in space portions. The present inventors have earnestly studied and have found out that a material for forming an adhesive film having, as a main component, a compound having a certain structure, a patterning process using the material, and a method for forming an adhesive film are extremely effective, and completed the present invention.

That is, the present invention is a material for forming an adhesive film for an adhesive film formed directly under a resist upper layer film, wherein the material for forming an adhesive film comprises: (A) a resin having a structural unit containing an acid-dissociable group and having at least two kinds of structural units represented by the following general formula (1), the resin optionally having a structural unit that generates an acid due to light; and
(C) an organic solvent, wherein the material for forming an adhesive film comprises
(B) a photo-acid generator, the resin (A) having the structural unit that generates an acid due to light, or both the photo-acid generator (B) and the resin (A) having the acid-generating structural unit, 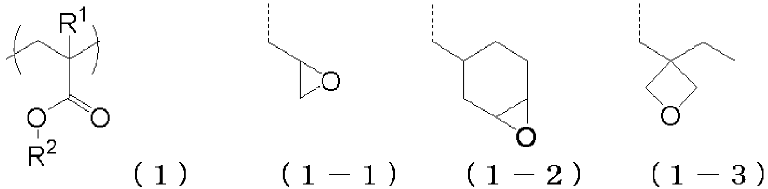 wherein R¹ represents a hydrogen atom or a methyl group, R² represents a group selected from the formulae (1-1) to (1-3), and a broken line represents an attachment point.

Note that in the present description, when an element is described as being "directly under" another element, the element contacts the other element directly, and there is no intervening element. On the contrary, when an element is described as being "under" another element, there may be an intervening element between the elements. Similarly, when an element is described as being "directly on" another element, the element contacts the other element directly, and there is no intervening element. When an element is described as being "on" another element, there may be an intervening element between the elements.

Meanwhile, in the present description, "acid dissociable" refers to the property that an interatomic bond can be cleaved by the action of an acid, and an "acid-dissociable group" may be either (i) a group having an acid-dissociable property where a bond between the acid-dissociable group and an atom adjoining the acid-dissociable group may be cleaved by the action of an acid, or (ii) a group in which some bonds may be cleaved by the action of an acid and then an elimination reaction such as a decarboxylation reaction may further occur, causing the cleavage of a bond between the acid-dissociable group and an atom adjoining the acid-dissociable group. The acid-dissociable group generates polar groups by the dissociation of the acid-dissociable group.

Hereinafter, the present invention will be described in detail. However, the present invention is not limited thereto.

### [Material for Forming Adhesive Film]

The present invention is a material for forming an adhesive film for an adhesive film formed directly under a resist upper layer film, where the material for forming an adhesive film contains: (A) a resin having a structural unit containing an acid-dissociable group and having at least two kinds of structural units represented by the following general formula (1); and (C) an organic solvent. The resin (A) may have a structural unit that generates an acid due to light.

The material for forming an adhesive film contains (i) (B) a photo-acid generator further, (ii) the resin (A) having the structural unit that generates an acid due to light, or (iii) both the photo-acid generator (B) and the resin (A) having the acid-generating structural unit. Note that in the inventive material for forming an adhesive film, one kind of the resin (A) may be used, or two or more kinds thereof may be used in combination. Furthermore, the material for forming an adhesive film may also contain components other than the components (A) to (C).

In the following, each component will be described.

### [(A) Resin]

The resin (A) contained in the inventive material for forming an adhesive film has a structural unit containing an acid-dissociable group and has at least two kinds of structural units represented by the following formula (1).

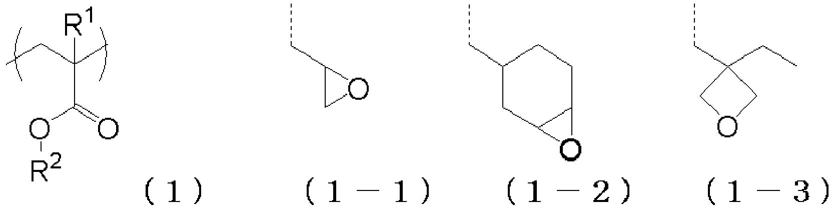

In the general formula (1), R¹ represents a hydrogen atom or a methyl group and R² represents a group selected from the formulae (1-1) to (1-3). In the formulae, a broken line represents an attachment point.

The structural unit represented by the general formula (1) functions as a crosslinking group and an adhesive group. A ring-opening reaction of an epoxy or oxetane structure in the structural unit during curing results in generating hydroxy groups. The interaction between the generated hydroxy groups makes it possible to provide curability without loss of adhesiveness between a resist upper layer film and a substrate to be processed or between a resist upper layer film and a silicon-containing middle layer film. Furthermore, by a plurality of these structural units being combined, the crosslinking network becomes more intricate, stronger interaction becomes possible, and thus, adhesiveness can be improved even more.

Specific examples of the structural unit represented by the general formula (1) include the following or the like. R¹ is as defined above.

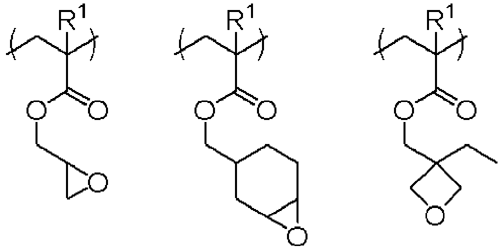

The structural unit containing an acid-dissociable group is preferably represented by any of the following general formulae (2) to (4), but is not limited thereto.

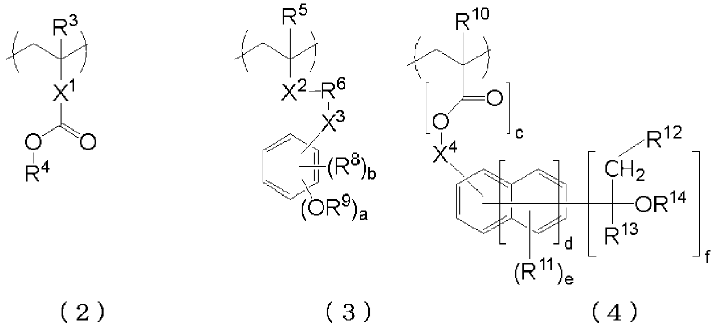

In the formulae, R³, R⁵, and R¹⁰ each independently represent a hydrogen atom or a methyl group; R⁴ and R⁹ each independently represent an acid-dissociable group; X¹ represents a single bond or a linking group having 1 to 14 carbon atoms and containing a phenylene group, a naphthylene group, an ester bond, an ether bond, or a lactone ring; X² represents a single bond, an ester bond, or an amide bond; X³ represents a single bond, an ether bond, or an ester bond; R⁶ represents a single bond or a saturated hydrocarbylene group having 1 to 6 carbon atoms, part of the carbon atoms optionally being substituted with an ether bond or an ester bond; R⁸ represents a fluorine atom, a trifluoromethyl group, a cyano group, or a saturated hydrocarbyl group having 1 to 6 carbon atoms; "a" represents 1 or 2 and "b" represents an integer of 0 to 4, provided that 1 ≤ a + b ≤ 5; X⁴ represents a single bond or an alkylene group having 1 to 10 carbon atoms and optionally containing an ethereal oxygen atom in a chain thereof; each R¹¹ independently represents a hydrogen atom, a halogen atom, a linear, branched, or cyclic acyloxy group having 2 to 8 carbon atoms and optionally being halogenated, a linear, branched, or cyclic alkyl group having 1 to 6 carbon atoms and optionally being halogenated, or a linear, branched, or cyclic alkoxy group having 1 to 6 carbon atoms and optionally being halogenated; R¹² and R¹³ each independently represent a hydrogen atom, a linear or branched alkyl group having 1 to 15 carbon atoms and optionally being substituted with a hydroxy group or an alkoxy group, or a monovalent aromatic ring-containing group optionally having a substituent; R¹⁴ represents a hydrogen atom, a linear, branched, or cyclic monovalent aliphatic hydrocarbon group having 1 to 10 carbon atoms and optionally containing an ethereal oxygen atom in a chain or containing a carbonyl group or a carbonyloxy group in a chain or at an end of a chain, or a monovalent aromatic ring-containing group optionally having a substituent, OR¹⁴ being an acid-dissociable group; "c" represents 0 or 1; "d" represents an integer of 0 to 2; "f" represents an integer of 1 to 3; and "e" equals 5+2d-f.

Specific examples of monomers that give the general formula (2) include the following, but are not limited thereto. R³ and R⁴ are as defined above.

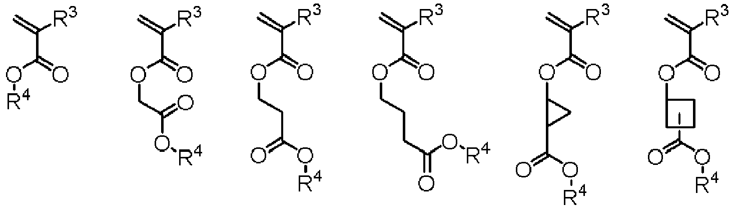

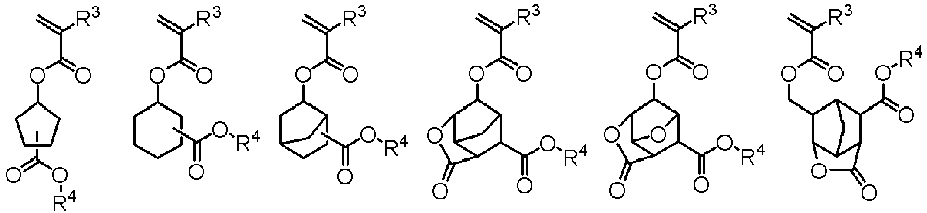

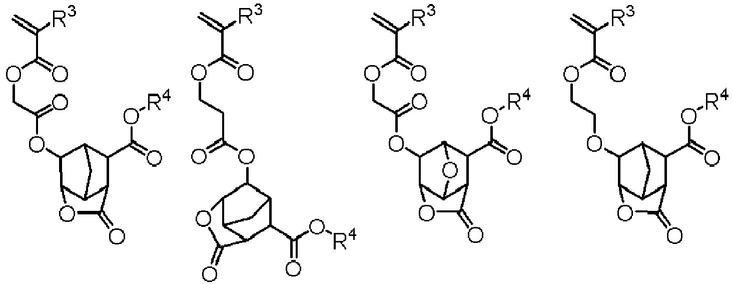

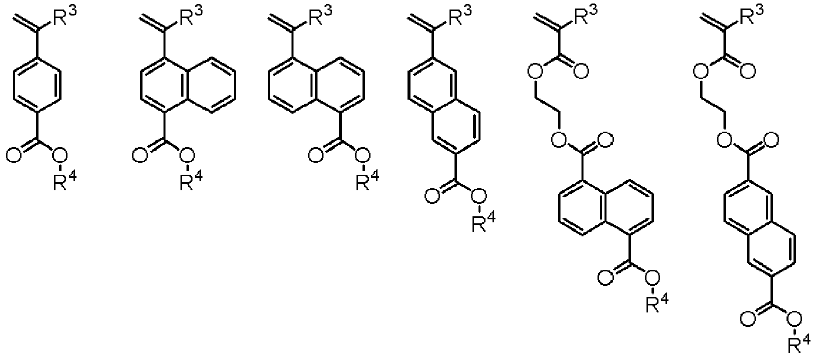

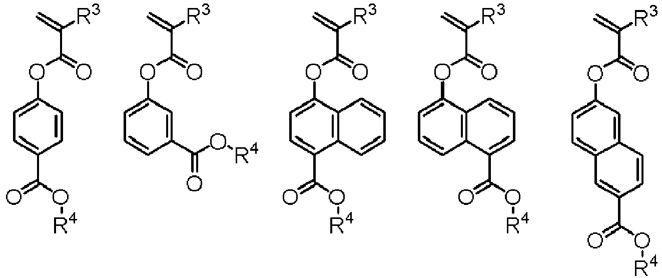

Specific examples of monomers that give the general formula (3) include the following, but are not limited thereto. R⁵ and R⁹ are as defined above.

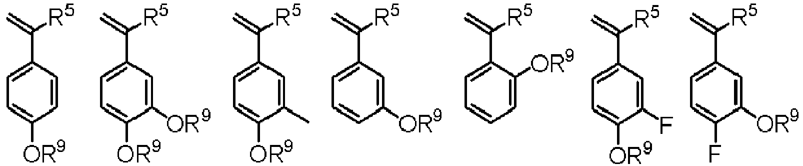

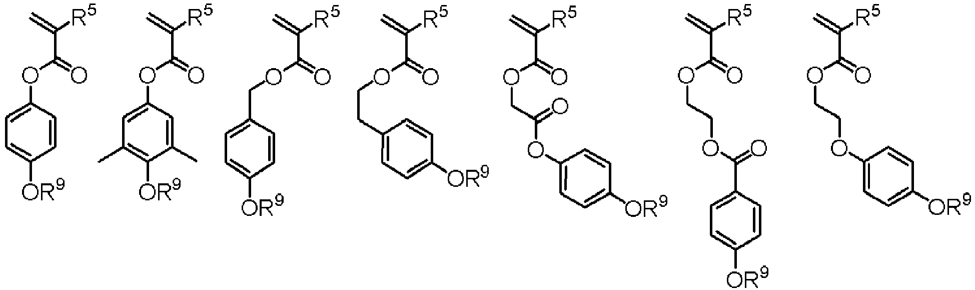

Various groups may be selected as a monovalent acid-dissociable group represented by R⁴ or R⁹, and examples include those represented by the following formulae (AL-1) to (AL-3).

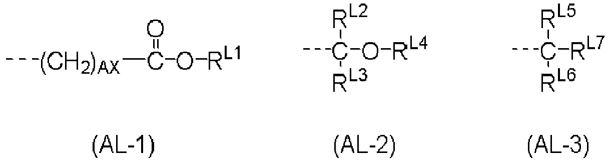

In the formulae, a broken line represents an attachment point.

In the formula (AL-1), R^{L1} represents a tertiary hydrocarbyl group having 4 to 61, preferably 4 to 15 carbon atoms, a trihydrocarbylsilyl group in which each hydrocarbyl group is a saturated hydrocarbyl group having 1 to 6 carbon atoms, a saturated hydrocarbyl group having 4 to 20 carbon atoms and containing a carbonyl group, an ether bond, or an ester bond, or a group represented by the formula (AL-3). AX represents an integer of 0 to 6. Note that a tertiary hydrocarbyl group means a group obtained by hydrogen atom elimination from a tertiary carbon atom of a hydrocarbon.

The tertiary hydrocarbyl group represented by R^{L1} may be saturated or unsaturated, and may be branched or cyclic. Specific examples include a tert-butyl group, a tert-pentyl group, a 1,1-diethylpropyl group, a 1-ethylcyclopentyl group, a 1-butylcyclopentyl group, a 1-ethylcyclohexyl group, a 1-butylcyclohexyl group, a 1-ethyl-2-cyclopentenyl group, a 1-ethyl-2-cyclohexenyl group, a 2-methyl-2-adamantyl group, etc. Examples of the trihydrocarbyl group include a trimethylsilyl group, a triethylsilyl group, a dimethyl-tert-butylsilyl group, etc. The saturated hydrocarbyl group containing a carbonyl group, an ether bond, or an ester bond may be linear, branched, or cyclic, but is preferably cyclic. Specific examples thereof include a 3-oxocyclohexyl group, a 4-methyl-2-oxooxan-4-yl group, a 5-methyl-2-oxooxolan-5-yl group, a 2-tetrahydropyranyl group, a 2-tetrahydrofuranyl group, etc.

Examples of the acid-dissociable group represented by the formula (AL-1) include a tert-butoxycarbonyl group, a tert-butoxycarbonylmethyl group, a tert-pentyloxycarbonyl group, a tert-pentyloxycarbonylmethyl group, a 1,1-diethylpropyloxycarbonyl group, a 1,1-diethylpropyloxycarbonylmethyl group, a 1-ethylcyclopentyloxycarbonyl group, a 1-ethylcyclopentyloxycarbonylmethyl group, a 1-ethyl-2-cyclopentenyloxycarbonyl group, a 1-ethyl-2-cyclopentenyloxycarbonylmethyl group, a 1-ethoxyethoxycarbonylmethyl group, a 2-tetrahydropyranyloxycarbonylmethyl group, a 2-tetrahydrofuranyloxycarbonylmethyl group, etc.

Other examples of the acid-dissociable group represented by the formula (AL-1) include groups represented by the following formulae (AL-1)-1 to (AL-1)-16.

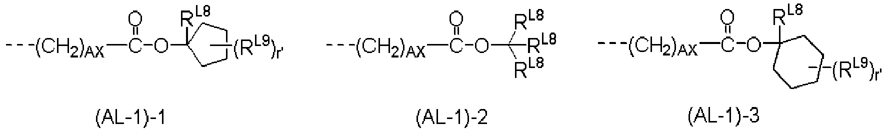

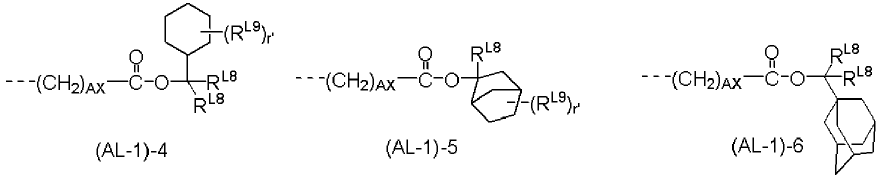

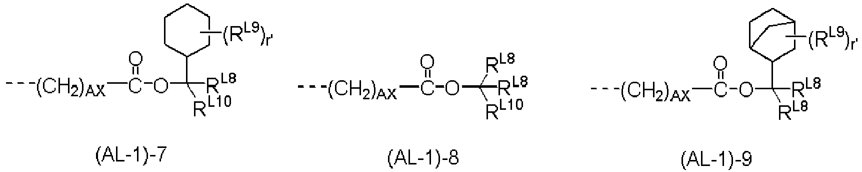

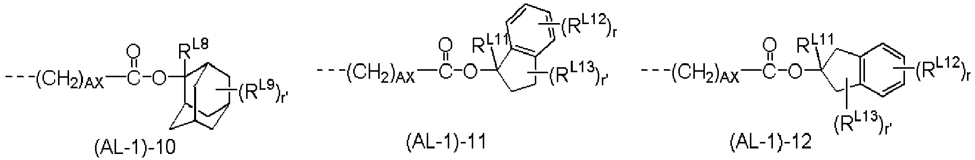

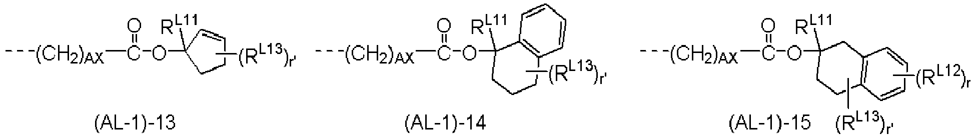

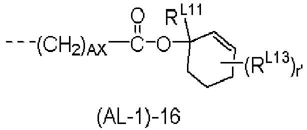

In the formulae, AX is as defined above. Each R^{L8} independently represents a saturated or unsaturated hydrocarbyl group having 1 to 10 carbon atoms or an aryl group having 6 to 20 carbon atoms. R^{L9} represents a hydrogen atom or a saturated or unsaturated hydrocarbyl group having 1 to 10 carbon atoms. R^{L10} represents a saturated or unsaturated hydrocarbyl group having 1 to 10 or an aryl group having 6 to 20 carbon atoms; R^{L11} represents a hydrogen atom, a saturated or unsaturated hydrocarbyl group having 1 to 10 carbon atoms, or an aryl group having 6 to 20 carbon atoms; and R^{L12} represents a hydrogen atom, a halogen atom, a difluoromethyl group, a trifluoromethyl group, a difluoromethoxy group, a trifluoromethoxy group, a cyano group, a nitro group, or a saturated or unsaturated hydrocarbyl group having 1 to 6 carbon atoms, optionally having an ether group or a sulfide group, and a plurality of R^{L12}s being bonded with each other to form a ring. R^{L13} represents a hydrogen atom or a saturated or unsaturated hydrocarbyl group having 1 to 6 carbon atoms. The saturated or unsaturated hydrocarbyl group may be any of a linear, branched, or cyclic group. "r" represents an integer of 1 to 4; and "r'" represents an integer of 1 to 6. A broken line represents an attachment point.

In the formula (AL-2), R^{L2} and R^{L3} each independently represent a hydrogen atom or a saturated hydrocarbyl group having 1 to 18, preferably 1 to 10 carbon atoms. The saturated hydrocarbyl group may be linear, branched, or cyclic, and specific examples thereof include a methyl group, an ethyl group, a propyl group, an isopropyl group, an n-butyl group, a sec-butyl group, a tert-butyl group, a cyclopentyl group, a cyclohexyl group, a 2-ethylhexyl group, an n-octyl group, etc.

In the formula (AL-2), R^{L4} represents a hydrocarbyl group having 1 to 18, preferably 1 to 10 carbon atoms and optionally containing a heteroatom. The hydrocarbyl group may be saturated or unsaturated, and may be linear, branched, or cyclic. Examples of the hydrocarbyl group include saturated hydrocarbyl groups having 1 to 18 carbon atoms, etc., and part of the hydrogen atoms thereof may be substituted with a hydroxy group, an alkoxy group, an oxo group, an amino group, an alkylamino group, etc. Examples of such a saturated hydrocarbyl group include those shown below.

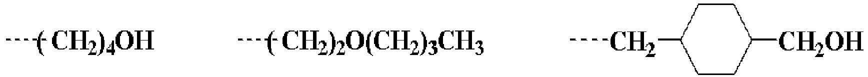

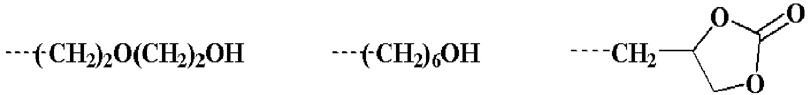

In the formulae, a broken line represents an attachment point.

In the formula (AL-2), R^{L2} and R^{L3}, R^{L2} and R^{L4}, or R^{L3} and R^{L4} may be bonded with each other to form a ring together with the carbon atom bonded thereto or together with the carbon atom and the oxygen atom bonded thereto. In this case, the R^{L2} and R^{L3}, R^{L2} and R^{L4}, or R^{L3} and R^{L4} that are involved in the formation of the ring each independently represent an alkanediyl group having 1 to 18, preferably 1 to 10 carbon atoms. The number of atoms in the ring obtained by these groups being bonded is preferably 3 to 10, more preferably 4 to 10.

Among the acid-dissociable groups represented by the formula (AL-2), examples of linear and branched groups include those represented by the following formulae (AL-2)-1 to (AL-2)-69, but are not limited thereto. Note that, in the following formulae, a broken line represents an attachment point. ----CH₂-O-CH₃ (AL-2)-1 ----CH₂-O-CH₂-CH₃ (AL-2)-2 ----CH₂-O-(CH₂)₂-CH₃ (AL-2)-3 ----CH₂-O-(CH₂)₃-CH₃ (AL-2)-4

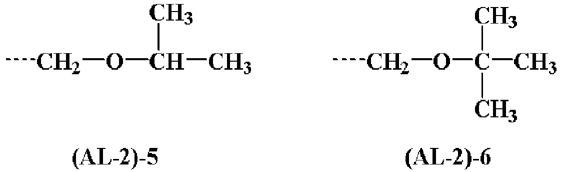

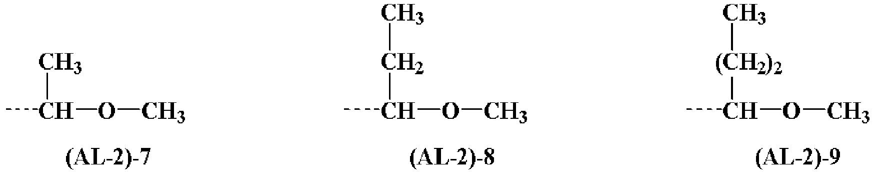

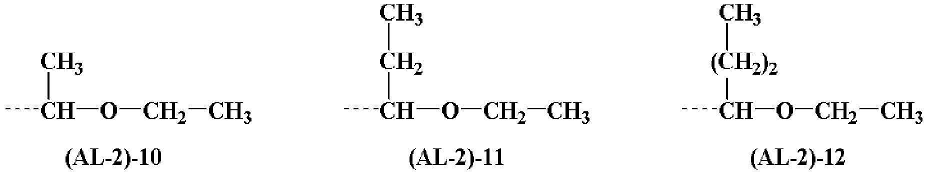

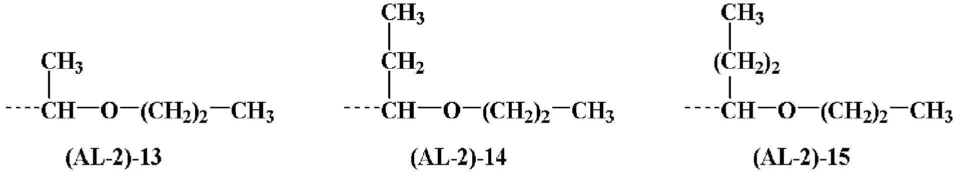

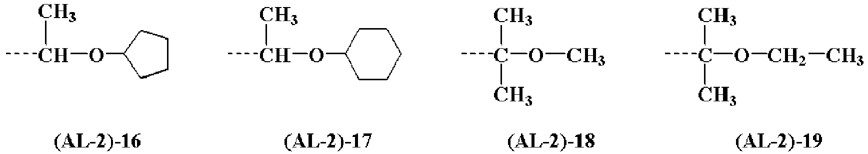

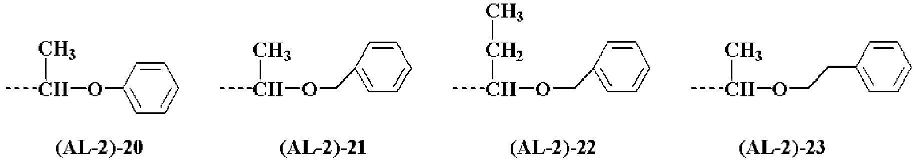

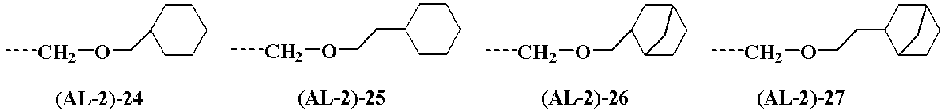

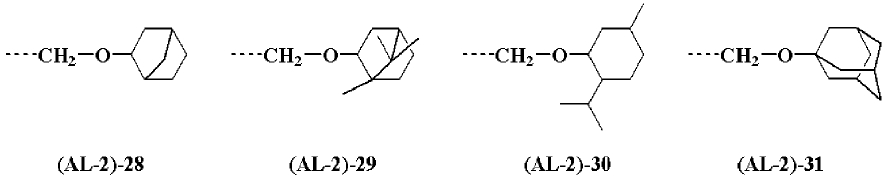

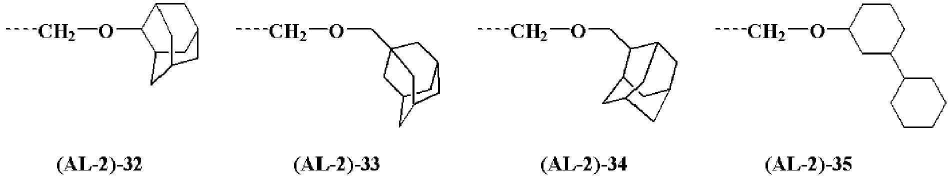

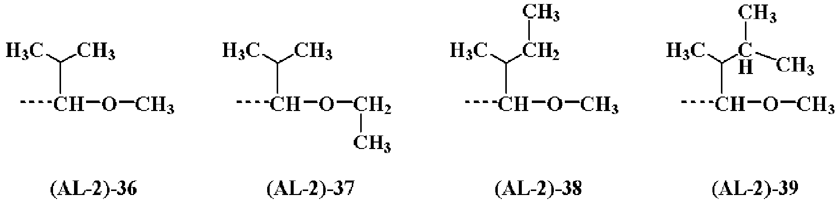

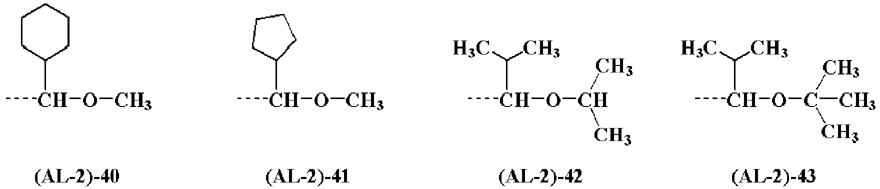

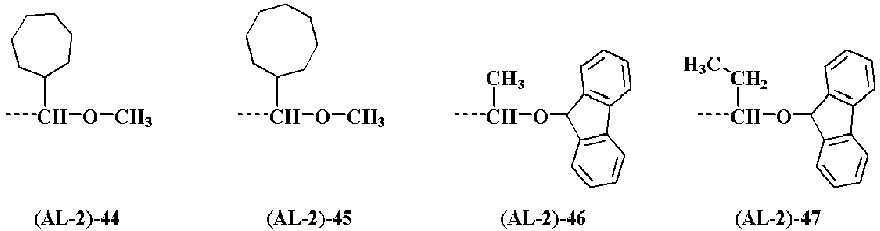

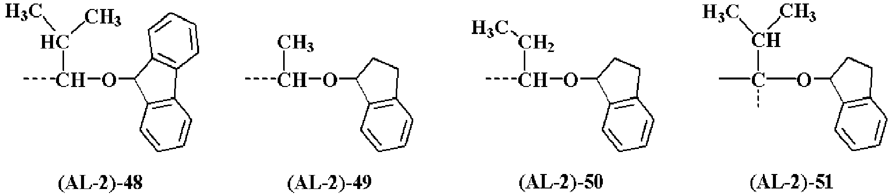

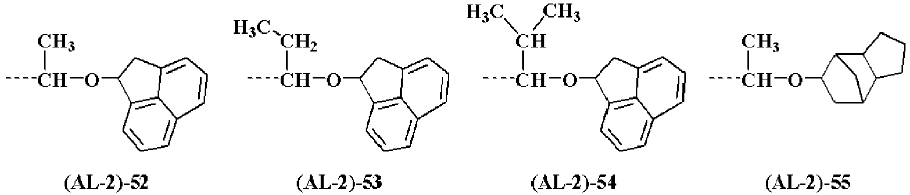

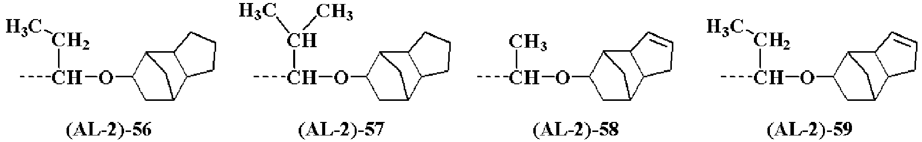

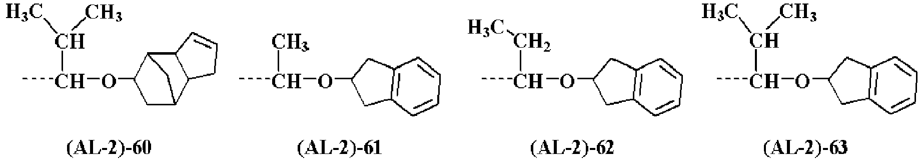

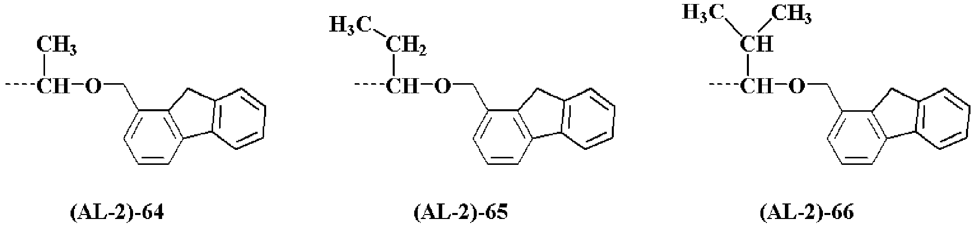

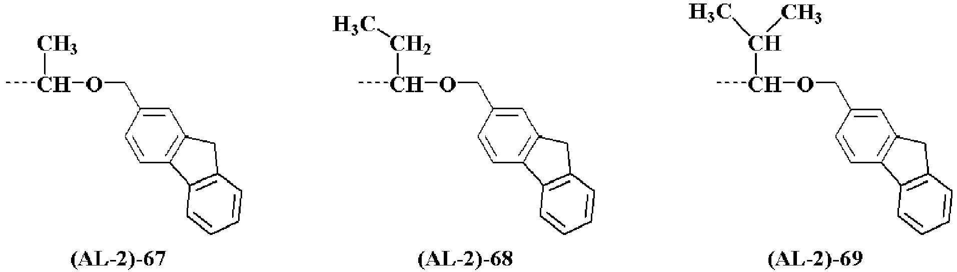

Among the acid-dissociable groups represented by the formula (AL-2), examples of cyclic groups include a tetrahydrofuran-2-yl group, a 2-methyltetrahydrofuran-2-yl group, a tetrahydropyran-2-yl group, a 2-methyltetrahydropyran-2-yl group, etc.

Examples of the acid-dissociable group include groups represented by the following formula (AL-2a) or (AL-2b). The base polymer may be intermolecularly or intramolecularly crosslinked by the acid-dissociable group.

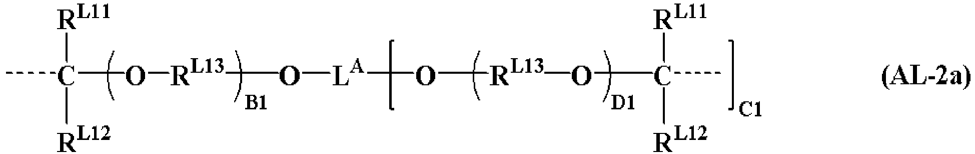

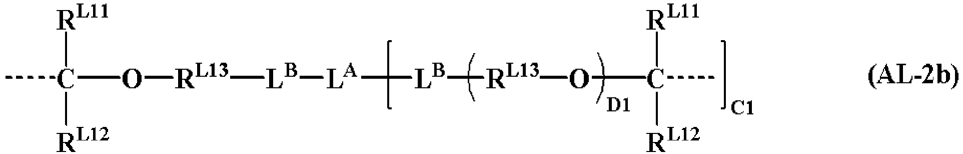

In the formulae, a broken line represents an attachment point.

In the formula (AL-2a) or (AL-2b), R^{L11} and R^{L12} each independently represent a hydrogen atom or a saturated hydrocarbyl group having 1 to 8 carbon atoms. The saturated hydrocarbyl group may be linear, branched, or cyclic. Furthermore, R^{L11} and R^{L12} may be bonded to each other to form a ring together with the carbon atom bonded thereto, and in such a case, R^{L11} and R^{L12} each independently represent an alkanediyl group having 1 to 8 carbon atoms. Each R^{L13} independently represents a saturated hydrocarbylene group having 1 to 10 carbon atoms, and the saturated hydrocarbylene group may be linear, branched, or cyclic. B1 and D1 each independently represent an integer of 0 to 10, preferably an integer of 0 to 5, and C1 represents an integer of 1 to 7, preferably an integer of 1 to 3. L^{A} represents an aliphatic saturated hydrocarbon group having a valency of C1+1 and having 1 to 50 carbon atoms, an alicyclic saturated hydrocarbon group having a valency of C1+1 and having 3 to 50 carbon atoms, an aromatic hydrocarbon group having a valency of C1+1 and having 6 to 50 carbon atoms, or a heterocyclic group having a valency of C1+1 and having 3 to 50 carbon atoms. In addition, part of the carbon atoms of these groups may be substituted with a heteroatom-containing group, and part of the hydrogen atoms bonded to the carbon atoms of these groups may be substituted with a hydroxy group, a carboxyl group, an acyl group, or a fluorine atom. Preferable examples of L^{A} include saturated hydrocarbon groups, such as saturated hydrocarbylene groups having 1 to 20 carbon atoms, trivalent saturated hydrocarbon groups, and tetravalent saturated hydrocarbon groups, arylene groups having 6 to 30 carbon atoms, etc. The saturated hydrocarbon groups may be linear, branched, or cyclic. L^{B} represents -C(=O)-O-, -NH-C(=O)-O-, or -NH-C(=O)-NH-.

Examples of crosslinking acetal groups represented by the formula (AL-2a) or (AL-2b) include groups represented by the following formulae (AL-2)-70 to (AL-2)-77, etc.

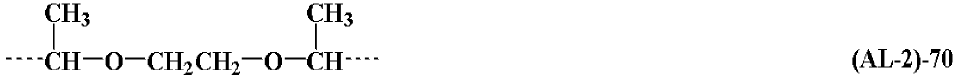

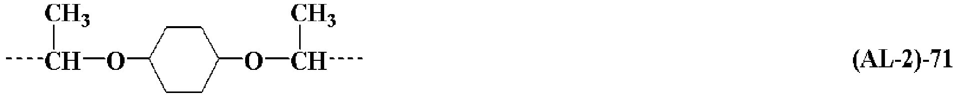

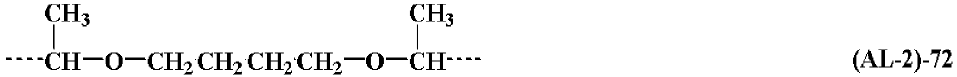

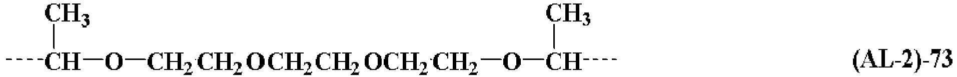

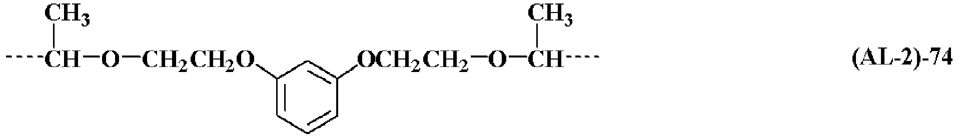

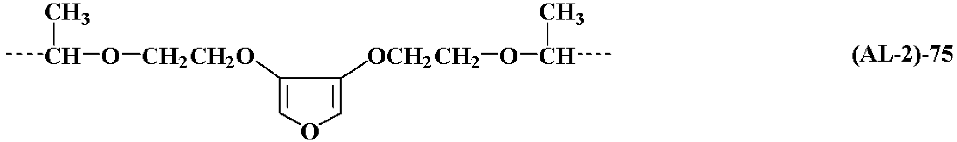

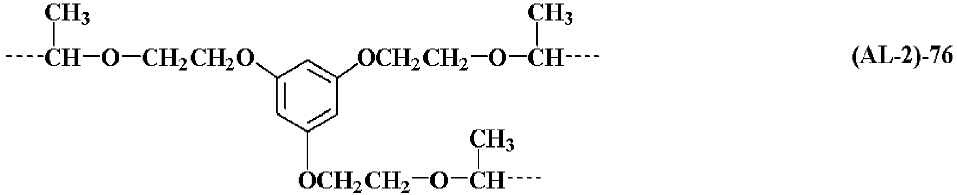

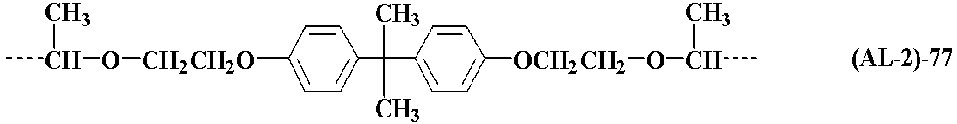

In the formulae, a broken line represents an attachment point.

In the formula (AL-3), R^{L3}, R^{L6}, and R^{L7} each independently represent a hydrocarbyl group having 1 to 20 carbon atoms, and may contain a heteroatom such as an oxygen atom, a sulfur atom, a nitrogen atom, and a fluorine atom. The hydrocarbyl group may be saturated or unsaturated, and may be linear, branched, or cyclic. Specific examples of the hydrocarbyl group include alkyl groups having 1 to 20 carbon atoms, cyclic saturated hydrocarbyl groups having 3 to 20 carbon atoms, alkenyl groups having 2 to 20 carbon atoms, cyclic unsaturated hydrocarbyl groups having 3 to 20 carbon atoms, aryl groups having 6 to 10 carbon atoms, etc. Furthermore, R^{L5} and R^{L6}, R^{L5} and R^{L7}, or R^{L6} and R^{L7} may be bonded to each other to form an aliphatic ring having 3 to 20 carbon atoms together with the carbon atom bonded thereto.

Examples of the group represented by the formula (AL-3) include a tert-butyl group, a 1,1-diethylpropyl group, a 1-ethylnorbornyl group, a 1-methylcyclohexyl group, a 1-ethylcyclopentyl group, a 2-(2-methyl)adamantyl group, a 2-(2-ethyl)adamantyl group, a tert-pentyl group, etc.

Examples of the group represented by the formula (AL-3) also include groups represented by the following formulae (AL-3)-1 to (AL-3)-19.

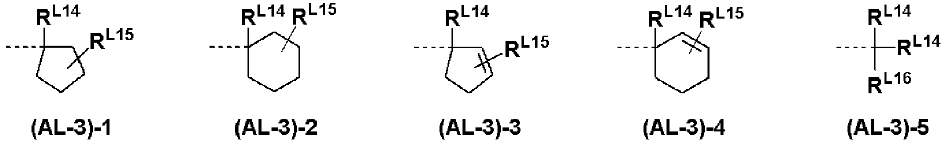

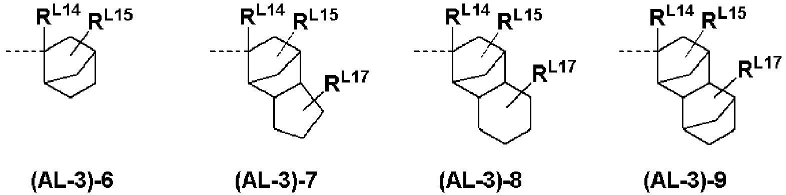

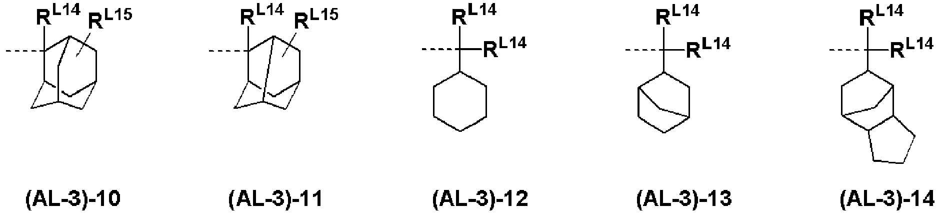

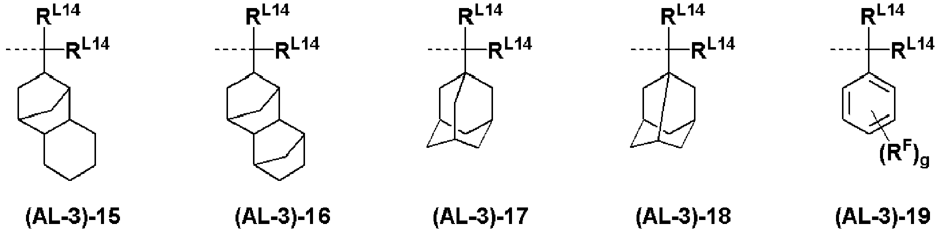

In the formulae, a broken line represents an attachment point.

In the formulae (AL-3)-1 to (AL-3)-19, each R^{L14} independently represents a saturated hydrocarbyl group having 1 to 8 carbon atoms or an aryl group having 6 to 20 carbon atoms. R^{L15} and R^{L17} each independently represent a hydrogen atom or a saturated hydrocarbyl group having 1 to 20 carbon atoms. R^{L16} represents an aryl group having 6 to 20 carbon atoms. The saturated hydrocarbyl group may be linear, branched, or cyclic. As the aryl group, a phenyl group or the like is preferable. R^{F} represents a fluorine atom, an iodine atom, a difluoromethyl group, a trifluoromethyl group, a cyano group, or a nitro group. "g" represents an integer of 0 to 5.

Other examples of the acid-dissociable group include groups represented by the following formula (AL-3)-20 or (AL-3)-21. The polymer may be intramolecularly or intermolecularly crosslinked by the acid-dissociable group.

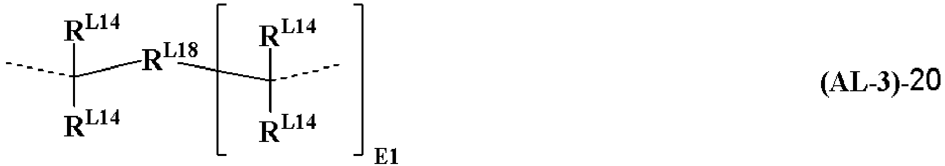

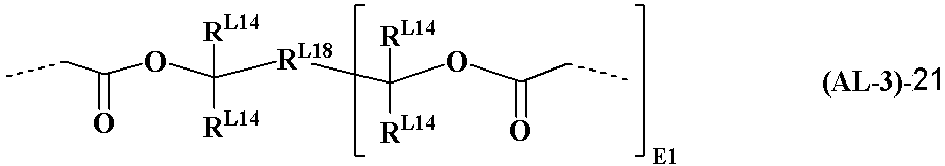

In the formulae, a broken line represents an attachment point.

In the formulae (AL-3)-20 and (AL-3)-21, R^{L14} is as defined above. R^{L18} represents a saturated or unsaturated hydrocarbylene group having 1 to 20 carbon atoms and having a valency of E1+1 or an arylene group having 6 to 20 carbon atoms and having a valency of E1+1, and R^{L18} optionally contains a heteroatom such as an oxygen atom, a sulfur atom, and a nitrogen atom. The saturated hydrocarbylene group may be linear, branched, or cyclic. E1 represents an integer of 1 to 3.

Examples of monomers to give a repeating unit containing the acid-dissociable group represented by the formula (AL-3) include (meth)acrylate including an exo-form structure represented by the following formula (AL-3)-22.

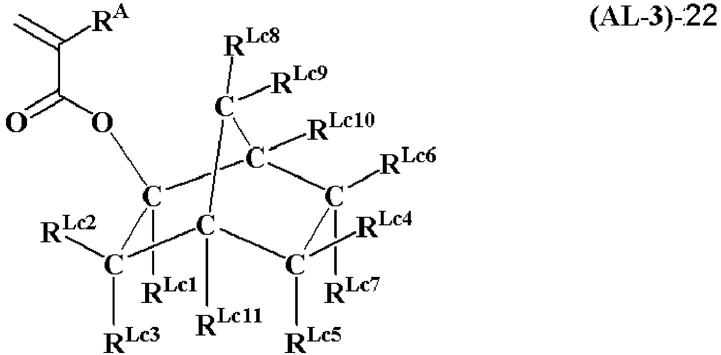

In the formula (AL-3)-22, R^{A} is identical to the above-described R³. R^{Lc1} represents a saturated hydrocarbyl group having 1 to 8 carbon atoms or an aryl group having 6 to 20 carbon atoms, the aryl group optionally being substituted. The saturated hydrocarbyl group may be linear, branched, or cyclic. R^{Lc2} to R^{Lc11} each independently represent a hydrogen atom or a hydrocarbyl group having 1 to 15 carbon atoms and optionally containing a heteroatom. Examples of the heteroatom include an oxygen atom etc. Examples of the hydrocarbyl group include alkyl groups having 1 to 15 carbon atoms, aryl groups having 6 to 15 carbon atoms, etc. R^{Lc2} and R^{Lc3}, R^{Lc4} and R^{Lc6}, R^{Lc4} and R^{Lc7}, R^{Lc5} and R^{Lc7}, R^{Lc5} and R^{Lc11}, R^{Lc6} and R^{Lc10}, R^{Lc8} and R^{Lc9}, or R^{Lc9} and R^{Lc10} may be bonded to each other to form a ring together with the carbon atom(s) bonded thereto. In such a case, the groups that are involved in the bonding are hydrocarbylene groups having 1 to 15 carbon atoms and optionally containing a heteroatom. Furthermore, R^{Lc2} and R^{Lc11}, R^{Lc8} and R^{Lc11}, or R^{Lc4} and R^{Lc6}, bonded to adjoining carbon atoms, may be bonded to each other directly and form a double bond. Note that the formula also represents an enantiomer.

Here, examples of monomers that give the repeating unit represented by the formula (AL-3)-22 include those disclosed in JP 2000-327633 A etc. Specific examples include the following, but are not limited thereto. Note that in the following formulae, R^{A} is identical to the above-described R³.

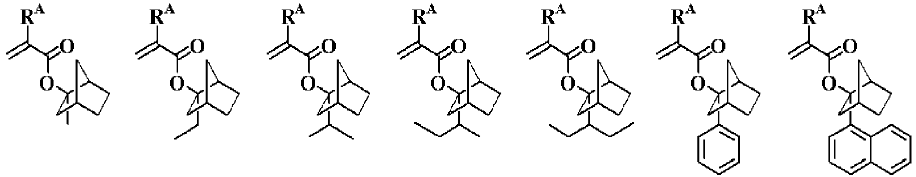

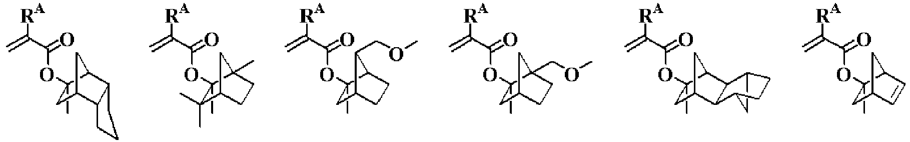

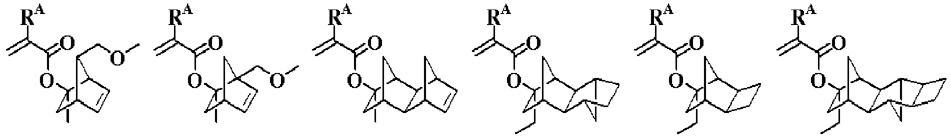

Examples of monomers to give a repeating unit containing an acid-labile group represented by the formula (AL-3) also include (meth)acrylate represented by the following formula (AL-3)-23, containing a furandiyl group, a tetrahydrofurandiyl group, or an oxanorbornanediyl group.

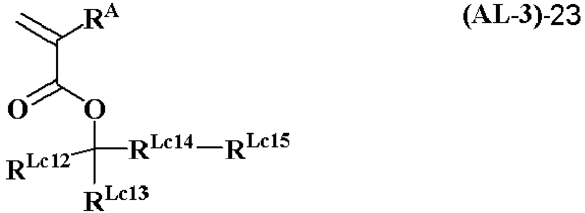

In the formula (AL-3)-23, R^{A} is identical to the above-described R³. R^{Lc12} and R^{Lc13} each independently represent a hydrocarbyl group having 1 to 10 carbon atoms. R^{Lc12} and R^{Lc13} may be bonded with each other to form an aliphatic ring together with the carbon atom bonded thereto. R^{Lc14} represents a furandiyl group, a tetrahydrofurandiyl group, or an oxanorbornanediyl group. R^{Lc15} represents a hydrogen atom or a hydrocarbyl group having 1 to 10 carbon atoms and optionally containing a heteroatom. The hydrocarbyl group may be linear, branched, or cyclic. Specific examples thereof include saturated hydrocarbyl groups having 1 to 10 carbon atoms etc.

Examples of monomers that give the repeating unit represented by the formula (AL-3)-23 include the following, but are not limited thereto. Note that in the following formulae, R^{A} is identical to the above-described R³, Ac represents an acetyl group, and Me represents a methyl group.

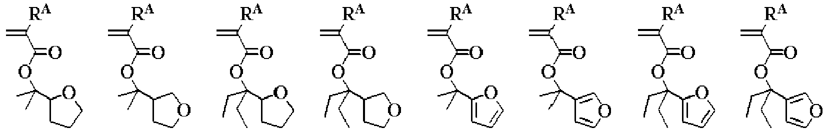

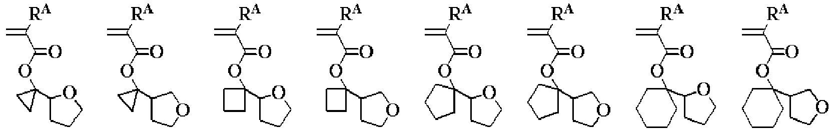

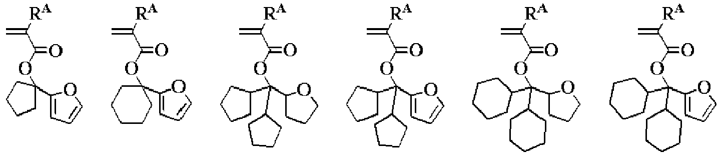

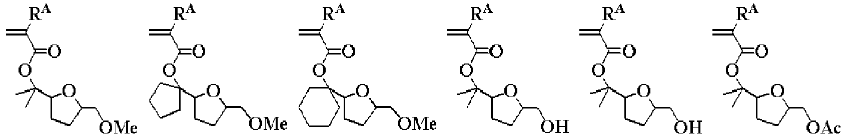

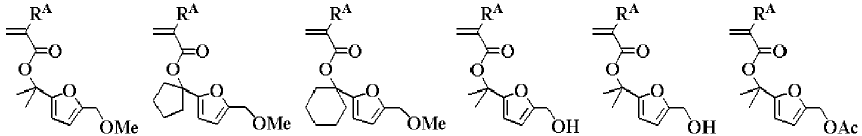

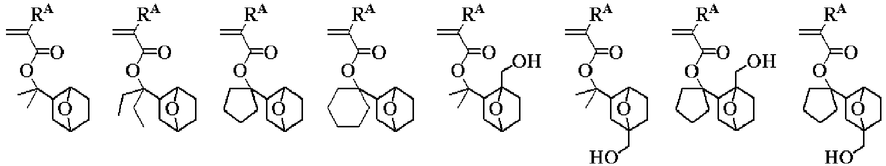

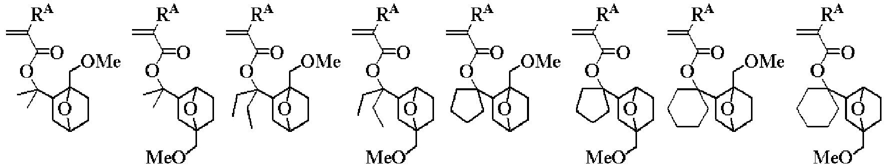

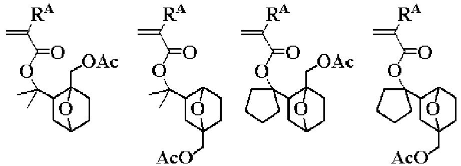

When a resin including a structural unit represented by the general formula (2) or (3) is used, polar groups, such as phenolic hydroxy groups or carboxy groups, are generated locally in portions where an acid is generated. Accordingly, by adding a photo-acid generator to a resin having such a structural unit, polar groups can be generated in exposed portions. In this manner, adhesiveness in the exposed portions is enhanced, and therefore, high adhesiveness and the ability to prevent scum in space portions can both be achieved, mainly in negative resists.

Among repeating units represented by the general formula (4), those represented by the following formula (4') are particularly favorable, but the repeating units are not limited thereto. R¹⁰, R¹², R¹³, R¹⁴, and "f" are as defined above.

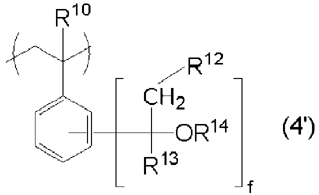

Specific examples of the structural unit represented by the general formula (4) include the following.

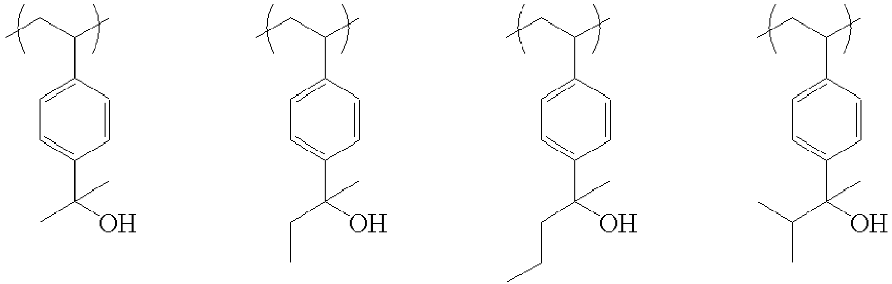

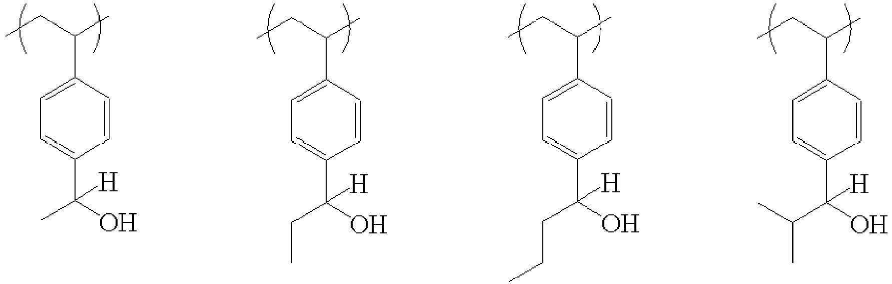

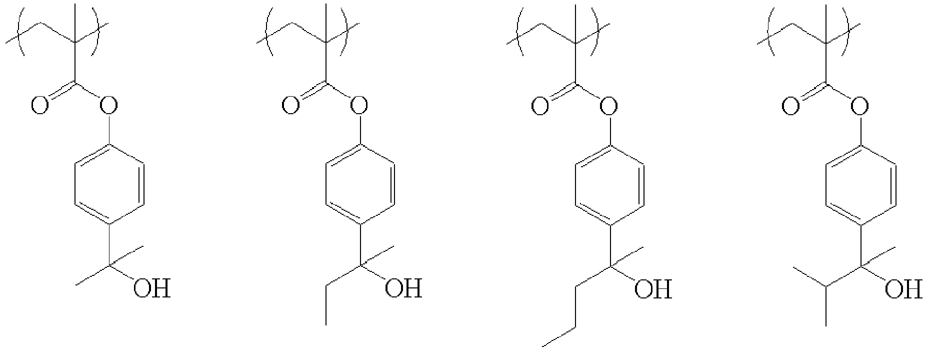

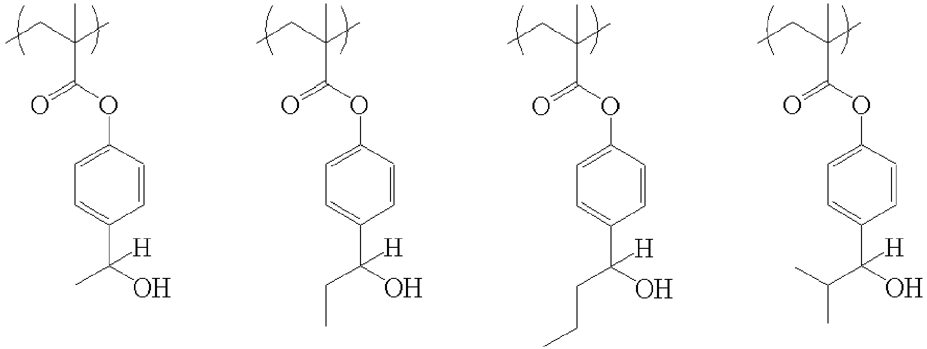

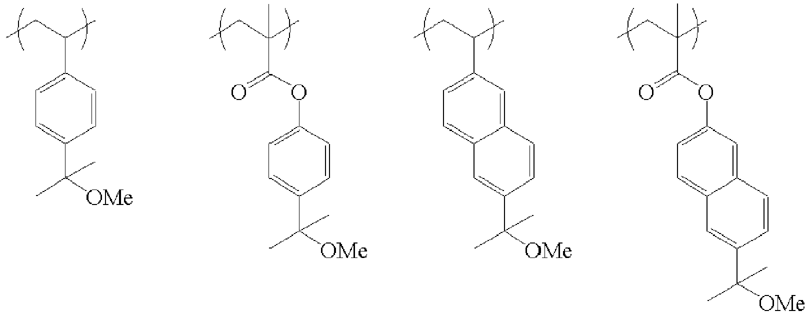

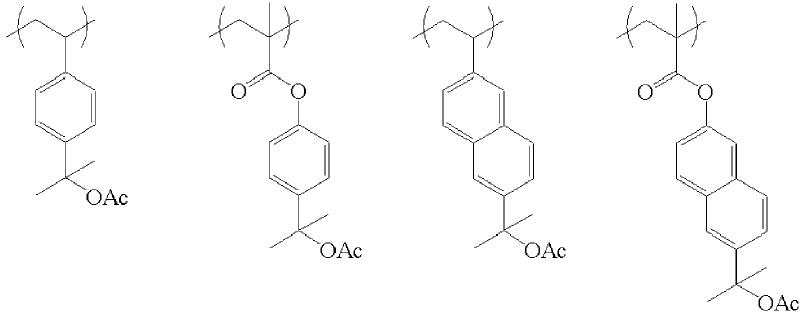

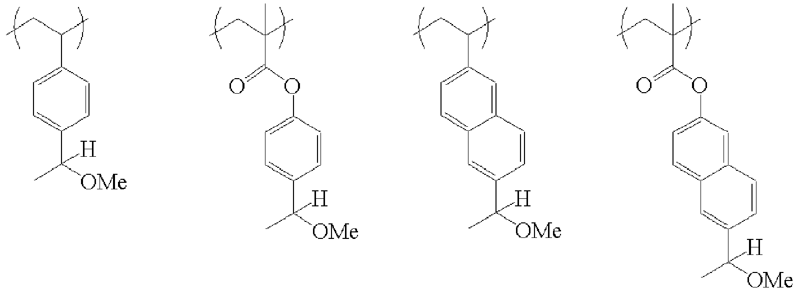

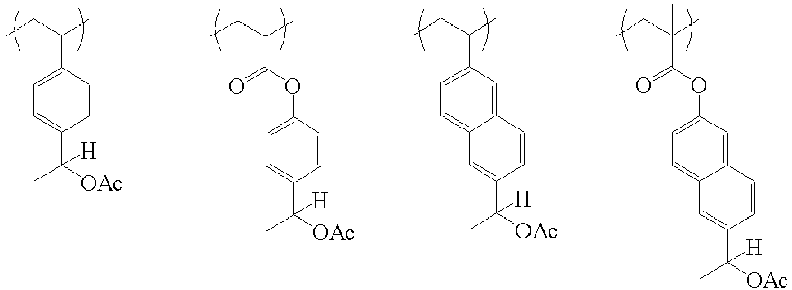

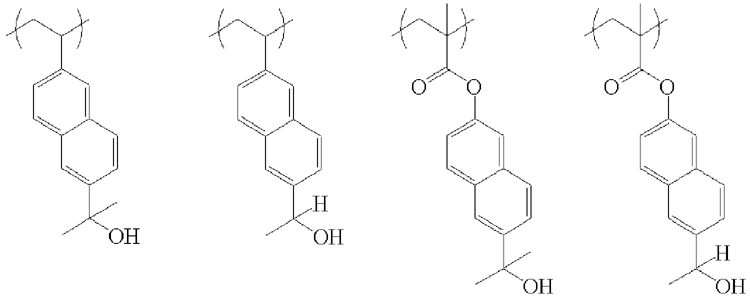

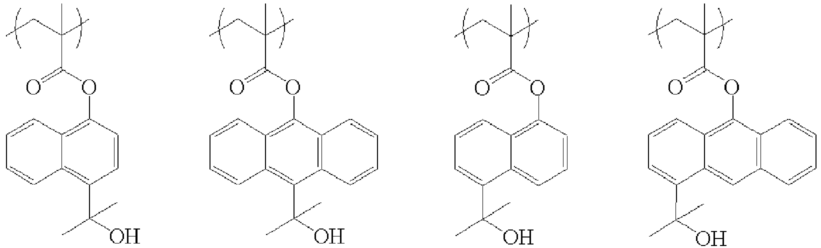

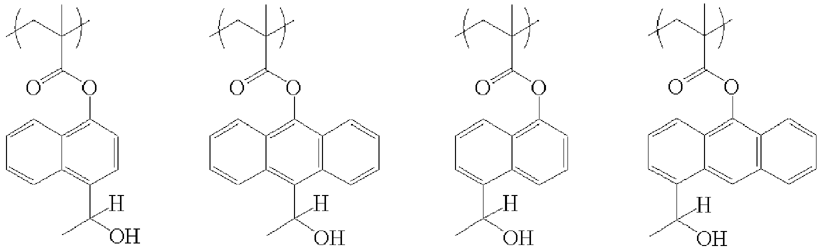

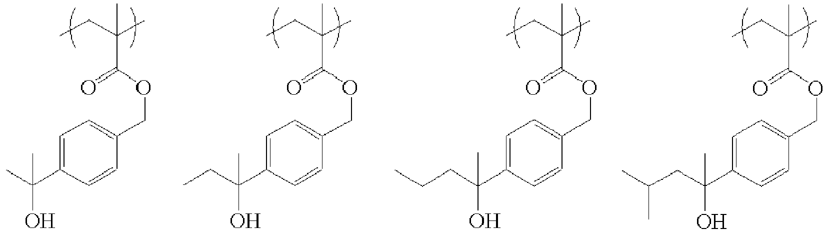

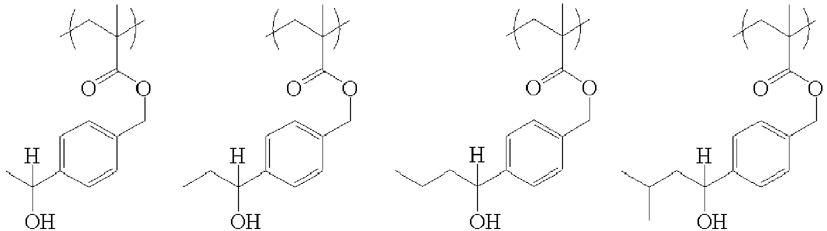

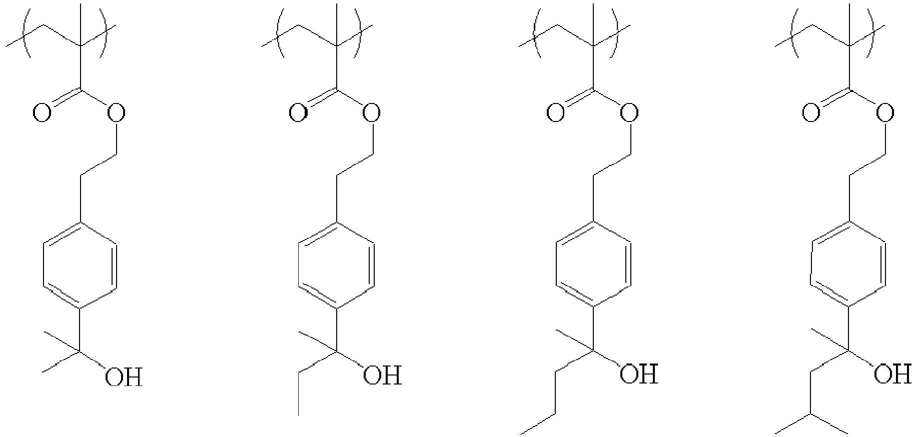

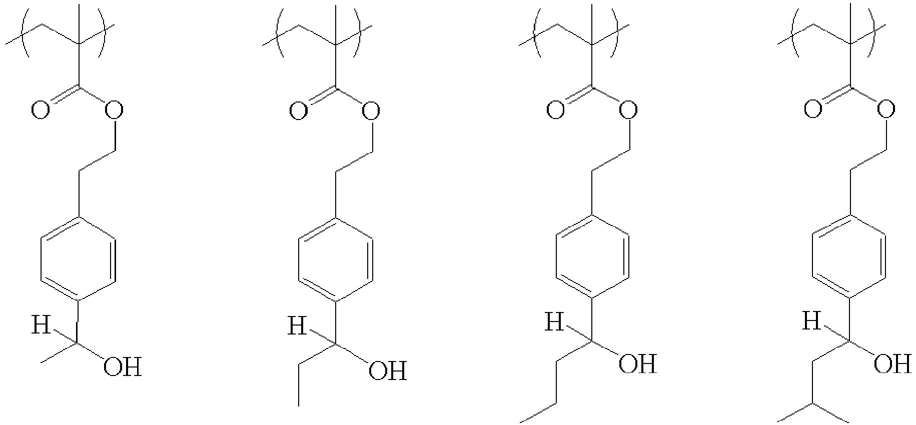

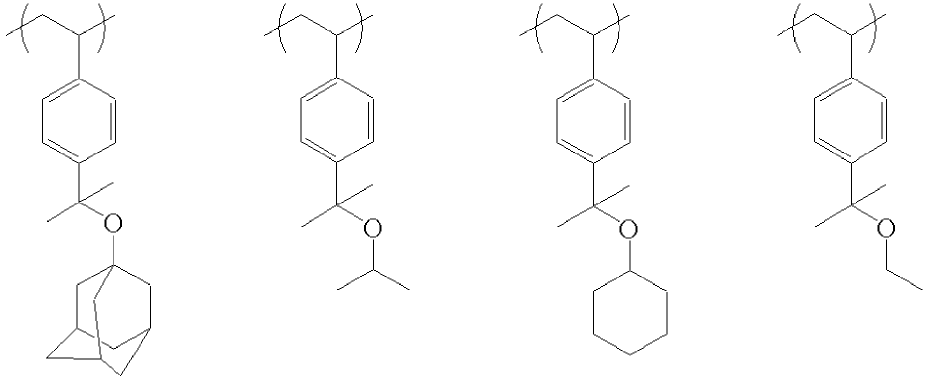

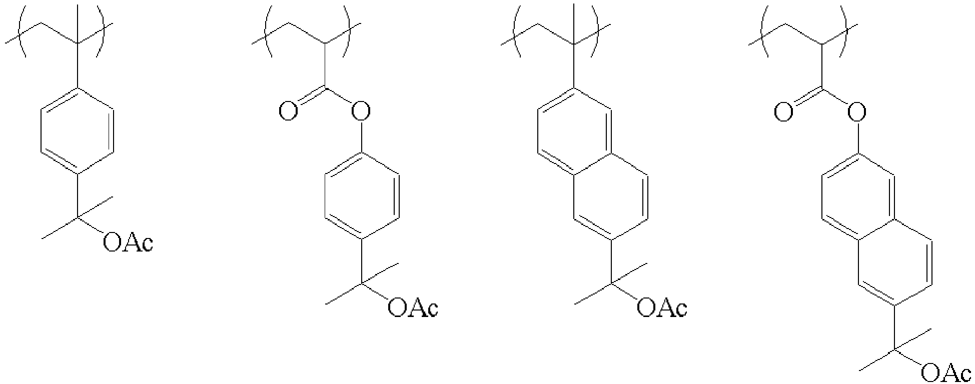

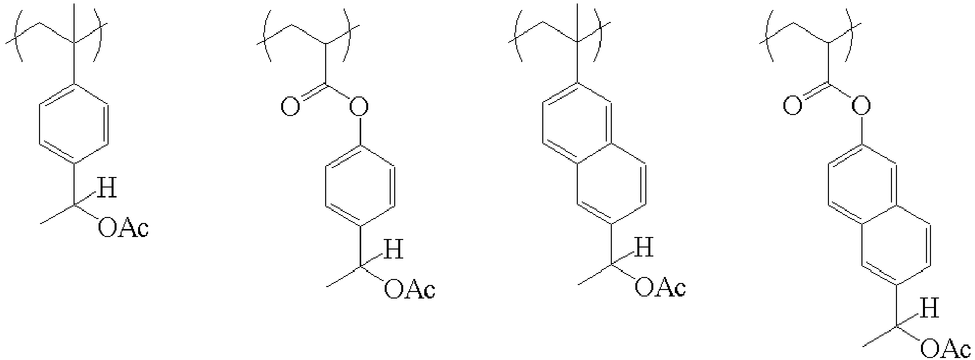

In the structural unit represented by the general formula (4), the (OR¹⁴) group behaves as an acid-dissociable group. Due to protonation caused by an acid, the (OR¹⁴) group is eliminated as HOR¹⁴, and via a carbocation, a carbon-carbon double bond (e.g. a styrene structure) is generated.

When a resin including a structural unit represented by the general formula (4) is used, polar structures, such as hydroxy groups, ester bonds, and ether bonds, are reduced locally in portions where an acid is generated. Accordingly, by adding a photo-acid generator to a resin having such a structural unit, polar groups can be reduced in exposed portions. In this manner, separability of an upper layer resist in exposed portions is enhanced while the adhesiveness in unexposed portions remains the same, and therefore, high adhesiveness and the ability to prevent scum in space portions can both be achieved, mainly in positive resists.

The resin (A) preferably further has at least one of the structural units represented by the following general formulae (5) and (6), but is not limited thereto.

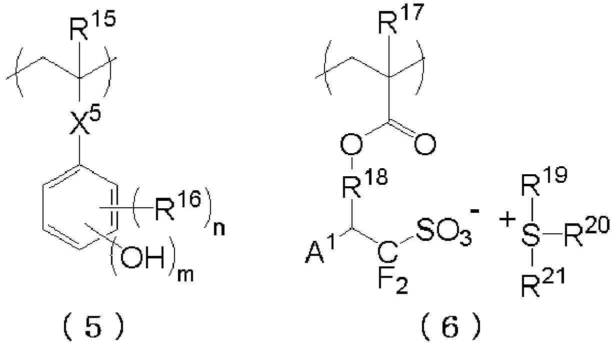

In the formulae, R¹⁵ and R¹⁷ each independently represent a hydrogen atom or a methyl group. R¹⁶ represents an alkyl group having 1 to 3 carbon atoms; and "m" represents an integer of 1 or 2 and "n" represents an integer of 0 to 4, provided that m+n is an integer of 1 or more and 5 or less. X⁵ represents a single bond or an alkylene group having 1 to 10 carbon atoms and optionally containing an oxygen atom. R¹⁸ represents a single bond, -Z²¹-C(=O)-O-, -Z²¹-O-, or -Z²¹-O-C(=O)-; and Z²¹ represents a saturated hydrocarbylene group having 1 to 12 carbon atoms and optionally containing a carbonyl group, an ester bond, or an ether bond. R¹⁹ to R²¹ each independently represent a hydrocarbyl group having 1 to 20 carbon atoms and optionally containing a heteroatom. Furthermore, any two of R¹⁹, R²⁰, and R²¹ optionally bond with each other to form a ring together with a sulfur atom bonded therewith. A¹ represents a hydrogen atom or a trifluoromethyl group.

Specific examples of the X⁵ in the general formula (5) include the following, but are not limited thereto.

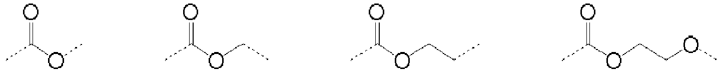

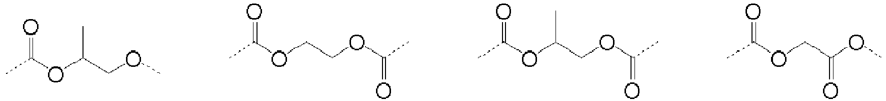

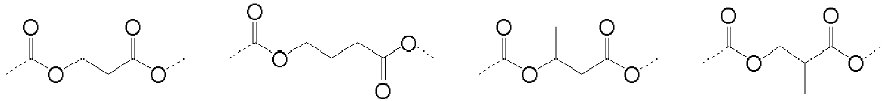

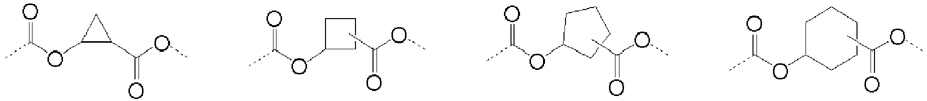

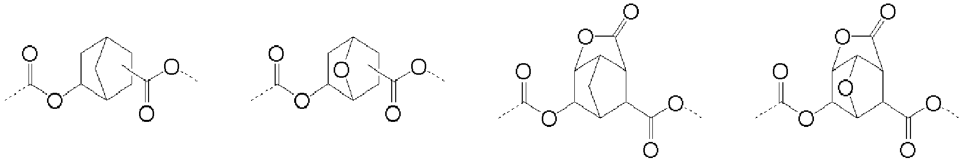

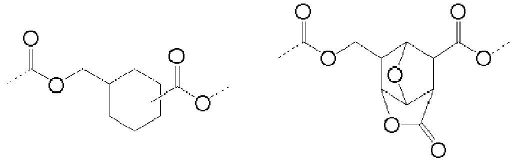

In the formulae, a broken line represents an attachment point.

Examples of the R¹⁶ in the general formula (5) include a methyl group, an ethyl group, a propyl group, and an isopropyl group, and a methyl group is preferable from the viewpoint of adhesiveness to a resist upper layer film.

Specific examples of the compound represented by the general formula (5) include the following, but are not limited thereto. In the following formulae, R¹⁵ is as defined above.

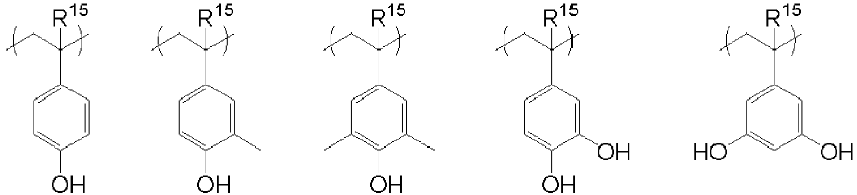

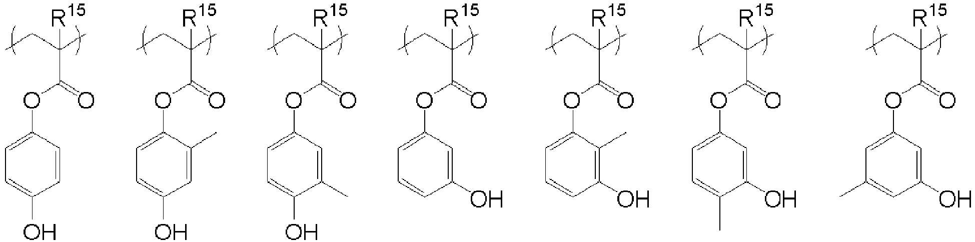

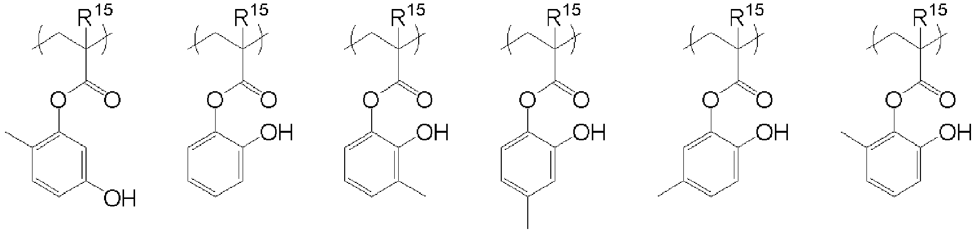

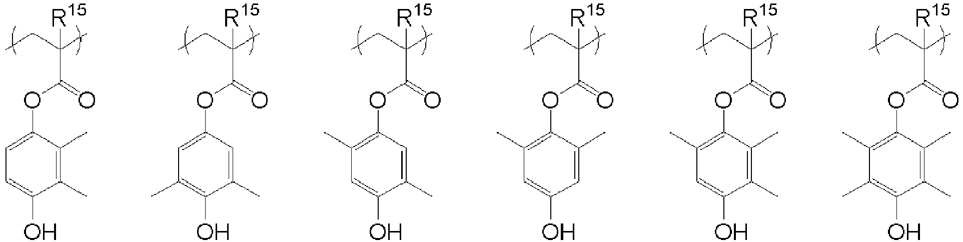

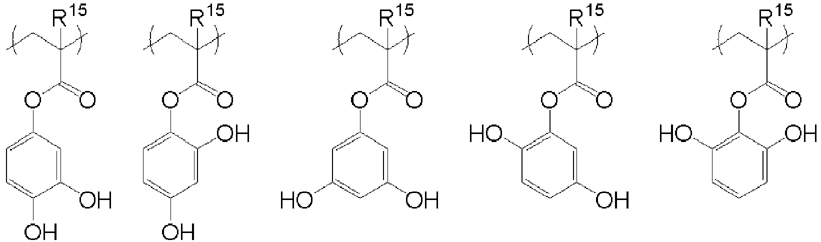

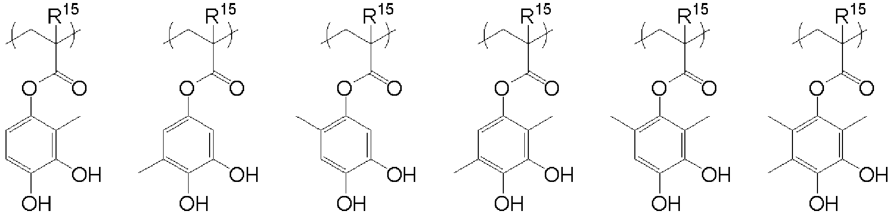

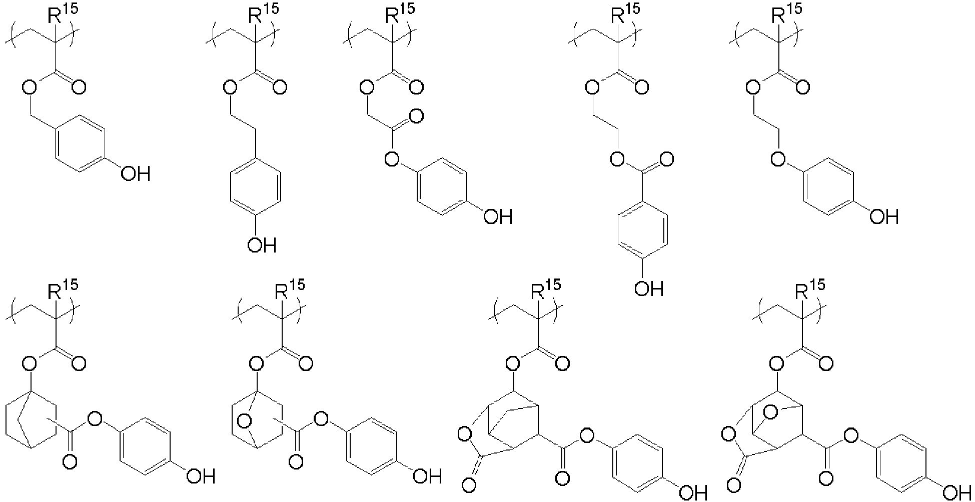

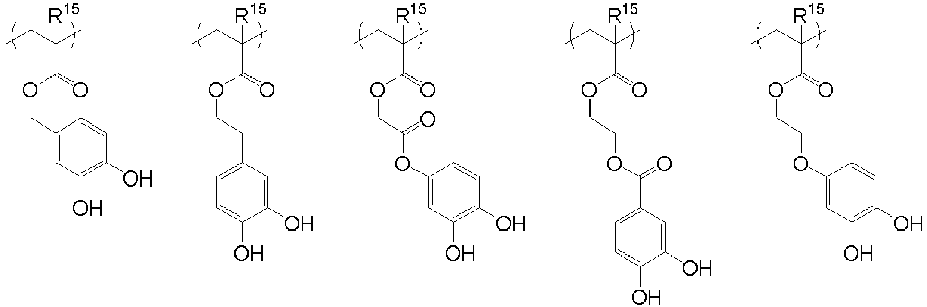

When the R¹⁸ in the general formula (6) represents -Z²¹-C(=O)-O-, -Z²¹-O-, or -Z²¹-O-C(=O)-, specific examples of the saturated hydrocarbylene group represented by Z²¹ which has 1 to 12 carbon atoms and optionally containing a carbonyl group, an ester bond, or an ether bond include the following, but are not limited thereto. 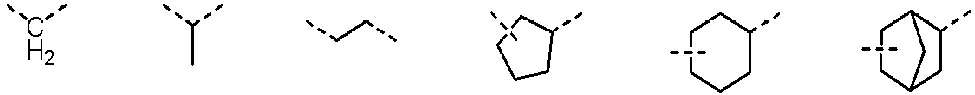 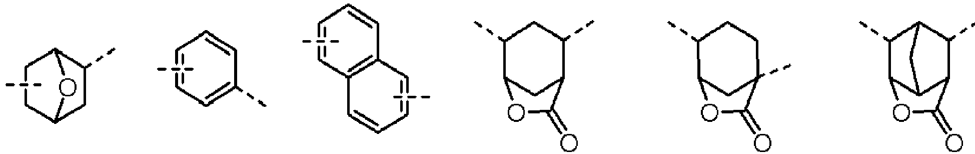 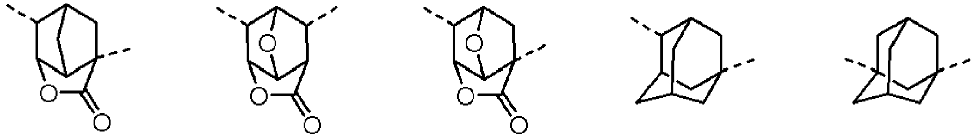 In the formulae, a broken line represents an attachment point.

The structural unit represented by the general formula (6) functions as an acid-generating group. A sulfonic acid is generated from this structural unit, and the sulfonic acid forms a hydrogen bond with the pattern. Thus, adhesiveness to the resist is improved. Moreover, since the generated acid is bonded to the polymer main chain, it is possible to prevent the degradation of pattern roughness and so forth of the resist upper layer film due to excessive diffusion of acid. When the resin has such a structural unit, excellent adhesiveness and scum prevention ability can be exhibited without adding a separate acid generator such as those described later.

Specific examples of anions of monomers that give the general formula (6) include the following, but are not limited thereto. In the following formulae, R¹⁷ is as defined above.

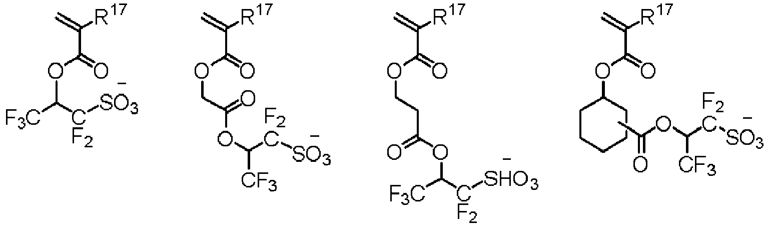

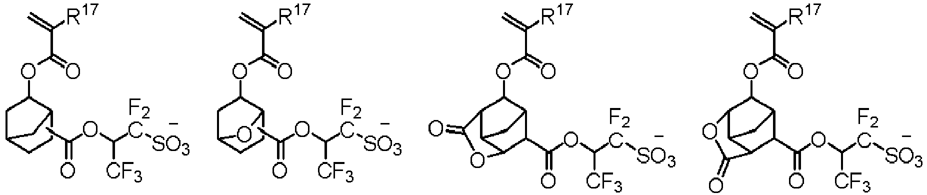

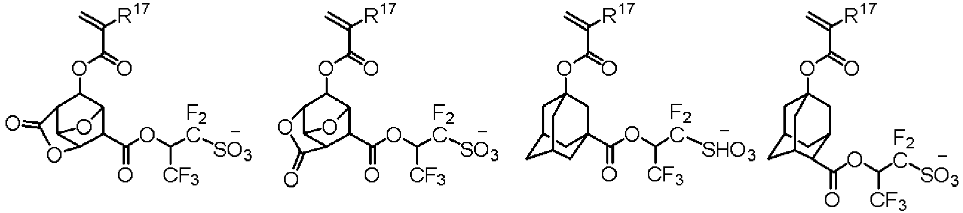

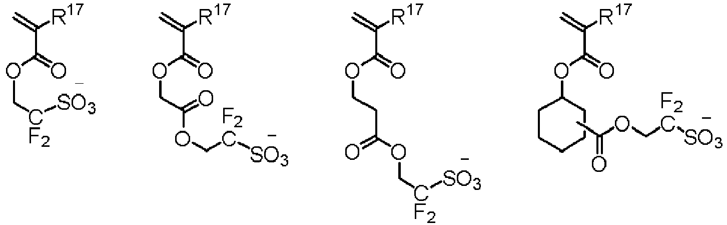

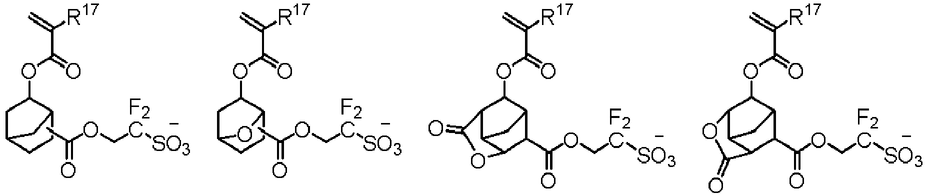

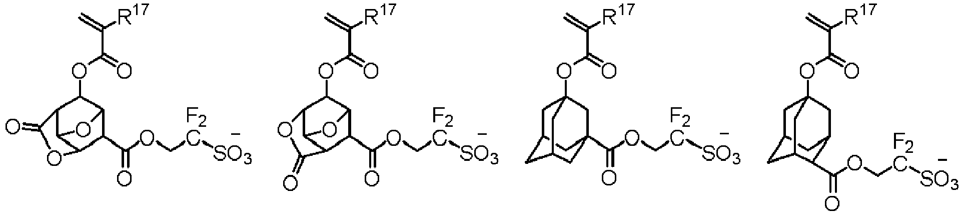

Examples of cations of monomers that give the general formula (6) include triphenylsulfonium, 4-hydroxyphenyldiphenylsulfonium, bis(4-hydroxyphenyl)phenylsulfonium, tris(4-hydroxyphenyl)sulfonium, 4-tert-butoxyphenyldiphenylsulfonium, bis(4-tert-butoxyphenyl)phenylsulfonium, tris(4-tert-butoxyphenyl)sulfonium, 3-tert-butoxyphenyldiphenylsulfonium, bis(3-tert-butoxyphenyl)phenylsulfonium, tris(3-tert-butoxyphenyl)sulfonium, 3,4-di-tert-butoxyphenyldiphenylsulfonium, bis(3,4-di-tert-butoxyphenyl)phenylsulfonium, tris(3,4-di-tert-butoxyphenyl)sulfonium, diphenyl(4-thiophenoxyphenyl)sulfonium, 4-tert-butoxycarbonylmethyloxyphenyldiphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, (4-hydroxy-3,5-dimethylphenyl)diphenylsulfonium, (4-n-hexyloxy-3,5-dimethylphenyl)diphenylsulfonium, dimethyl(2-naphthyl)sulfonium, 4-hydroxyphenyldimethylsulfonium, 4-methoxyphenyldimethylsulfonium, trimethylsulfonium, 2-oxocyclohexylcyclohexylmethylsulfonium, trinaphthylsulfonium, tribenzylsulfonium, diphenylmethylsulfonium, dimethylphenylsulfonium, 2-oxo-2-phenylethylthiacyclopentanium, diphenyl-2-thienylsulfonium, 4-n-butoxynaphthyl-1-thiacyclopentanium, 2-n-butoxynaphthyl-1-thiacyclopentanium, 4-methoxynaphthyl-1-thiacyclopentanium, 2-methoxynaphthyl-1-thiacyclopentanium, and the like. More preferable examples include triphenylsulfonium, 4-tert-butylphenyldiphenylsulfonium, 4-tert-butoxyphenyldiphenylsulfonium, tris(4-tert-butylphenyl)sulfonium, tris(4-tert-butoxyphenyl)sulfonium, dimethylphenylsulfonium, and the like. Further examples also include those represented by the following structures, but are not limited thereto.

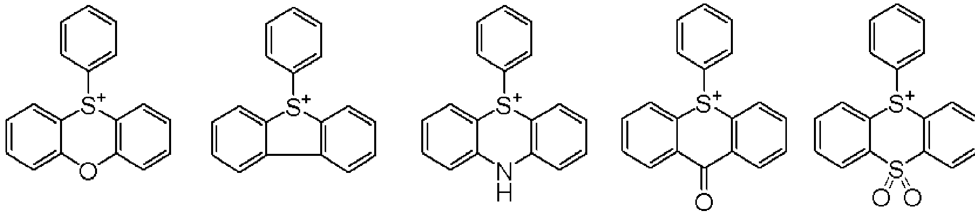

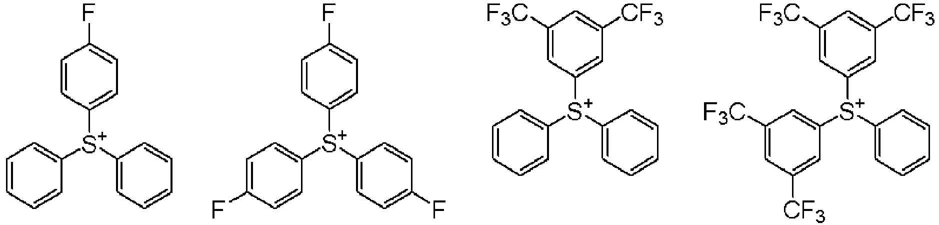

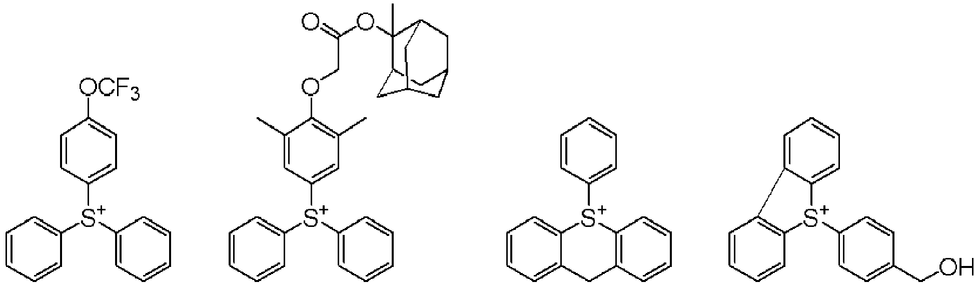

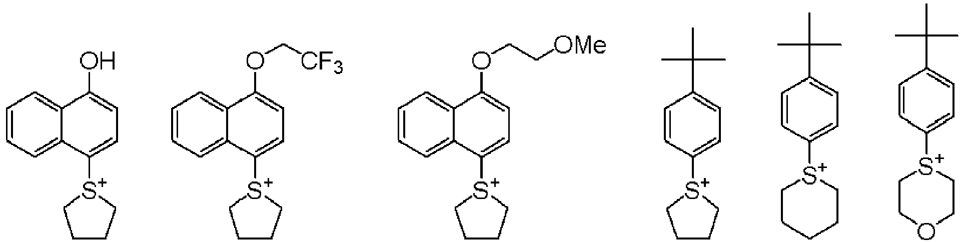

In addition, the resin (A) contained in the inventive material for forming an adhesive film has a structural unit containing an acid-dissociable group and has at least two kinds of structural units represented by the general formula (1).

By combining a plurality of structural units, not only is the progress of an elimination reaction adjusted, adhesiveness enhanced, and the effect of suppressing fine pattern collapse enhanced, it is also possible to make appropriate adjustments to the pattern profile, exposure sensitivity, and so forth of the resist upper layer film.

Furthermore, in the present invention, the structural unit represented by the general formula (1) in the resin (A) preferably has a molar fraction of 10% or more and 99% or less, more preferably 60% or more and 95% or less. Meanwhile, the structural unit containing an acid-dissociable group preferably has a molar fraction of 0.1% or more and 60% or less, more preferably 3% or more and 20% or less. Meanwhile, the structural units represented by (5) and (6) preferably have a molar fraction of 0% or more and 60% or less, more preferably 3% or more and 20% or less. By combining the structural units within such ranges, it is possible to provide adhesiveness while maintaining curability.

In particular, a total number of moles of the structural unit represented by the general formula (1) is preferably 0.10 or more and 0.99 or less, a total number of moles of the structural unit containing an acid-dissociable group is preferably 0.001 or more and 0.60 or less, and a total number of moles of the structural units represented by (5) and (6) is preferably 0 or more and 0.60 or less where a total number of moles of all the structural units in the resin (A) is 1.0. When the constitutional ratio of the structural units in the resin (A) is as described, the amount of polar groups at the surface of the film changes due to the elimination of acid-dissociable groups in exposed portions, and thus, it is possible to form an adhesive film having high adhesiveness to a resist upper layer film and a high ability to suppress scum in patterned portions.

Note that when the total of the molar fractions of the structural units represented by the general formula (1), the structural unit containing an acid-dissociable group, and the repeating units represented by (5) and (6) does not reach 100%, the resin (A) contains other structural units. In such a case, as the other structural units, the resin (A) may include each or a combination of any structural units derived from: α,β-unsaturated carboxylic esters, such as other acrylates, other methacrylates, other acrylamides, other methacrylamides, crotonates, maleates, and itaconates; α,β-unsaturated carboxylic acids, such as methacrylic acid, acrylic acid, maleic acid, and itaconic acid; acrylonitrile; methacrylonitrile; α,β-unsaturated lactones, such as 5,5-dimethyl-3-methylene-2-oxotetrahydrofuran; cyclic olefins, such as norbornene derivatives and tetracyclo[4.4.0.1^{2,5}.1^{7,10}]dodecene derivatives; α,β-unsaturated carboxylic anhydrides, such as maleic anhydride and itaconic anhydride; allyl ethers; vinyl ethers; vinyl esters; and vinyl silanes.

A material for forming an adhesive film containing these resins can form a material for forming an adhesive film having high adhesiveness to a resist upper layer film and having an effect of suppressing fine pattern collapse, and can be manufactured easily.

By using a material for forming an adhesive film containing such a resin for forming a multilayer resist film applied in fine processing in a manufacturing process of a semiconductor device or the like, it is possible to provide a material for forming an adhesive film that has high adhesiveness to a resist upper layer film and has an effect of suppressing fine pattern collapse, a method for forming an adhesive film, and a patterning process.

The resin can be synthesized according to known methods. The polymerization reaction is not particularly limited, but is preferably radical polymerization. Regarding these methods, JP 2004-115630 A may be consulted.

The resin preferably has a weight-average molecular weight (Mw) of 3,000 to 70,000, more preferably 15,000 to 50,000. When the Mw is 3,000 or more, excellent film-formability can be provided, the generation of sublimation products during heat-curing can be suppressed, and the contamination of apparatuses due to sublimation products can be suppressed. Meanwhile, when the Mw is 70,000 or less, coatability failure or coating defects due to insufficient solubility to solvents can be suppressed. Furthermore, the resin preferably has a molecular weight distribution (Mw/Mn) of 1.0 to 3.8, more preferably 1.0 to 2.8. Note that in the present invention, Mw and molecular weight distribution are values measured in terms of polystyrene by gel permeation chromatography (GPC) using tetrahydrofuran (THF) as an eluent.

### [(B) Photo-Acid Generator]

In the inventive material for forming an adhesive film, a photo-acid generator (B) can be contained in order to eliminate acid-dissociable groups locally in exposed portions.

Examples of the photo-acid generator (B) that can be used in the material for forming an adhesive film of the present invention include the following general formula (7) etc., besides the structural unit represented by the general formula (6) contained in the resin.

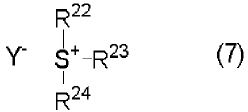

In the formula, R²², R²³, and R²⁴ each independently represent a linear, branched, or cyclic alkyl group or alkenyl group having 1 to 10 carbon atoms, the group optionally being substituted with a heteroatom and optionally having an intervening heteroatom, or represent an aryl group or aralkyl group having 6 to 18 carbon atoms, the group optionally being substituted with a heteroatom and optionally having an intervening heteroatom. Furthermore, any two of R²², R²³, and R²⁴ may be bonded to each other to form a ring together with the sulfur atom in the formula. Y⁻ represents the following general formula (8) or (9).

R²⁵-CF₂-SO₃⁻ (8)

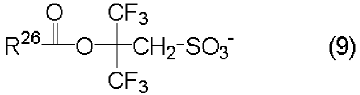

In the formulae, R²⁵ and R²⁶ each independently represent a monovalent hydrocarbon group including an alicyclic structure having 3 to 40 carbon atoms, the group optionally being substituted with a heteroatom and optionally having an intervening heteroatom.

Here, the general formula (8) is more preferably shown by the following general formula (8').

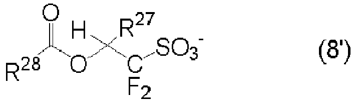

In the formula, R²⁷ represents a hydrogen atom or a trifluoromethyl group. R²⁸ represents a monovalent hydrocarbon group including an alicyclic structure having 3 to 30 carbon atoms, the group optionally being substituted with a heteroatom and optionally having an intervening heteroatom.

Specific examples of R²², R²³, and R²⁴ include alkyl groups, such as a methyl group, an ethyl group, an n-propyl group, an isopropyl group, an n-butyl group, a tert-butyl group, a cyclopropyl group, a cyclopentyl group, a cyclohexyl group, a cyclopropylmethyl group, a 4-methylcyclohexyl group, a cyclohexylmethyl group, a norbornyl group, and an adamantyl group; alkenyl groups, such as a vinyl group, an allyl group, a propenyl group, a butenyl group, a hexenyl group, and a cyclohexenyl group; aryl groups, such as a phenyl group, a naphthyl group, and a thienyl group; aralkyl groups, such as a benzyl group, a 1-phenylethyl group, and a 2-phenylethyl group; etc. Aryl groups are preferable. In addition, part of the hydrogen atoms of these groups may be substituted with a heteroatom such as an oxygen atom, a sulfur atom, a nitrogen atom, or a halogen atom, and the groups may have an intervening heteroatom, such as an oxygen atom, a sulfur atom, or a nitrogen atom. The resulting group may form groups or have intervening groups, such as a hydroxy group, a cyano group, a carbonyl group, an ether bond, an ester bond, a sulfonic acid ester bond, a carbonate bond, a lactone ring, a sultone ring, a carboxylic anhydride, a haloalkyl group, etc.

Specific examples of the Y⁻ in the general formula (7) include the following, but are not limited thereto.

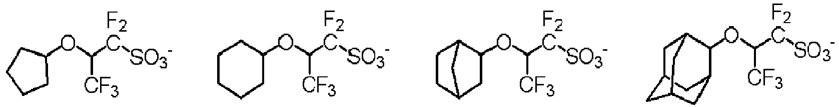

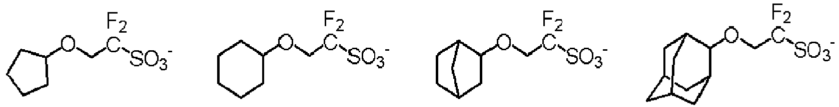

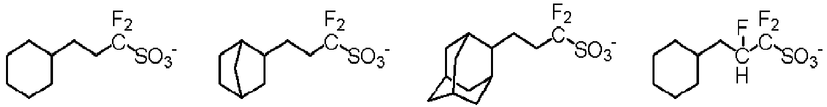

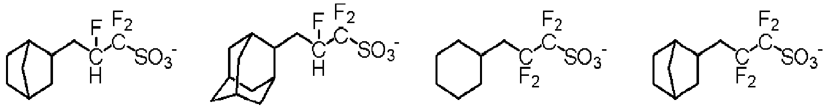

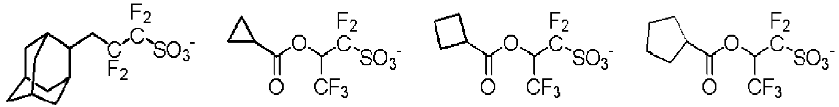

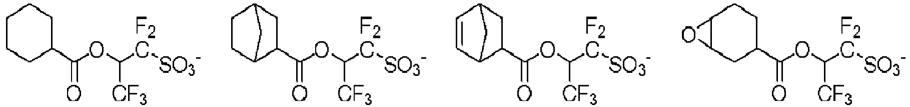

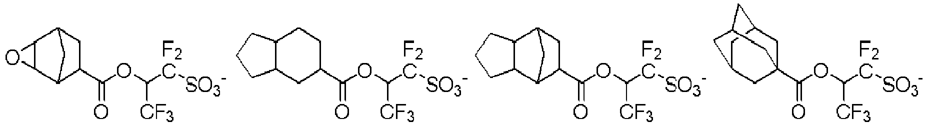

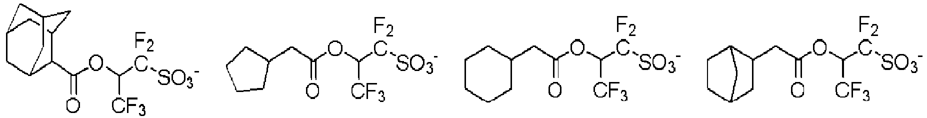

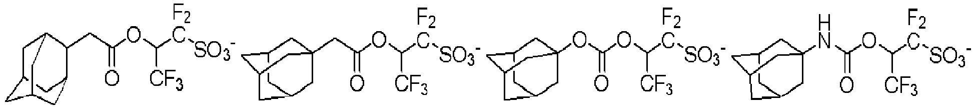

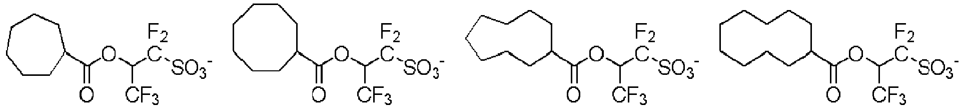

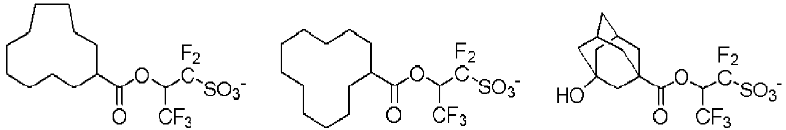

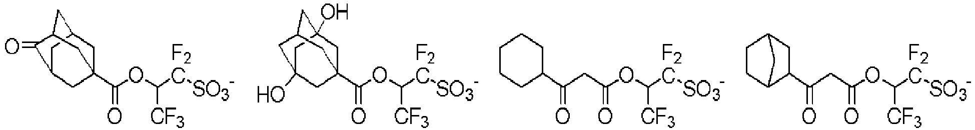

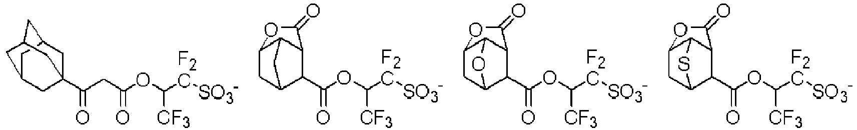

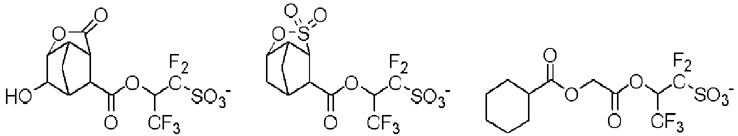

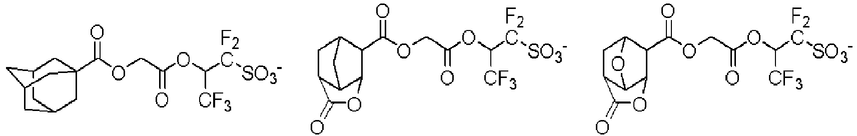

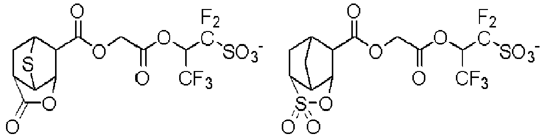

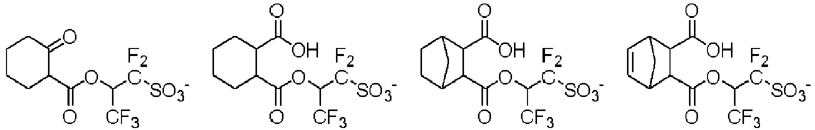

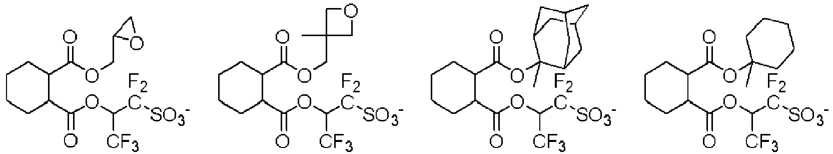

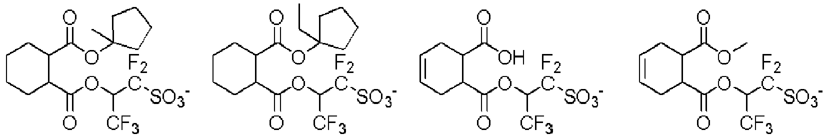

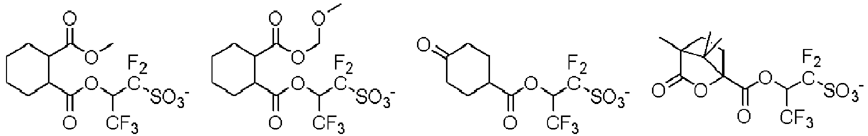

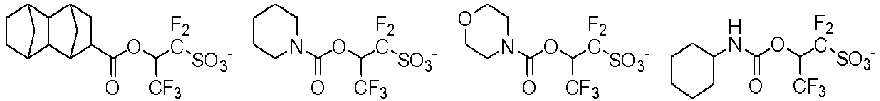

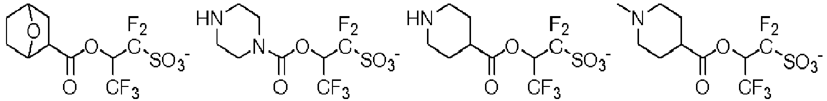

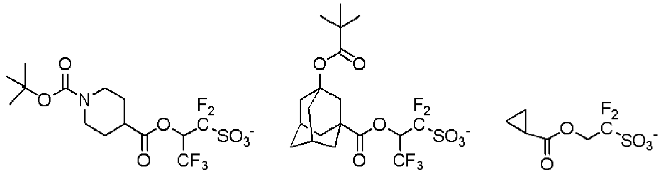

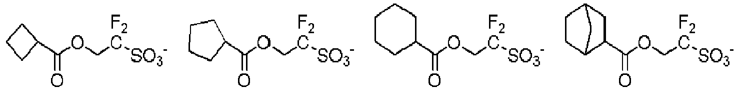

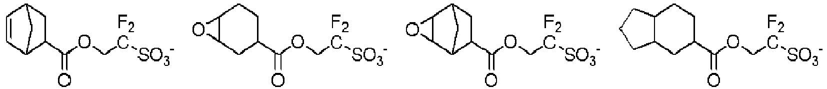

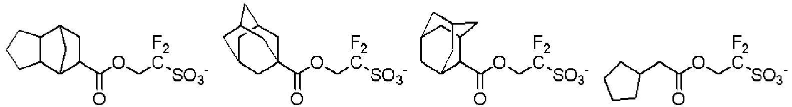

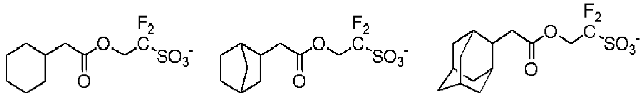

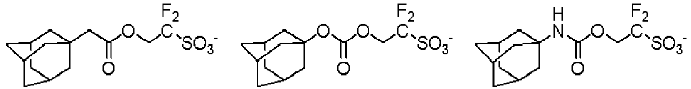

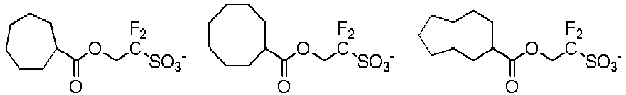

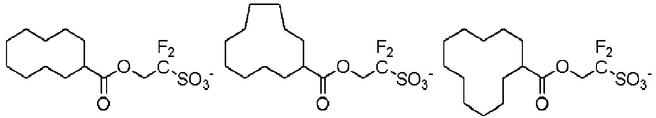

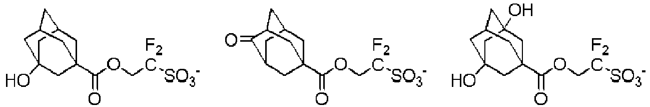

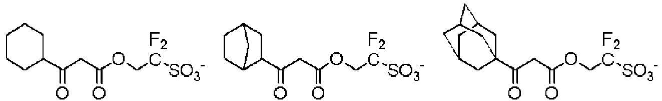

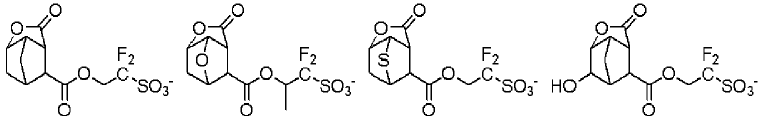

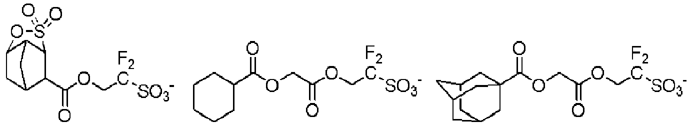

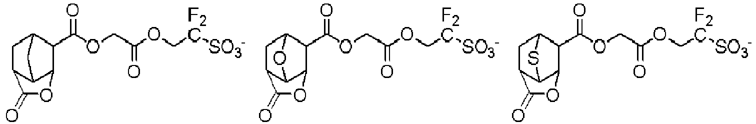

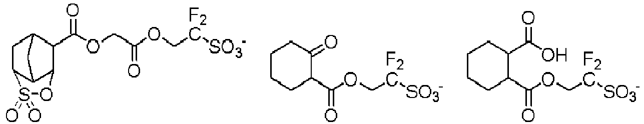

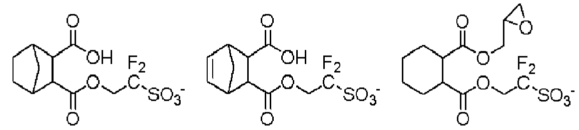

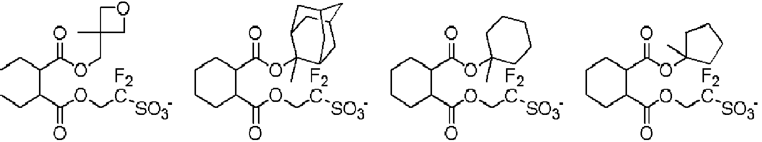

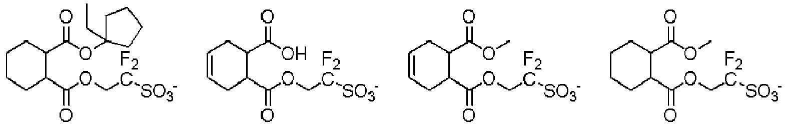

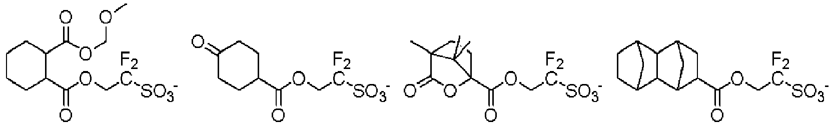

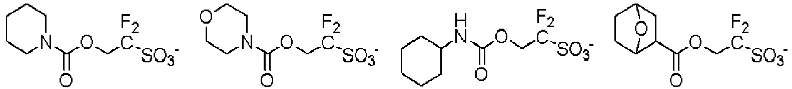

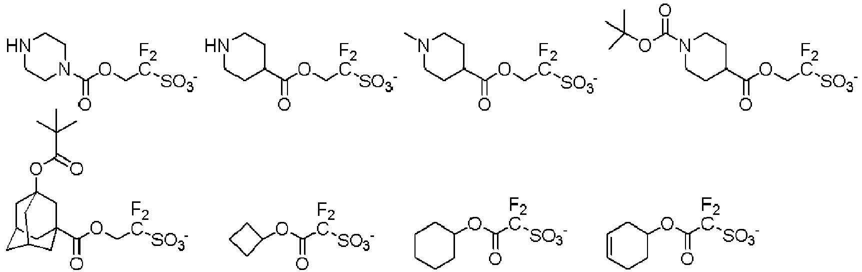

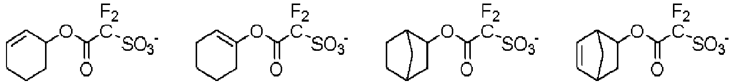

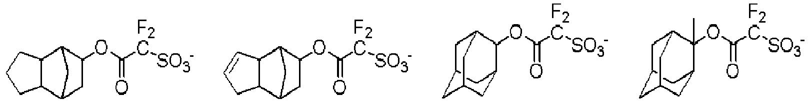

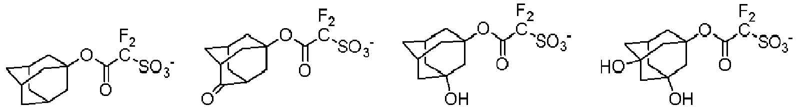

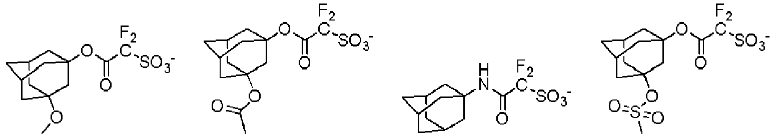

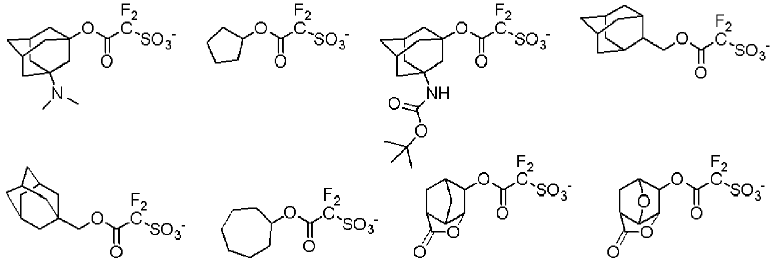

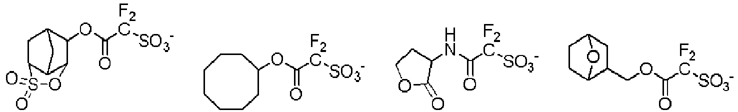

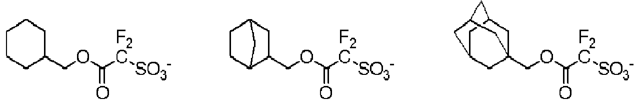

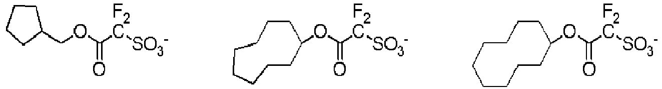

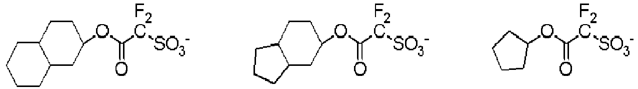

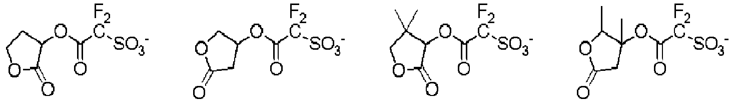

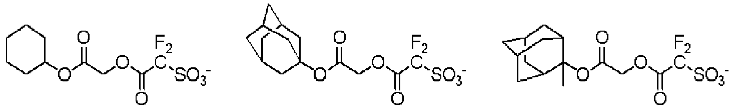

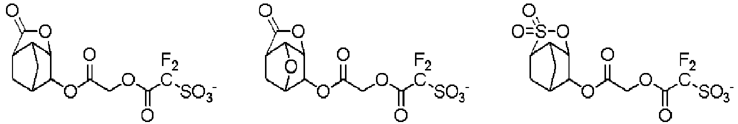

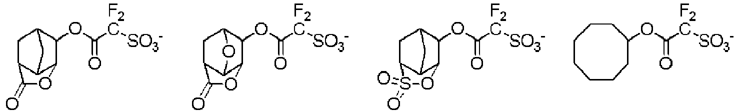

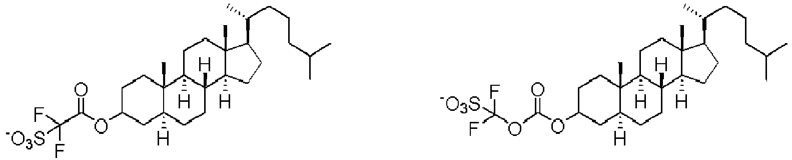

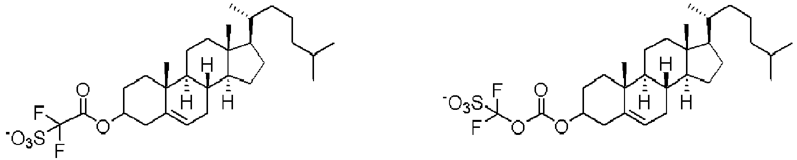

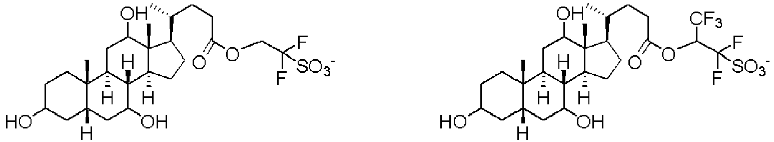

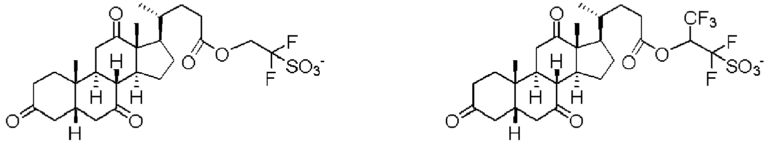

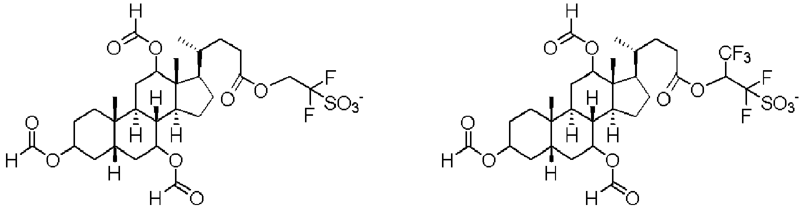

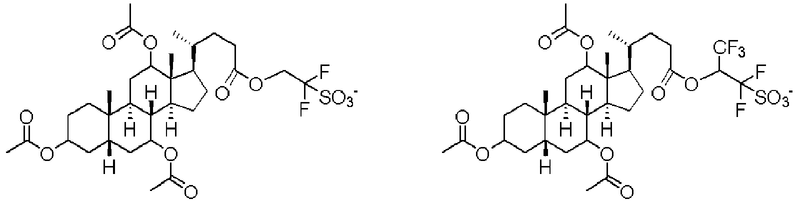

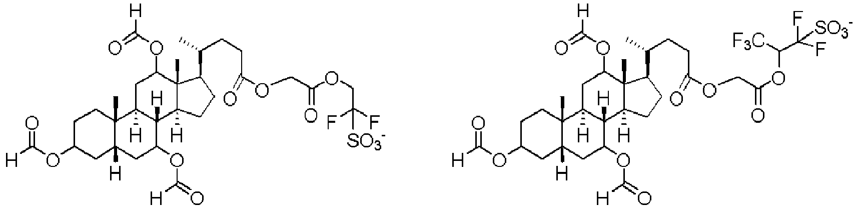

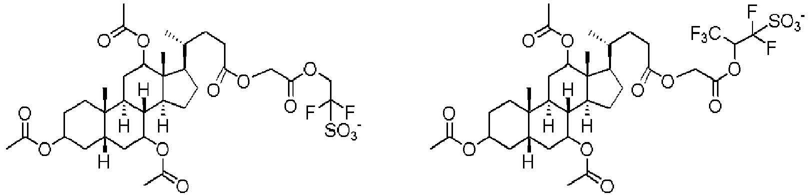

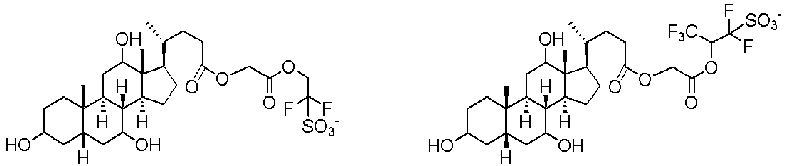

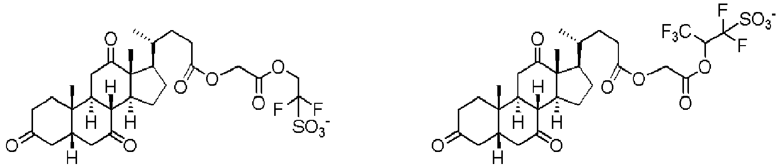

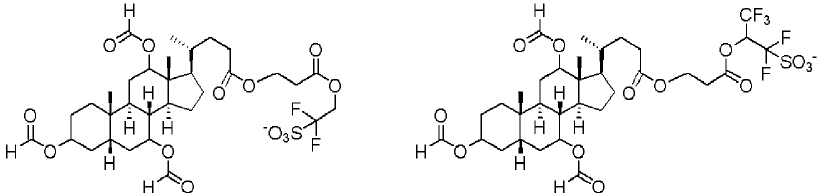

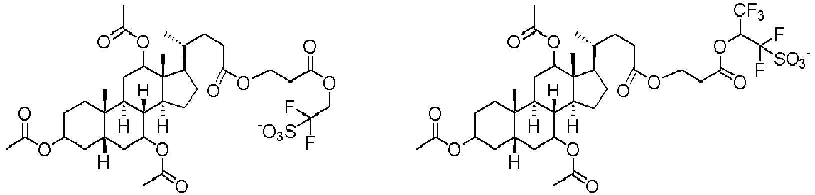

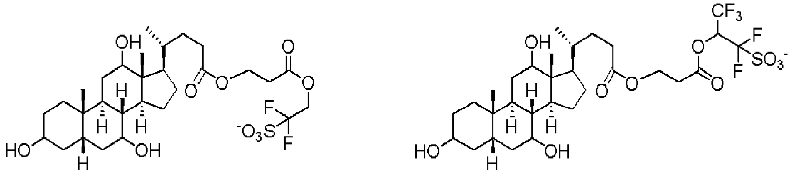

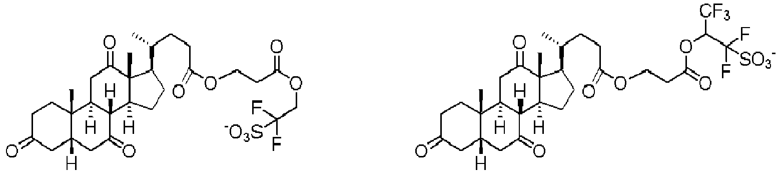

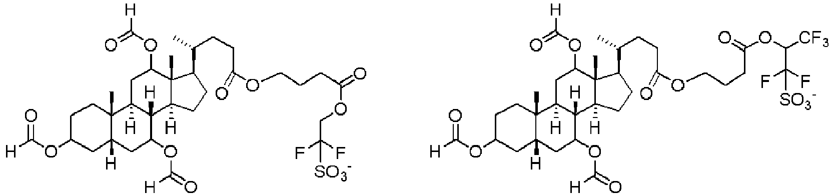

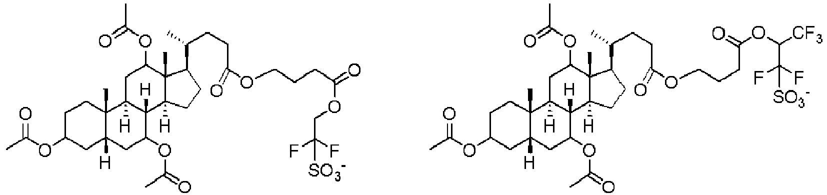

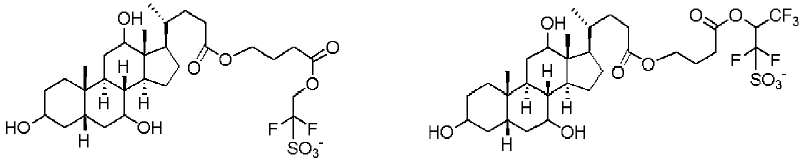

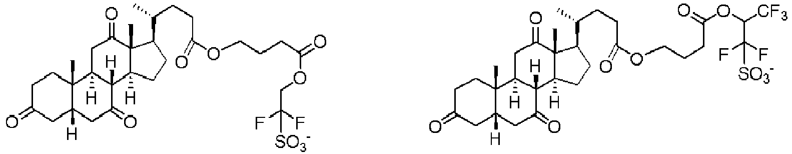

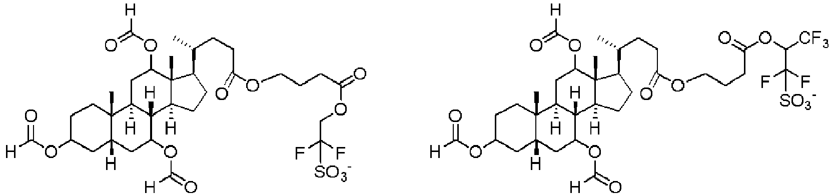

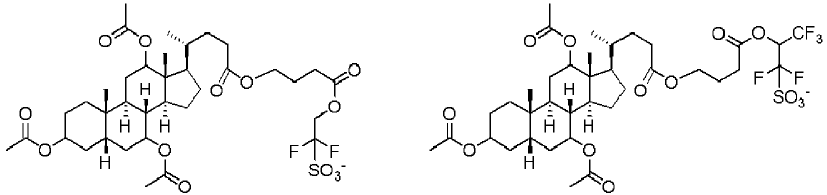

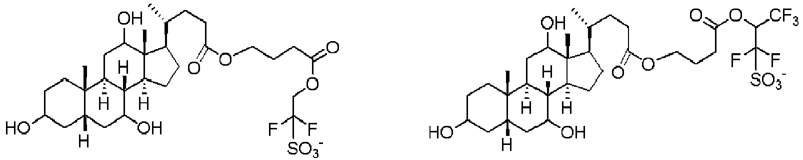

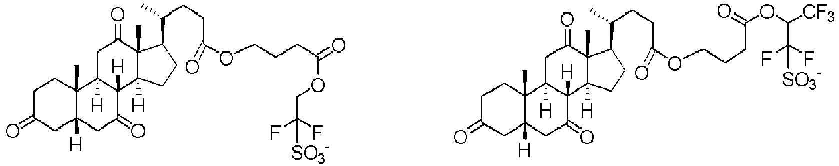

One kind of the photo-acid generator may be used, or a combination of two or more kinds thereof may be used to adjust appropriately the pattern profile, exposure sensitivity, etc. of the resist upper layer film. When the photo-acid generator is to be contained, the amount to be contained is preferably 1 mass% to 20 mass%, more preferably 3 mass% to 15 mass% based on 100 mass% of the resin. When the amount of the photo-acid generator contained is within the above ranges, the elimination of the acid-dissociable groups is favorable, and there is no risk of problems of foreign substances occurring after resist development or during removal.

### [(C) Organic Solvent]

The organic solvent (C) contained in the material for forming an adhesive film to be used in the inventive method for forming an adhesive film is not particularly limited as long as the organic solvent is capable of dissolving the above-described resin (A), photo-acid generator (B), and if contained, other additives, etc. Specific examples include organic solvents disclosed in paragraphs [0144] to [0145] of JP 2008-111103 A including: ketones, such as cyclohexanone and methyl-2-n-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters, such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate; and lactones, such as γ-butyrolactone. One of these solvents may be used, or two or more thereof may be used in mixture, but the solvent is not limited thereto.

### [Other Additives]

The inventive material for forming an adhesive film can further contain one or more out of (D) a surfactant, (E) a crosslinking agent, and (F) a thermal acid generator besides the components (A) to (C). Each component will be described below.

### [(D) Surfactant]

In the inventive material for forming an adhesive film, a surfactant (D) can be contained so as to enhance the coating property in spin-coating. One kind of surfactant may be used or two or more kinds thereof may be used in combination. As examples of the surfactant, those disclosed in paragraphs [0142] to [0147] of JP 2009-269953 A can be used. When the surfactant is to be contained, the contained amount is preferably 0.001 to 20 parts, more preferably 0.01 to 10 parts based on 100 parts of the resin (A).

### [(E) Crosslinking Agent]

In addition, in the inventive material for forming an adhesive film, a crosslinking agent (E) can also be contained so as to increase curability and to further suppress intermixing with a resist upper layer film. The crosslinking agent is not particularly limited, and known various types of crosslinking agents can be widely used. Examples thereof include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. One kind of the crosslinking agent (E) may be used or two or more kinds thereof may be used in combination. When the crosslinking agent is to be contained, the amount to be contained is preferably 5 to 50 parts, more preferably 10 to 40 parts based on 100 parts of the resin (A). When the contained amount is 10 parts or more, sufficient curability can be exhibited, so that intermixing with the resist upper layer film can be suppressed. Meanwhile, when the contained amount is 50 parts or less, there is no risk of adhesiveness degradation due to a decrease in the proportion of the resin (A) in the composition.

Specific examples of the melamine-based crosslinking agents include hexamethoxymethylated melamine, hexabutoxymethylated melamine, alkoxy- and/or hydroxy-substituted derivatives thereof, and partial self-condensates thereof. Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof. Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof. Specific examples of the urea-based crosslinking agents include dimethoxymethylated dimethoxyethyleneurea, alkoxy- and/or hydroxy-substituted derivatives thereof, and partial self-condensates thereof. A specific example of the β-hydroxyalkylamide-based crosslinking agents includes N,N,N',N'-tetra(2-hydroxyethyl)adipic acid amide. Specific examples of the isocyanurate-based crosslinking agents include triglycidyl isocyanurate and triallyl isocyanurate. Specific examples of the aziridine-based crosslinking agents include 4,4'-bis(ethyleneiminocarbonylamino)diphenylmethane and 2,2-bishydroxymethylbutanol-tris[3-(1-aziridinyl)propionate]. Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylenebis4,5-diphenyl-2-oxazoline, 2,2'-methylenebis-4-phenyl-2-oxazoline, 2,2'-methylenebis-4-tert-butyl-2-oxazoline, 2,2'-bis(2-oxazoline), 1,3-phenylenebis(2-oxazoline), 1,4-phenylenebis(2-oxazoline), and a 2-isopropenyloxazoline copolymer. Specific examples of the epoxy-based crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of polynuclear phenol-based crosslinking agents include compounds shown by the following general formula (13).

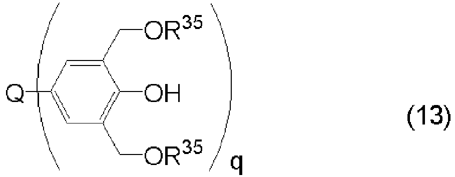

In the formula, Q represents a single bond or a hydrocarbon group with a valency of "q" having 1 to 20 carbon atoms. R³⁵ represents a hydrogen atom or an alkyl group having 1 to 20 carbon atoms. "q" represents an integer of 1 to 5.

Q represents a single bond or a hydrocarbon group with a valency of "q" having 1 to 20 carbon atoms. "q" represents an integer of 1 to 5, more preferably 2 or 3. Specific examples of Q include groups obtained by removing q hydrogen atoms from methane, ethane, propane, butane, isobutane, pentane, cyclopentane, hexane, cyclohexane, methyl pentane, methyl cyclohexane, dimethyl cyclohexane, trimethyl cyclohexane, benzene, toluene, xylene, ethyl benzene, ethyl isopropylbenzene, diisopropylbenzene, methylnaphthalene, ethyl naphthalene, and eicosane. R³⁵ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. A hydrogen atom or a methyl group is preferable.

Specific examples of the compound represented by the general formula (13) include the following compounds. In particular, in view of enhancing the curability and film thickness uniformity of the adhesive film, hexamethoxymethylated compounds of triphenolmethane, triphenolethane, 1,1,1-tris(4-hydroxyphenyl)ethane, and tris(4-hydroxyphenyl)-1-ethyl-4-isopropylbenzene are preferable.

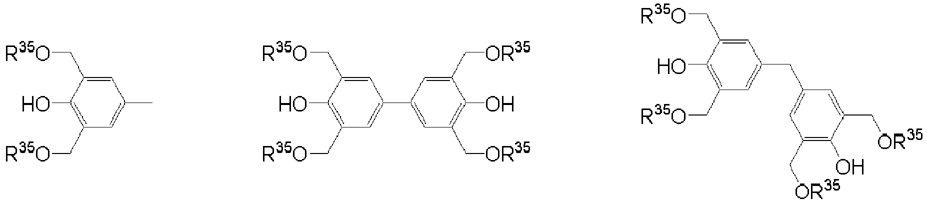

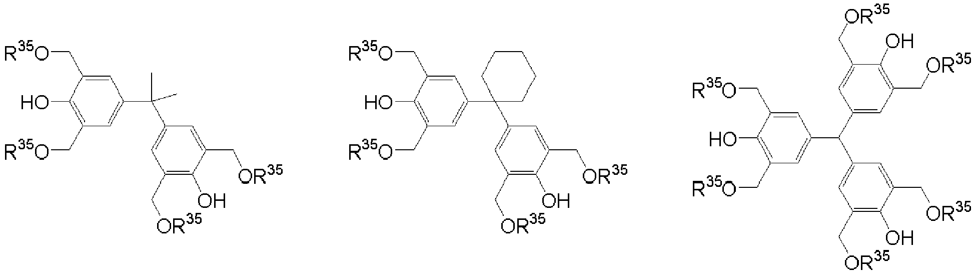

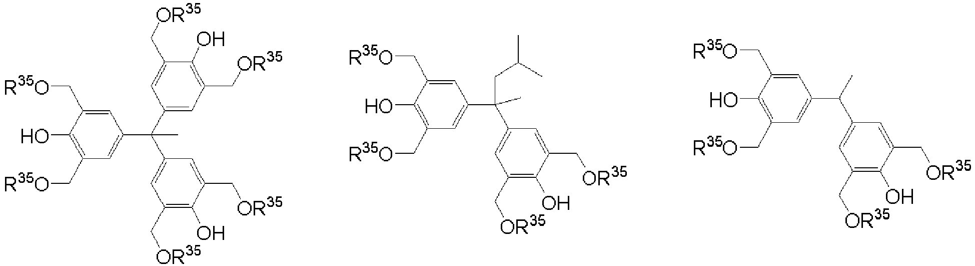

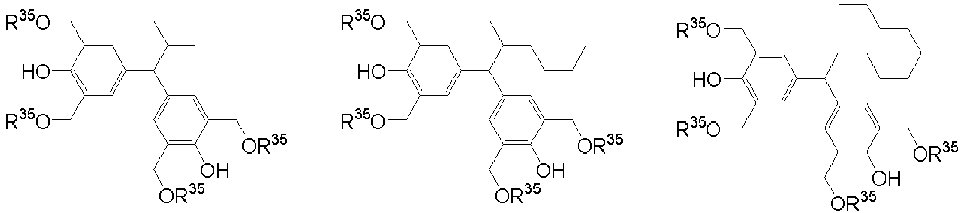

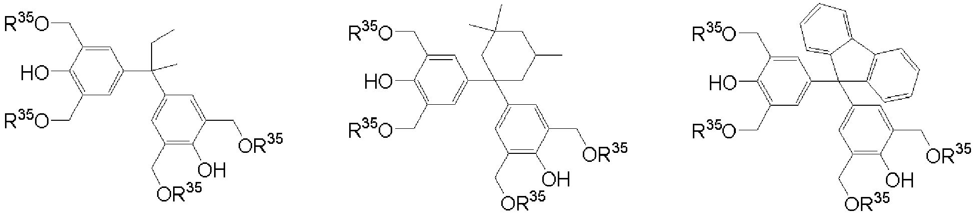

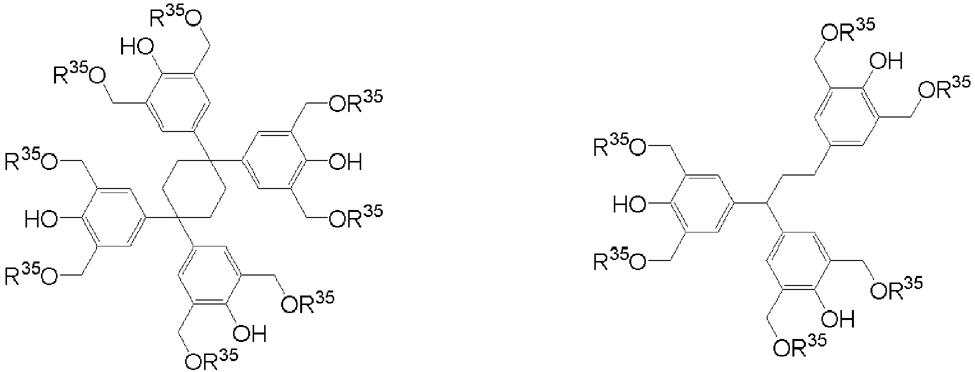

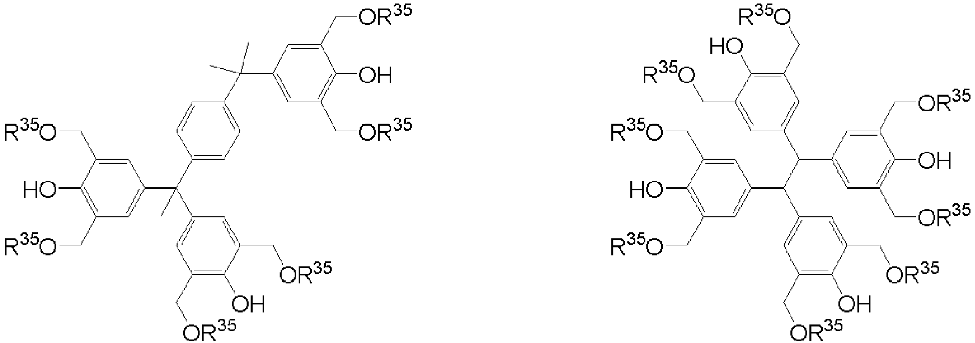

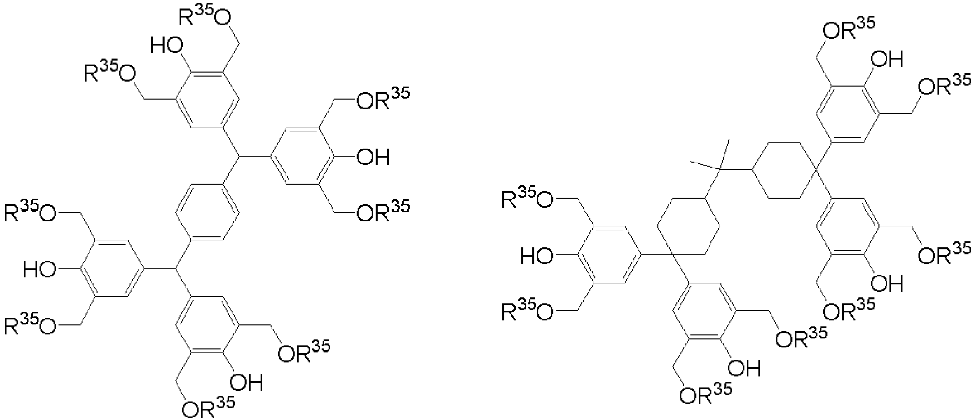

One kind of the crosslinking agent (E) can be used, or two or more kinds thereof can be used in combination. The amount of the crosslinking agent (E) to be contained is preferably 10 mass% to 50 mass%, more preferably 15 mass% to 30 mass% based on 100 parts of the resin (A). When the contained amount is 10 mass% or more, sufficient curability can be provided, so that intermixing with the resist upper layer film can be suppressed. Meanwhile, when the contained amount is 50 mass% or less, there is no risk of adhesiveness degradation due to decrease in the proportion of the resin (A) in the composition.

### [(F) Thermal Acid Generator]

The inventive material for forming an adhesive film can contain a thermal acid generator (F) in order to promote a crosslinking reaction by heat and partially eliminate acid-dissociable groups.

Examples of a thermal acid generator (F) that can be used in the material for forming an adhesive film of the present invention include those represented by the following general formula (10) and the like. 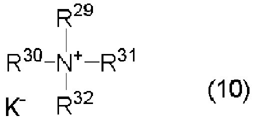 In the formula, K⁻ represents a non-nucleophilic counter ion. R²⁹, R³⁰, R³¹, and R³² each represent a hydrogen atom, a linear, branched, or cyclic alkyl group, alkenyl group, oxoalkyl group, or oxoalkenyl group having 1 to 12 carbon atoms, an aryl group having 6 to 20 carbon atoms, or an aralkyl group or aryloxoalkyl group having 7 to 12 carbon atoms, some or all of the hydrogen atoms of these groups optionally being substituted with an alkoxy group or the like. In addition, R²⁹ and R³⁰ or R²⁹, R³⁰, and R³¹ may form a ring. When forming a ring, R²⁹ and R³⁰ or R²⁹, R³⁰, and R³¹ represent an alkylene group having 3 to 10 carbon atoms, or a heterocyclic aromatic ring containing the nitrogen atom in the formula therein.

R²⁹, R³⁰, R³¹, and R³² may be identical to or different from one another. Specifically, examples of the alkyl group include a methyl group, an ethyl group, a propyl group, an isopropyl group, an n-butyl group, a sec-butyl group, a tert-butyl group, a pentyl group, a hexyl group, a heptyl group, an octyl group, a cyclopentyl group, a cyclohexyl group, a cycloheptyl group, a cyclopropylmethyl group, a 4-methylcyclohexyl group, a cyclohexylmethyl group, a norbornyl group, an adamantyl group, and the like. Examples of the alkenyl group include a vinyl group, an allyl group, a propenyl group, a butenyl group, a hexenyl group, a cyclohexenyl group, and the like. Examples of the oxoalkyl group include a 2-oxocyclopentyl group, a 2-oxocyclohexyl group, a 2-oxopropyl group, a 2-cyclopentyl-2-oxoethyl group, a 2-cyclohexyl-2-oxoethyl group, a 2-(4-methylcyclohexyl)-2-oxoethyl group, and the like. Examples of the oxoalkenyl group include a 2-oxo-4-cyclohexenyl group, a 2-oxo-4-propenyl group, and the like. Examples of the aryl group include a phenyl group, a naphthyl group, and the like; alkoxyphenyl groups, such as a p-methoxyphenyl group, an m-methoxyphenyl group, an o-methoxyphenyl group, an ethoxyphenyl group, a p-tert-butoxyphenyl group, and an m-tert-butoxyphenyl group; alkylphenyl groups, such as a 2-methylphenyl group, a 3-methylphenyl group, a 4-methylphenyl group, an ethylphenyl group, a 4-tert-butylphenyl group, a 4-butylphenyl group, and a dimethylphenyl group; alkylnaphthyl groups, such as a methylnaphthyl group and an ethylnaphthyl group; alkoxynaphthyl groups, such as a methoxynaphthyl group and an ethoxynaphthyl group; dialkylnaphthyl groups, such as a dimethylnaphthyl group and a diethylnaphthyl group; dialkoxynaphthyl groups, such as a dimethoxynaphthyl group and a diethoxynaphthyl group; and the like. Examples of the aralkyl group include a benzyl group, a phenylethyl group, a phenethyl group, and the like. Examples of the aryloxoalkyl group include 2-aryl-2-oxoethyl groups, such as a 2-phenyl-2-oxoethyl group, a 2-(1-naphthyl)-2-oxoethyl group, and a 2-(2-naphthyl)-2-oxoethyl group; and the like.

In addition, examples of the heterocyclic aromatic ring, the R²⁹, R³⁰, R³¹, and R³² having, in the ring, the nitrogen atom in the formula, include imidazole derivatives (for example, imidazole, 4-methylimidazole, 4-methyl-2-phenylimidazole, etc.), pyrazole derivatives, furazan derivatives, pyrroline derivatives (for example, pyrroline, 2-methyl-1-pyrroline, etc.), pyrrolidine derivatives (for example, pyrrolidine, N-methylpyrrolidine, pyrrolidinone, N-methylpyrrolidone, etc.), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, dimethylaminopyridine, etc.), pyridazine derivatives, pyrimidine derivatives, pyrazine derivatives, pyrazoline derivatives, pyrazolidine derivatives, piperidine derivatives, piperadine derivatives, morpholine derivatives, indole derivatives, isoindole derivatives, 1H-indazole derivatives, indoline derivatives, quinoline derivatives (for example, quinoline, 3-quinolinecarbonitrile, etc.), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, uridine derivatives, etc.

The non-nucleophilic counter ion of K⁻ includes halide ions, such as a chloride ion and a bromide ion; fluoroalkyl sulfonate ions, such as triflate ion, 1,1,1-trifluoroethanesulfonate ion, and nonafluorobutanesulfonate ion; arylsulfonate ions, such as tosylate ion, benzenesulfonate ion, 4-fluorobenzenesulfonate ion, and 1,2,3,4,5-pentafluorobenzenesulfonate ion; alkylsulfonate ions, such as mesylate ion and butanesulfonate ion; imidic acid ions, such as bis(trifluoromethylsulfonyl)imide ion, bis(perfluoroethylsulfonyl)imide ion, and bis(perfluorobutylsulfonyl)imide ion; methide acid ions, such as tris(trifluoromethylsulfonyl)methide ion and tris(perfluoroethylsulfonyl)methide ion; furthermore, sulfonate ions having the α-position substituted with fluorine shown in the following general formula (11); and sulfonate ions having the α- and β-positions substituted with fluorine shown in the following general formula (12).

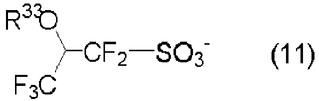

R³⁴-CF₂-CF₂-SO₃⁻ (12)

In the general formula (11), R³³ represents a hydrogen atom, a linear, branched, or cyclic alkyl group or acyl group having 1 to 20 carbon atoms, an alkenyl group having 2 to 20 carbon atoms, or an aryl group or aryloxy group having 6 to 20 carbon atoms. In the general formula (12), R³⁴ represents a hydrogen atom, a linear, branched, or cyclic alkyl group having 1 to 20 carbon atoms, an alkenyl group having 2 to 20 carbon atoms, or an aryl group having 6 to 20 carbon atoms.

Specific examples of the above-described thermal acid generator include the following.
(CH₃CH₂)₃N⁺H (CH₃CH₂)₃N⁺H (CH₃CH₂)₃N⁺H (CH₃CH₂)₃N⁺H (CH₃CH₂)₃N⁺H
C₄F₉SO₃⁻ 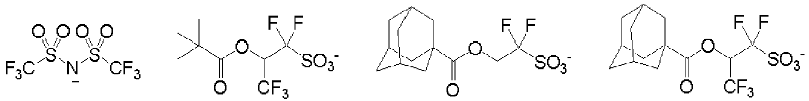 (CH₃CH₂)₃N⁺H (CH₃CH₂)₃N⁺H (CH₃CH₂)₃N⁺H 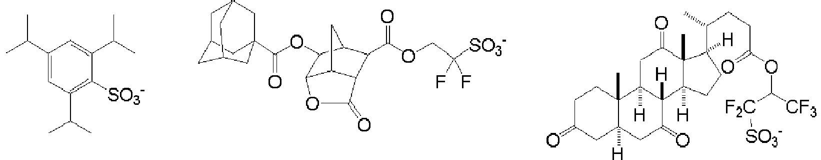 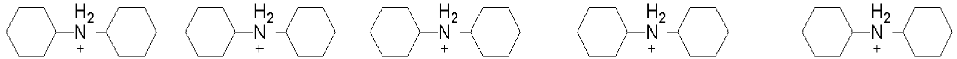 C₄F₉SO₃⁻

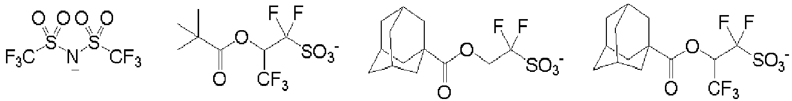

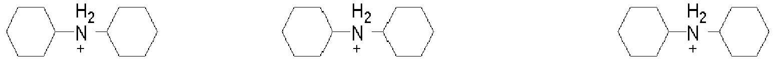

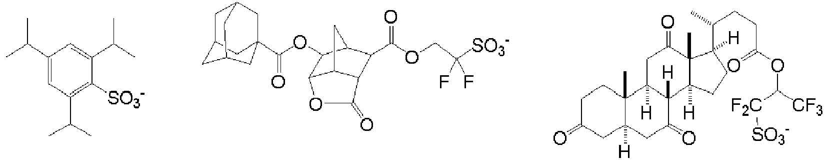

One kind of the thermal acid generator (B) contained in the inventive material for forming an adhesive film may be used or two or more kinds thereof may be used in combination. By adding a thermal acid generator, it is possible to promote a crosslinking reaction and achieve sufficient curability. On the other hand, since the elimination of acid-dissociable groups partially progresses due to acid originating from the thermal acid generator, a smaller amount is preferable as the amount to be added. Specifically, the amount is preferably 0.01 to 3 parts, more preferably 0.01 to 0.05 parts based on 100 parts of the resin (A). A material for forming an adhesive film, containing 0.05 parts or less of the thermal acid generator, is guaranteed to have sufficient curability, and in addition, part of the acid-dissociable groups are not eliminated and remain. Therefore, excellent adhesiveness and scum prevention ability can be expected.

### [Method for Forming Adhesive Film]

The present invention provides a method for forming an adhesive film by using the above-described material for forming an adhesive film, the adhesive film having high adhesiveness to a resist upper layer film and having an effect of suppressing fine pattern collapse in a fine patterning process according to a multilayer resist method in a semiconductor device manufacturing process.

The thickness of the material for forming an adhesive film used in the present invention is selected appropriately, but is preferably 2 to 50 nm, particularly preferably 5 to 20 nm.

In addition, the inventive material for forming an adhesive film is extremely useful as an adhesive film material for multilayer resist processes such as a 2-layer resist process and a 4-layer resist process using a resist underlayer film and a silicon-containing middle layer film.

The silicon-containing middle layer film can be a silicon-containing resist middle layer film or an inorganic hard mask middle layer film in accordance with the patterning processes described below. The inorganic hard mask middle layer film is preferably selected from a silicon oxide film, a silicon nitride film, and a silicon oxynitride film.

In the inventive method for forming an adhesive film, a substrate to be processed is coated with the above-described material for forming an adhesive film by a spin-coating method or the like. After the spin-coating, baking (a heat treatment) is performed in order to evaporate the organic solvent and promote a crosslinking reaction to prevent intermixing with the resist upper layer film or the silicon-containing middle layer film. The baking is preferably performed at 100°C or higher and 300°C or lower for 10 to 600 seconds, more preferably at 200°C or higher and 250°C or lower for 10 to 300 seconds. Considering the effect on damage to the adhesive film and deformation of the wafer, the upper limit of the heating temperature in the wafer process of the lithography is preferably set to 300°C or lower, more preferably 250°C or lower.

Alternatively, in the inventive method for forming an adhesive film, an adhesive film can also be formed by coating a substrate to be processed with the inventive material for forming an adhesive film by a spin-coating method or the like in the same manner as above and curing the material for forming an adhesive film by baking in an atmosphere having an oxygen concentration of 0.1% or more to 21% or less. By baking the inventive material for forming an adhesive film in such an oxygen atmosphere, a sufficiently cured film can be obtained.

The atmosphere during the baking may be in air, or an inert gas such as N₂, Ar, and He may also be introduced. In this event, the atmosphere may have an oxygen concentration of less than 0.1%. In addition, the baking temperature and so forth can be as described above. The crosslinking reaction during the adhesive film formation can be promoted without causing degradation of the substrate to be processed even when the substrate to be processed contains a material that is unstable to heating under an oxygen atmosphere.

### [Patterning Process]

Patterning processes in which the inventive material for forming an adhesive film is used include the following embodiments.
(i) A patterning process for forming a pattern in a substrate to be processed, including the steps of:
   (I-1) applying the inventive material for forming an adhesive film on a substrate to be processed and then performing a heat treatment to form an adhesive film;
   (I-2) forming a resist upper layer film on the adhesive film by using a photoresist material;
   (I-3) subjecting the resist upper layer film to pattern exposure and then to development with a developer to form a pattern in the resist upper layer film;
   (I-4) transferring the pattern to the adhesive film by dry etching while using the resist upper layer film having the formed pattern as a mask; and
   (I-5) forming the pattern in the substrate to be processed by etching the substrate to be processed while using the adhesive film having the formed pattern as a mask.
(ii) A patterning process for forming a pattern in a substrate to be processed, including the steps of:
   (II-1) forming a resist underlayer film on a substrate to be processed;
   (II-2) forming a silicon-containing resist middle layer film on the resist underlayer film;
   (II-3) applying the inventive material for forming an adhesive film on the silicon-containing resist middle layer film and then performing a heat treatment to form an adhesive film;
   (II-4) forming a resist upper layer film on the adhesive film by using a photoresist material;
   (II-5) subjecting the resist upper layer film to pattern exposure and then to development with a developer to form a pattern in the resist upper layer film;
   (II-6) transferring the pattern to the adhesive film by dry etching while using the resist upper layer film having the formed pattern as a mask;
   (II-7) transferring the pattern to the silicon-containing resist middle layer film by dry etching while using the adhesive film having the formed pattern as a mask;
   (II-8) transferring the pattern to the resist underlayer film by dry etching while using the silicon-containing resist middle layer film having the transferred pattern as a mask; and
   (II-9) forming the pattern in the substrate to be processed by etching the substrate to be processed while using the resist underlayer film having the formed pattern as a mask.
(iii) A patterning process for forming a pattern in a substrate to be processed, including the steps of:
   (III-1) forming a resist underlayer film on a substrate to be processed;
   (III-2) forming an inorganic hard mask middle layer film selected from a silicon oxide film, a silicon nitride film, and a silicon oxynitride film on the resist underlayer film;
   (III-3) applying the inventive material for forming an adhesive film on the inorganic hard mask middle layer film and then performing a heat treatment to form an adhesive film;
   (III-4) forming a resist upper layer film on the adhesive film by using a photoresist material;
   (III-5) subjecting the resist upper layer film to pattern exposure and then to development with a developer to form a pattern in the resist upper layer film;
   (III-6) transferring the pattern to the adhesive film by dry etching while using the resist upper layer film having the formed pattern as a mask;
   (III-7) transferring the pattern to the inorganic hard mask middle layer film by dry etching while using the adhesive film having the formed pattern as a mask;
   (III-8) transferring the pattern to the resist underlayer film by dry etching while using the inorganic hard mask middle layer film having the transferred pattern as a mask; and
   (III-9) forming the pattern in the substrate to be processed by etching the substrate to be processed while using the resist underlayer film having the formed pattern as a mask.

As described, the inventive material for forming an adhesive film can be used suitably for various patterning processes such as a 2-layer resist process or a 4-layer resist process in which the adhesive film is formed on the silicon-containing middle layer film (silicon-containing resist middle layer film, inorganic hard mask middle layer film). According to these patterning processes, pattern collapse can be relieved effectively by the formation of the adhesive film, and these patterning processes are suitable for photolithography of a resist upper layer film.

In this case, the inorganic hard mask middle layer film is preferably formed by a CVD method or an ALD method.

Furthermore, in the present invention, photolithography at a wavelength of 10 nm or more to 300 nm or less, a direct drawing by electron beam, a nanoimprinting, or a combination thereof is preferably employed as a method for forming the pattern in the resist upper layer film.

Furthermore, in the inventive patterning processes, the material for forming an adhesive film is preferably applied to have a thickness of 2 nm or more and 50 nm or less in the step of forming the adhesive film.

According to such a patterning process, it is possible to remove the formed adhesive film by etching performed for a short time, and a thinner film can be selected as an upper layer resist.

The inventive patterning process will be described with the following 4-layer resist process as an example, but is not limited to this process. Firstly, the present invention provides a patterning process for forming a pattern in a substrate to be processed, including at least the following steps:
forming a resist underlayer film by using an organic film material on a substrate to be processed;
forming a silicon-containing middle layer film (silicon-containing resist middle layer film) by using a resist middle layer film material containing a silicon atom on the resist underlayer film;
forming an adhesive film by using the inventive material for forming an adhesive film on the silicon-containing resist middle layer film;
forming a resist upper layer film by using a resist upper layer film material including a photoresist composition on the adhesive film so that a multilayer resist film is constructed;
forming a resist upper layer film pattern in the resist upper layer film by exposing a pattern circuit region of the resist upper layer film, and then developing with a developer;
forming an adhesive film pattern by etching the adhesive film while using the obtained resist upper layer film pattern as an etching mask;
forming a silicon-containing resist middle layer film pattern by etching the silicon-containing resist middle layer film while using the obtained adhesive film pattern as an etching mask;
forming a resist underlayer film pattern by etching the resist underlayer film while using the obtained silicon-containing resist middle layer film pattern as an etching mask; and
further forming the pattern in the substrate to be processed by etching the substrate to be processed while using the obtained resist underlayer film pattern as an etching mask.

As the silicon-containing resist middle layer film in the 4-layer resist process, a polysilsesquioxane-based middle layer film is also favorably used. The silicon-containing resist middle layer film having an antireflective effect can suppress the reflection. Particularly, for 193-nm light exposure, a material containing many aromatic groups and having high substrate etching resistance is used as a resist underlayer film, so that the k-value and thus the substrate reflection are increased. However, the reflection can be suppressed by the silicon-containing resist middle layer film, and so the substrate reflection can be reduced to 0.5% or less. As the silicon-containing resist middle layer film having the antireflective effect, a polysilsesquioxane is preferably used, the polysilsesquioxane having anthracene for 248-nm and 157-nm light exposure, or a phenyl group or a light-absorbing group having a silicon-silicon bond for 193-nm light exposure in a pendant structure, and being crosslinked by an acid or heat.

In this case, forming a silicon-containing resist middle layer film by a spin-coating method is simpler and more advantageous regarding cost than a CVD method.

Alternatively, an inorganic hard mask middle layer film may be formed as the silicon-containing middle layer film, and in this case, it is possible to perform at least the following steps:
forming a resist underlayer film by using an organic film material on the substrate to be processed;
forming an inorganic hard mask middle layer film selected from a silicon oxide film, a silicon nitride film, and a silicon oxynitride film on the resist underlayer film;
forming an adhesive film by using the inventive material for forming an adhesive film on the inorganic hard mask middle layer film;
forming a resist upper layer film by using a resist upper layer film material including a photoresist composition on the adhesive film;
forming a resist upper layer film pattern in the resist upper layer film by exposing a pattern circuit region of the resist upper layer film, and then developing with a developer;
forming an adhesive film pattern by etching the adhesive film while using the obtained resist upper layer film pattern as an etching mask;
forming an inorganic hard mask middle layer film pattern by etching the inorganic hard mask middle layer film while using the obtained adhesive film pattern as an etching mask;
forming a resist underlayer film pattern by etching the resist underlayer film while using the obtained inorganic hard mask middle layer film pattern as an etching mask; and
further forming the pattern in the substrate to be processed by etching the substrate to be processed while using the obtained resist underlayer film pattern as an etching mask.

In the case where an inorganic hard mask middle layer film is formed on the resist underlayer film as described above, a silicon oxide film, a silicon nitride film, and a silicon oxynitride film (SiON film) can be formed by a CVD method, an ALD method, or the like. The method for forming the silicon nitride film is disclosed in, for example, JP 2002-334869 A and WO 2004/066377 A1. The film thickness of the inorganic hard mask middle layer film is preferably 5 to 200 nm, more preferably 10 to 100 nm. As the inorganic hard mask middle layer film, a SiON film is most preferably used, being effective as an antireflective coating. When the SiON film is formed, the substrate temperature reaches 300 to 500°C. Hence, the resist underlayer film needs to withstand the temperature of 300 to 500°C.

The resist upper layer film in the 4-layer resist process may be a positive type or a negative type, and any generally-used photoresist composition can be employed, but the resist upper layer film is preferably a negative type.

In the present invention, the material for forming an adhesive film can be a material for forming an adhesive film for a negative resist film, where the structural unit containing an acid-dissociable group is represented by the general formula (2) or (3). Alternatively, the material for forming an adhesive film can be a material for forming an adhesive film for a positive resist film, where the structural unit containing an acid-dissociable group is represented by the general formula (4).

In the present invention, it is possible to provide both a material for forming an adhesive film for a negative resist film and a material for forming an adhesive film for a positive resist film by selecting an appropriate structural unit containing an acid-dissociable group in the above-described material for forming an adhesive film.

Firstly, a case where an adhesive film for a negative resist film is formed by using a material for forming an adhesive film containing, as the component (A), a resin having a structure represented by the general formula (2) or (3) will be described.

In this case, when the adhesive film and the resist upper layer film formed directly thereon are exposed to light, R⁴ or R⁹, which are acid-dissociable groups, are eliminated due to the acid from the acid generator, and hydroxyl groups and carboxyl groups, which are polar groups, are generated. Due to the function of these polar groups, the adhesiveness between the adhesive film and the resist upper layer film becomes excellent. On the other hand, in unexposed portions, the hydroxyl groups and carboxyl groups, which are polar groups, are still protected by acid-dissociable groups, and therefore, the resist upper layer film can be peeled easily from the adhesive film. Thus, the generation of scum can be suppressed.

Secondly, a case where an adhesive film for a positive resist film is formed by using a material for forming an adhesive film containing, as the component (A), a resin having a structure represented by the general formula (4) will be described.

In this case, when the adhesive film and the resist upper layer film formed directly thereon are exposed to light, (OR¹⁴) groups, which behave as acid-dissociable groups, are eliminated as HOR¹⁴ by the function of the acid from the acid generator, and via carbocations, carbon-carbon double bonds are generated, and these undergo crosslinking. For this reason, exposed portions become non-polar, and the generation of scum can be suppressed by the elimination of (OR¹⁴) groups. Thus, development can be performed favorably. On the other hand, in unexposed portions, (OR¹⁴) groups, which are polar groups, remain, and therefore, adhesiveness can be maintained.

In the present invention, the fact that the polarities at the surface of the adhesive film are reverse in exposed portions and unexposed portions as explained above is ingeniously used to realize both the improvement of the adhesiveness of the resist and the reduction of scum in space portions at the same time.

Furthermore, the resist upper layer film is preferably formed from a composition containing at least an organic metal compound and a solvent. The organic metal compound more preferably contains at least one selected from titanium, cobalt, copper, zinc, zirconium, lead, indium, tin, antimony, and hafnium.

After spin-coating of the photoresist composition, pre-baking is preferably performed at 60 to 180°C for 10 to 300 seconds. Then, light exposure, post-exposure baking (PEB), and development are performed according to conventional methods to obtain the resist upper layer film pattern. Note that the thickness of the resist upper layer film is not particularly limited, but is preferably 30 to 500 nm, and particularly preferably 50 to 400 nm.

A circuit pattern (resist upper layer film pattern) is formed in the resist upper layer film. In the circuit pattern formation, the circuit pattern is preferably formed by a lithography using light having a wavelength of 10 nm or more to 300 nm or less, a direct drawing by electron beam, a nanoimprinting, or a combination thereof.

Note that examples of exposure light include a high-energy beam with a wavelength of 300 nm or less, specifically, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray of 3 to 20 nm (EUV), electron beam (EB), ion beam, X-ray, and the like.

Additionally, in the formation of the circuit pattern, the circuit pattern is preferably developed by alkaline development or an organic solvent.

Next, etching is performed while using the obtained resist upper layer film pattern as a mask. The etching of the adhesive film in the 4-layer resist process is performed by using an oxygen-based gas while using the resist upper layer film pattern as a mask. Thereby, the adhesive film pattern is formed.

Subsequently, etching is performed while using the obtained adhesive film pattern as a mask. The etching of the silicon-containing resist middle layer film and the inorganic hard mask middle layer film is performed by using a fluorocarbon-based gas while using the adhesive film pattern as a mask. Thereby, the silicon-containing resist middle layer film pattern and the inorganic hard mask middle layer film pattern are formed.

The etching of the adhesive film may be performed continuously before the etching of the silicon-containing middle layer film. Alternatively, after the adhesive film is etched alone, the etching apparatus is changed, for example, and then the etching of the silicon-containing middle layer film may be performed.

Next, the resist underlayer film is etched while using the obtained silicon-containing resist middle layer film pattern and inorganic hard mask middle layer film pattern as masks.

Subsequently, the substrate to be processed can be etched according to a conventional method. For example, the substrate to be processed made of SiO₂, SiN, or silica-based low-dielectric insulating film is etched mainly with a fluorocarbon-based gas; and p-Si, Al, or W is etched mainly with a chlorine- or bromine-based gas. When the substrate is processed by etching with a fluorocarbon-based gas, the silicon-containing middle layer film pattern in the 3-layer resist process is removed when the substrate is processed. When the substrate is etched with a chlorine- or bromine-based gas, the silicon-containing middle layer film pattern needs to be removed by additional dry etching with a fluorocarbon-based gas after the substrate processing.

Note that the substrate to be processed is not particularly limited, and it is possible to use a semiconductor device substrate or the semiconductor device substrate coated with any of a metal film, a metal carbide film, a metal oxide film, a metal nitride film, a metal oxycarbide film, or a metal oxynitride film. As the metal, it is possible to use silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

Specific examples include: substrates made of Si, α-Si, p-Si, SiO₂, SiN, SiON, W, TiN, Al, or the like; the substrate coated with a layer to be processed; etc. Examples of the layer to be processed include: various Low-k films made of Si, SiO₂, SiON, SiN, p-Si, α-Si, W, W-Si, Al, Cu, Al-Si, or the like; and stopper films thereof. Generally, the layer can be formed to have a thickness of 50 to 10,000 nm, in particular, 100 to 5,000 nm. Note that when the layer to be processed is formed, the substrate and the layer to be processed are formed from different materials.

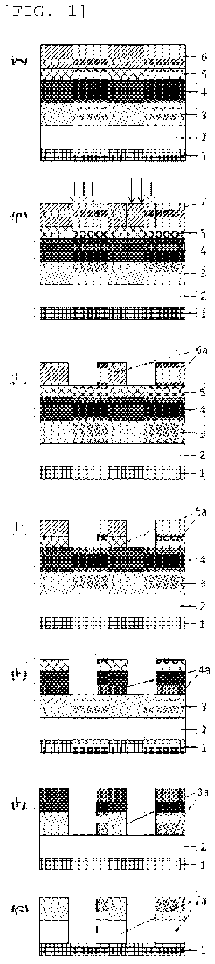

Hereinbelow, an example of the 4-layer resist process will be specifically described with reference to FIG. 1. As shown in FIG. 1 (A), in the 4-layer resist process, a resist underlayer film 3 is formed by using an organic film material on a layer 2 to be processed that has been stacked on a substrate 1. Then, a silicon-containing middle layer film 4 is formed, an adhesive film 5 is formed by using the inventive material for forming an adhesive film thereon, and a resist upper layer film 6 is formed thereon.

Next, as shown in FIG. 1 (B), a required portion 7 of the resist upper layer film is exposed to light, followed by PEB and development to form a resist pattern 6a (FIG. 1 (C)). While using the obtained resist pattern 6a as a mask, the adhesive film 5 is etched by using an O₂-based gas. Thereby, an adhesive film pattern 5a is formed (FIG. 1 (D)). While using the obtained adhesive film pattern 5a as a mask, the silicon-containing middle layer film 4 is etched by using a CF-based gas. Thereby, a silicon-containing middle layer film pattern 4a is formed (FIG. 1 (E)). After the adhesive film pattern 5a is removed, the resist underlayer film 3 is etched with an O₂-based gas while using the obtained silicon-containing middle layer film pattern 4a as a mask. Thereby, a resist underlayer film pattern 3a is formed (FIG. 1 (F)). Furthermore, after the silicon-containing middle layer film pattern 4a is removed, the layer 2 to be processed is etched while using the resist underlayer film pattern 3a as a mask. Thus, a pattern 2a is formed (FIG. 1 (G)).

As described above, the inventive patterning processes make it possible to form a fine pattern with high precision in a substrate to be processed in the multilayer resist processes.

### EXAMPLES

Hereinafter, the present invention will be described further specifically with reference to Synthesis Examples, Comparative Synthesis Examples, Examples, and Comparative Examples. However, the present invention is not limited thereto. Note that the molecular weight was measured by gel permeation chromatography (GPC) using tetrahydrofuran (THF) or N,N-dimethylformamide (DMF) as an eluent, the weight-average molecular weight (Mw) and the number-average molecular weight (Mn) were determined in terms of polystyrene, and dispersity (Mw/Mn) was calculated therefrom.

Polymers (A1) to (A16) and comparative polymers (R1) to (R5) to be used as a resin (A) for materials for forming an adhesive film were synthesized using the monomers (B1) to (B21) shown below.

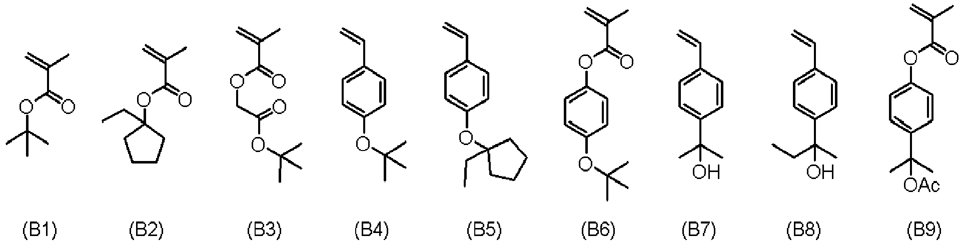

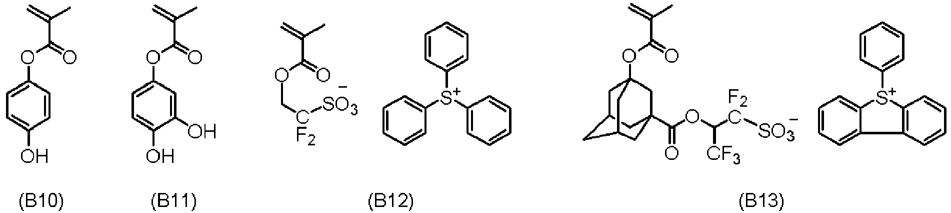

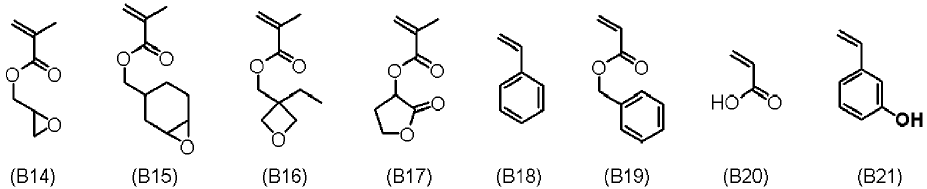

### [Synthesis Example 1] Synthesis of Polymer (A1)

Under a nitrogen atmosphere, 4.31 g of the monomer (B1), 43.1 g of the monomer (B14), 55.3 g of the monomer (B15), 2.35 g of V-601 (Dimethyl 2,2'-Azobis(isobutyrate), available from Wako Pure Chemical Industries Ltd.), and 340 g of PGMEA (propylene glycol monomethyl ether acetate) were measured and charged into a 1-L measuring cylinder. Subsequently, degassing was performed while stirring the mixture to prepare a monomer-polymerization initiator solution. 60 g of PGMEA was measured and charged into a different 1-L flask having a nitrogen atmosphere. After degassing while stirring, the resultant was heated until the inner temperature reached 80°C. The monomer-polymerization initiator solution was added thereto dropwise over 4 hours. Subsequently, the polymer solution was stirred for 16 hours while maintaining the temperature at 80°C, and then was cooled to room temperature. The obtained polymer solution was added dropwise to 5,000 g of vigorously stirred diisopropyl ether (DIPE), and the deposited polymer was collected by filtration. Furthermore, the obtained polymer was washed twice with 600 g of DIPE. After that, the polymer was vacuum dried at 50°C for 20 hours to obtain a polymer (A1) in white powder form (yield: 99.5 g, 97%). When the weight-average molecular weight (Mw) and dispersity (Mw/Mn) of the polymer (A1) were measured by GPC, the results were: Mw = 14,730, Mw/Mn = 2.01.

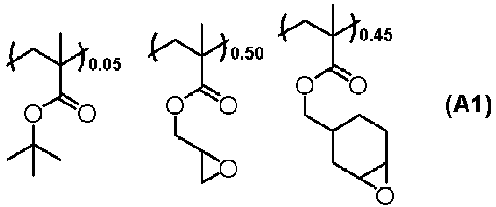

### [Synthesis Examples 2 to 16] Synthesis of Polymers (A2) to (A16)

Except that the monomers, polymerization initiators, and solvents shown in Table 1 were used, reaction and post-processing were performed under the same conditions as in Synthesis Example 1 to obtain polymers (A2) to (A16) as products. In addition, the weight-average molecular weight (Mw) and dispersity (Mw/Mn) determined by GPC are shown.

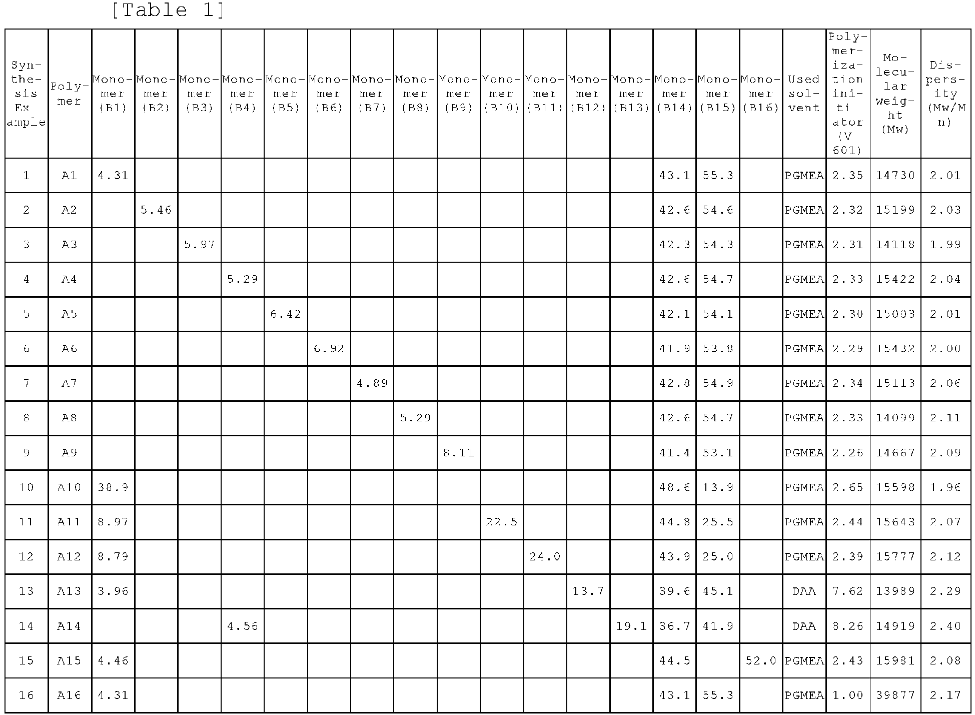

### [Comparative Synthesis Example 1] Synthesis of Comparative Polymer (R1)

38.9 g of propylene glycol monomethyl ether acetate (hereinafter, referred to as "PGMEA") was heated and stirred under a nitrogen atmosphere at 80°C. A mixture of 29.7 g of glycidyl methacrylate, 8.9 g of tert-butyl acrylate, 11.3 g of benzyl acrylate, and 38.9 g of PGMEA, and a mixture of 4.0 g of dimethyl 2,2-azobis (2-methylpropionate) and 38.9 g of PGMEA were added thereto simultaneously but separately over the course of 4 hours. After further heating and stirring for 20 hours, the mixture was cooled to room temperature, thereby obtaining a target polymer compound (R1) dissolved in PGMEA. As a result of analysis, the polymer compound (R1) was found to have a weight-average molecular weight (Mw) of 12,000 and a dispersity (Mw/Mn) of 2.4.

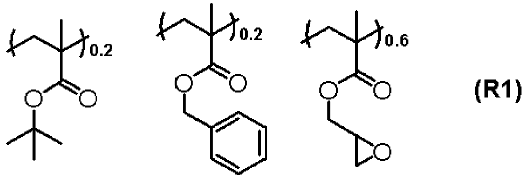

### [Comparative Synthesis Example 2] Synthesis of Comparative Polymer (R2)

Under a nitrogen atmosphere, 62.8 g of the monomer (B14), 37.2 g of the monomer (B15), 1.45 g of V-601, and 340 g of PGMEA were measured and charged into a 1-L flask. Subsequently, degassing was performed while stirring the mixture to prepare a monomer-polymerization initiator solution. 60 g of PGMEA was measured and charged into a different 1-L flask having a nitrogen atmosphere. After degassing while stirring, the resultant was heated until the inner temperature reached 80°C. The monomer-polymerization initiator solution was added thereto dropwise over 4 hours. Subsequently, the polymer solution was stirred for 16 hours while maintaining the temperature at 80°C, and then was cooled to room temperature. The obtained polymer solution was added dropwise to 1,500 g of vigorously stirred hexane, and the deposited polymer was collected by filtration. Furthermore, the obtained polymer was washed twice with 600 g of hexane. After that, the polymer was vacuum dried at 50°C for 20 hours to obtain a polymer (R2) in white powder form (yield: 97.5 g, 96%). When the weight-average molecular weight (Mw) and dispersity (Mw/Mn) of the polymer (R2) were measured by GPC, the results were: Mw = 33,500, Mw/Mn = 1.88.

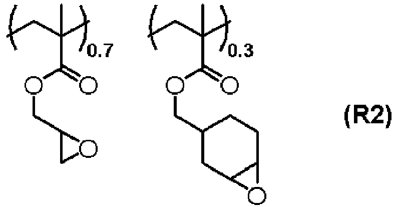

### [Comparative Synthesis Example 3] Synthesis of Comparative Polymer (R3)

Under a nitrogen atmosphere, 45.1 g of the monomer (B13), 34.8 g of the monomer (B14), 20.0 g of the monomer (B15), 4.70 g of V-601 (Dimethyl 2,2'-Azobis(isobutyrate), available from Wako Pure Chemical Industries Ltd.), 1.28 g of SEA (2-Mercaptoethanol, available from Tokyo Chemical Industry Co., Ltd.), and 340 g of DAA (diacetone alcohol) were measured and charged into a 1-L flask. Subsequently, degassing was performed while stirring the mixture to prepare a monomer-polymerization initiator solution. 60 g of DAA was measured and charged into a different 1-L flask having a nitrogen atmosphere. After degassing while stirring, the resultant was heated until the inner temperature reached 80°C. The monomer-polymerization initiator solution was added thereto dropwise over 4 hours. Subsequently, the polymer solution was stirred for 16 hours while maintaining the temperature at 80°C, and then was cooled to room temperature. The obtained polymer solution was added dropwise to 1,500 g of vigorously stirred hexane, and the deposited polymer was collected by filtration. Furthermore, the obtained polymer was washed twice with 600 g of hexane. After that, the polymer was vacuum dried at 50°C for 20 hours to obtain a polymer (R3) in white powder form (yield: 101.5 g, 96%). When the weight-average molecular weight (Mw) and dispersity (Mw/Mn) of the polymer (R3) were measured by GPC, the results were: Mw = 15,300, Mw/Mn = 1.98.

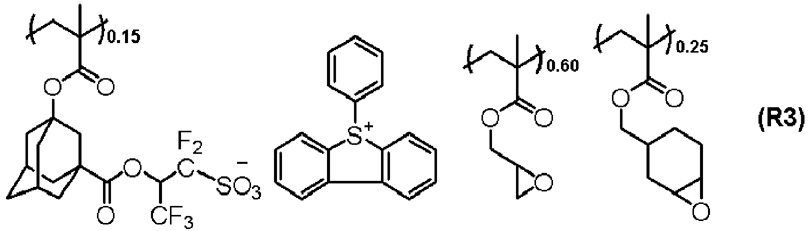

### [Comparative Synthesis Example 4] Synthesis of Comparative Polymer (R4)

Under a nitrogen atmosphere, 34 g of the monomer (B18), 66 g of the monomer (B20), and 25.1 g of V-601 were measured and charged into a 1-L flask. Subsequently, degassing was performed while stirring the mixture to prepare a monomer-polymerization initiator solution. 300 g of methyl isobutyl ketone was measured and charged into a different 1-L flask having a nitrogen atmosphere. After degassing while stirring, the resultant was heated until the inner temperature reached 80°C. The monomer-polymerization initiator solution was added thereto dropwise over 3 hours. Subsequently, the polymer solution was stirred for 6 hours while maintaining the temperature at 80°C, and then was cooled to room temperature. The obtained polymer solution was added dropwise to 1, 500 g of vigorously stirred hexane, and the deposited polymer was collected by filtration. Furthermore, the obtained polymer was washed twice with 600 g of hexane. After that, the polymer was vacuum dried at 50°C for 20 hours to obtain a polymer (R4) in white powder form (yield: 98.7 g, 97.2%). When the weight-average molecular weight (Mw) and dispersity (Mw/Mn) of the polymer (R4) were measured by GPC, the results were: Mw = 5800, Mw/Mn = 1.97.

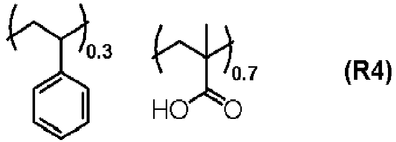

### [Comparative Synthesis Example 5] Synthesis of Comparative Polymer (R5)

Under a nitrogen atmosphere, 32.1 g of the monomer (B1), 49.9 g of the monomer (B13), 19.0 g of the monomer (B21), 15.4 g of V-601, and 340 g of DAA were measured and charged into a 1-L flask. Subsequently, degassing was performed while stirring the mixture to prepare a monomer-polymerization initiator solution. 60 g of DAA was measured and charged into a different 1-L flask having a nitrogen atmosphere. After degassing while stirring, the resultant was heated until the inner temperature reached 80°C. The monomer-polymerization initiator solution was added thereto dropwise over 4 hours. Subsequently, the polymer solution was stirred for 16 hours while maintaining the temperature at 80°C, and then was cooled to room temperature. The obtained polymer solution was added dropwise to 1,500 g of vigorously stirred hexane, and the deposited polymer was collected by filtration. Furthermore, the obtained polymer was washed twice with 600 g of hexane. After that, the polymer was vacuum dried at 50°C for 20 hours to obtain a polymer (R5) in white powder form (yield: 101.3 g, 94.5%). When the weight-average molecular weight (Mw) and dispersity (Mw/Mn) of the polymer (R5) were measured by GPC, the results were: Mw = 8,100, Mw/Mn = 2.11.

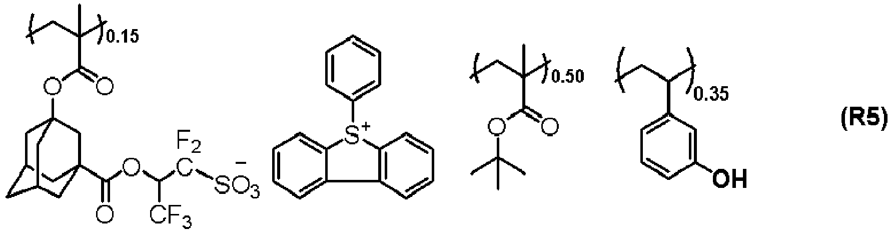

### Preparation of Materials (AL-1 to -27, Comparative AL-1 to -12) for Forming Adhesive Film

For the preparation of materials for forming an adhesive film and comparative materials, the following were used: the polymers (A1) to (A16) and the comparative polymers (R1) to (R5); (AG1) and (AG2) as thermal acid generators; (AG3) and (AG4) as photo-acid generators; and (X1) to (X3) as crosslinking agents. The compounds were dissolved in an organic solvent containing 0.1 mass% of PF636 (available from OMNOVA) in proportions shown in Table 2. The solution was then filtered through a 0.1-pm filter made of fluorinated resin to prepare materials (AL-1 to -27, comparative AL-1 to -12) for forming an adhesive film.

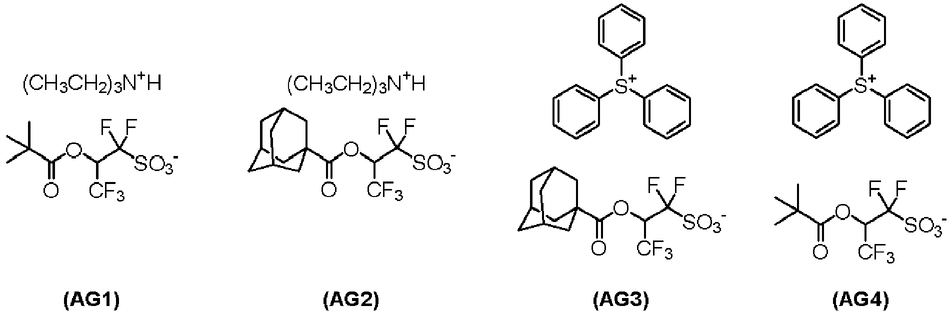

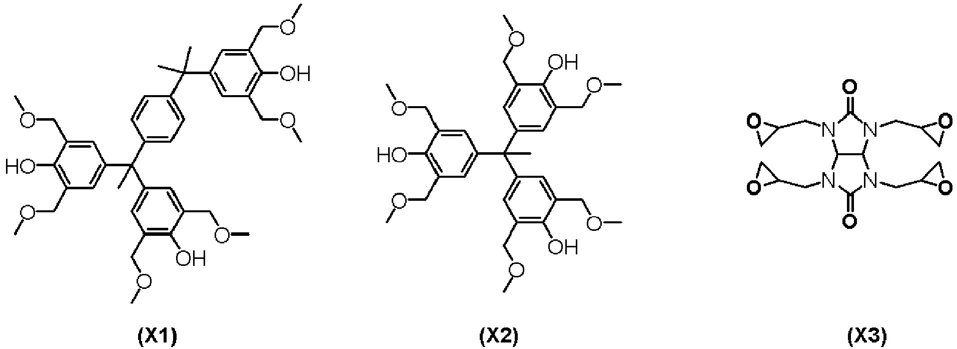

**[Table 2]**

| Material for forming adhesive film | Polymer (parts by mass) | Thermal acid generator (parts by mass) | Photo-acid generator (parts by mass) | Crosslinking agent (parts by mass) | Organic solvent (parts by mass) |
|---|---|---|---|---|---|
| AL-1 | A1 (10) | - | AG3 (0.5) | - | PGMEA (4400) |
| AL-2 | A2 (10) | - | AG3 (0.5) | - | PGMEA (4400) |
| AL-3 | A3 (10) | - | AG3 (0.5) | - | PGMEA (4400) |
| AL-4 | A4 (10) | - | AG3 (0.5) | - | PGMEA (4400) |
| AL-5 | A5 (10) | - | AG3 (0.5) | - | PGMEA (4400) |
| AL-6 | A6 (10) | - | AG3 (0.5) | - | PGMEA (4400) |
| AL-7 | A7 (10) | - | AG3 (0.5) | - | PGMEA (4400) |
| AL-8 | A8 (10) | - | AG3 (0.5) | - | PGMEA (4400) |
| AL-9 | A9 (10) | - | AG3 (0.5) | - | PGMEA (4400) |
| AL-10 | A10 (10) | - | AG3 (0.5) | - | PGMEA (4400) |
| AL-11 | A11 (10) | - | AG3 (0.5) | - | PGMEA (4400) |
| AL-12 | A12 (10) | - | AG3 (0.5) | - | PGMEA (4400) |
| AL-13 | A13 (10) | - | AG3 (0.5) | - | PGMEA (1760), DAA (440), EL (2200) |
| AL-14 | A14 (10) | - | AG3 (0.5) | - | PGMEA (1760), DAA (440), EL (2200) |
| AL-15 | A15 (10) | - | AG3 (0.5) | - | PGMEA (4400) |
| AL-16 | A16 (10) | - | AG3 (0.5) | - | PGMEA (4400) |
| AL-17 | A1 (10) | AG1 (0.05) | AG3 (0.5) | - | PGMEA (4400) |
| AL-18 | A1 (10) | AG2 (0.05) | AG3 (0.5) | - | PGMEA (4400) |
| AL-19 | A1 (10) | - | AG4 (0.5) | - | PGMEA (4400) |
| AL-20 | A1 (10) | - | AG3 (0.5) | X1 (2) | PGMEA (4400) |
| AL-21 | A1 (10) | - | AG3 (0.5) | X2 (2) | PGMEA (4400) |
| AL-22 | A1 (10) | - | AG3 (0.5) | X3 (2) | PGMEA (4400) |
| AL-23 | A1 (10) | - | AG3 (0.5) | - | PGMEA (1000) |
| AL-24 | A4 (10) | - | AG3 (0.5) | - | PGMEA (1000) |
| AL-25 | A7 (10) | - | AG3 (0.5) | - | PGMEA (1000) |
| AL-26 | A14 (10) | - | - | - | PGMEA (1760), DAA (440), EL (2200) |
| AL-27 | A14 (10) | AG1 (0.05) | - | - | PGMEA (1760), DAA (440), EL (2200) |
| Comparative AL-1 | A1 (10) | - | - | - | PGMEA (4400) |
| Comparative AL-2 | A4 (10) | - | - | - | PGMEA (4400) |
| Comparative AL-3 | A7 (10) | - | - | - | PGMEA (4400) |
| Comparative AL-4 | A1 (10) | AG1 (0.05) | - | - | PGMEA (4400) |
| Comparative AL-5 | A4 (10) | AG1 (0.05) | - | - | PGMEA (4400) |
| Comparative AL-6 | A7 (10) | AG1 (0.05) | - | - | PGMEA (4400) |
| Comparative AL-7 | R1 (10) | AG1 (0.1) | - | - | PGMEA (3080), PGME (1320) |
| Comparative AL-8 | R1 (10) | - | AG3 (0.5) | - | PGMEA (3080), PGME (1320) |
| Comparative AL-9 | R2 (10) | - | AG3 (0.5) | - | PGMEA (4400) |
| Comparative AL-10 | R3 (10) | AG1 (0.05) | - | - | PGMEA (1760), DAA (440), EL (2200) |
| Comparative AL-11 | R4/R5 (5/5) | - | AG3 (0.5) | X3 (3) | PGMEA (4400) |
| Comparative AL-12 | R2 (10) | - | AG3 (0.5) | - | PGMEA (1000) |

The compositions in Table 2 are respectively as follows.
Organic solvent: PGMEA (propylene glycol monomethyl ether acetate)
DAA (diacetone alcohol)
EL (ethyl lactate)
PGME (propylene glycol monomethyl ether)

### Example 1: Adhesiveness Test (Examples 1-1 to 1-27, Comparative Examples 1-1 to 1-12)

The materials (AL-1 to -27, comparative AL-1 to -12) for forming an adhesive film were respectively applied onto an SiO₂ wafer substrate and baked at 215°C for 60 seconds in the atmosphere by using a hot plate. Thus, an adhesive film with a film thickness of 5 nm (AL-1 to -19, comparative AL-1 to -11) or 20 nm (AL-20 to -27, comparative AL-12) was formed. Next, (1) a set of coated wafer substrates was subjected to open-frame exposure over the entire wafer with a dosage of 25 mJ by using the KrF exposure apparatus (NSR-206D, manufactured by Nikon Corporation; NA: 0.82), and was heat-treated at 150°C for 60 seconds; and (2) the other set of substrates was subjected to only the heat-treatment at 150°C for 60 seconds without performing the exposure. Each of the wafers obtained as a result of (1) and (2) was cut into a 1 cm × 1 cm square, and an aluminum pin with epoxy adhesive was fastened to the cut wafer with a dedicated jig. Thereafter, the assembly was heated with an oven at 150°C for 1 hour to bond the aluminum pin to the substrate. After cooling to room temperature, initial adhesiveness was evaluated based on the resistance force by a thin-film adhesion strength measurement apparatus (Sebastian Five-A).

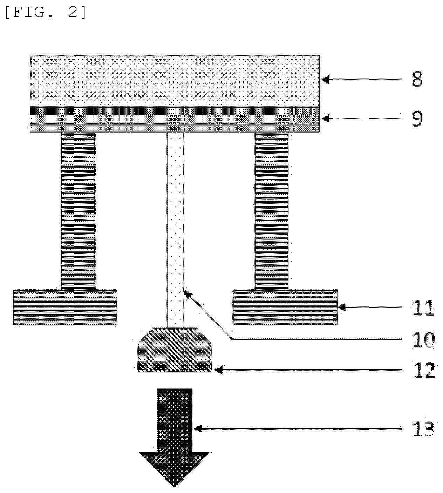

FIG. 2 shows an explanatory diagram indicating an adhesiveness measurement method. In FIG. 2, reference number 8 denotes a silicon wafer (substrate), 9 denotes a cured film, 10 denotes an aluminum pin with adhesive, 11 denotes a support, 12 denotes a grip, and 13 denotes a tensile direction. The adhesion is an average of 12 measurement points, and a larger value indicates that the adhesive film has higher adhesiveness with respect to the substrate. The adhesiveness was evaluated by comparing the obtained values. Table 3 shows the results.

**[Table 3]**

| | Material for forming adhesive film | Adhesion of exposed wafer (mN) | Adhesion of unexposed wafer (mN) |
|---|---|---|---|
| Example 1-1 | AL-1 | 540 | 350 |
| Example 1-2 | AL-2 | 530 | 340 |
| Example 1-3 | AL-3 | 560 | 370 |
| Example 1-4 | AL-4 | 510 | 330 |
| Example 1-5 | AL-5 | 500 | 320 |
| Example 1-6 | AL-6 | 510 | 350 |
| Example 1-7 | AL-7 | 310 | 510 |
| Example 1-8 | AL-8 | 300 | 490 |
| Example 1-9 | AL-9 | 320 | 440 |
| Example 1-10 | AL-10 | 500 | 290 |
| Example 1-11 | AL-11 | 530 | 420 |
| Example 1-12 | AL-12 | 560 | 410 |
| Example 1-13 | AL-13 | 550 | 390 |
| Example 1-14 | AL-14 | 540 | 420 |
| Example 1-15 | AL-15 | 530 | 370 |
| Example 1-16 | AL-16 | 530 | 330 |
| Example 1-17 | AL-17 | 540 | 440 |
| Example 1-18 | AL-18 | 520 | 430 |
| Example 1-19 | AL-19 | 530 | 340 |
| Example 1-20 | AL-20 | 530 | 360 |
| Example 1-21 | AL-21 | 510 | 320 |
| Example 1-22 | AL-22 | 510 | 350 |
| Example 1-23 | AL-23 | 530 | 330 |
| Example 1-24 | AL-24 | 500 | 360 |
| Example 1-25 | AL-25 | 320 | 490 |
| Example 1-26 | AL-26 | 500 | 330 |
| Example 1-27 | AL-27 | 510 | 400 |
| Comparative Example 1-1 | Comparative AL-1 | 340 | 340 |
| Comparative Example 1-2 | Comparative AL-2 | 340 | 320 |
| Comparative Example 1-3 | Comparative AL-3 | 490 | 500 |
| Comparative Example 1-4 | Comparative AL-4 | 490 | 480 |
| Comparative Example 1-5 | Comparative AL-5 | 470 | 490 |
| Comparative Example 1-6 | Comparative AL-6 | 410 | 400 |
| Comparative Example 1-7 | Comparative AL-7 | 450 | 480 |
| Comparative Example 1-8 | Comparative AL-8 | 460 | 280 |
| Comparative Example 1-9 | Comparative AL-9 | 430 | 440 |
| Comparative Example 1-10 | Comparative AL-10 | 560 | 550 |
| Comparative Example 1-11 | Comparative AL-11 | 470 | 390 |
| Comparative Example 1-12 | Comparative AL-12 | 560 | 580 |

As shown in Table 3, it was observed in Examples 1-1 to 1-27, where the inventive materials (AL-1 to -27) for forming an adhesive film were used, that adhesion changed greatly by whether or not exposure was performed. In particular, in Examples 1-1 to 1-6, 1-10 to 1-24, 1-26, and 1-27, where a polymer including a structural unit represented by the general formula (2) or (3) was used, the adhesion tended to increase when exposure was performed, and the materials can be expected to achieve excellent results when a negative resist is used. Meanwhile, in Examples 1-7 to 1-9 and 1-25, where a polymer including a structural unit represented by the general formula (4) was used, the adhesion increased when exposure was not performed, and using the materials in combination with a positive resist can be expected to have excellent results. On the other hand, in Comparative Examples 1-1 to 1-7, where no photo-acid generator was contained, and in Comparative Examples 1-9 to 1-12, where a polymer containing no structural units represented by the general formulae (2) to (4) was used, there was little change in the adhesion caused by whether or not exposure was performed, and this suggests that either the ability to prevent pattern collapse or the ability to prevent scum in space portions is poor. Meanwhile, in Comparative Example 1-8, where only one kind of structural unit represented by the general formula (1) was contained, the adhesion changed greatly depending on whether or not exposure was performed, but the adhesion in the exposed portion, where the adhesion had increased, was low compared to the Examples of the present invention. This suggests that adhesiveness to a resist film is also poor.

### Example 2: Patterning Test by ArF Immersion Exposure using Positive Resist (Examples 2-1 to 2-4, Comparative Examples 2-1 to 2-6)

Spin-on carbon ODL-301 (carbon content: 88 mass%) available from Shin-Etsu Chemical Co., Ltd. was applied to silicon wafer substrates and the resulting substrates were baked at 350°C for 60 seconds to form a 200-nm thick resist underlayer film. A CVD-SiON hard mask middle layer film was formed thereon, and furthermore, each of the materials (AL-7 to -9, -25, comparative AL-3, comparative AL-6 to -7, comparative AL-9, comparative AL-11 to -12) for forming an adhesive film was respectively applied and baked at 215°C for 60 seconds to form a 5-nm thick (AL-7 to -9, comparative AL-3, comparative AL-6 to -7, comparative AL-9, comparative AL-11) or 20-nm thick (AL-25, comparative AL-12) adhesive film. A monolayer resist for ArF of a positive resist upper layer film material shown in Table 4 was applied thereon and baked at 105°C for 60 seconds to form a resist upper layer film having a film thickness of 100 nm. A liquid immersion top coat material (TC-1) was applied on the resist upper layer film and baked at 90°C for 60 seconds to form a top coat having a film thickness of 50 nm.

The positive resist upper layer film material (monolayer resist for ArF) was prepared by: dissolving a polymer (PRP-A1), an acid generator (PAG1), and a basic compound (Amine1) into a solvent containing 0.1 mass% of FC-4430 (available from Sumitomo 3M Ltd.) in proportions shown in Table 4; and filtering the solution through a 0.1-µm filter made of a fluorinated resin.

**[Table 4]**

| | Polymer (parts by mass) | Acid generator (parts by mass) | Basic compound (parts by mass) | Solvent (parts by mass) |
|---|---|---|---|---|
| SL resist for ArF | PRP-A1 (100) | PAG1 (6.6) | Amine1 (0.8) | PGMEA (2500) |

Polymer for resist: PRP-A1
Molecular weight (Mw) = 8,600
Dispersity (Mw/Mn) = 1.88

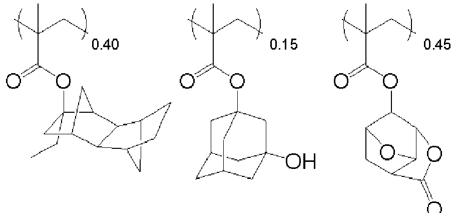

Acid generator: PAG1

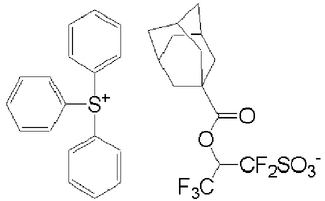

Basic compound: Amine1

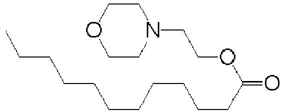

The liquid immersion top coat material (TC-1) was prepared by: dissolving a top coat polymer (PP1) into organic solvents in proportions shown in Table 5; and filtering the solution through a 0.1-pm filter made of a fluorinated resin.

**[Table 5]**

| | Polymer (parts by mass) | Organic solvent (parts by mass) |
|---|---|---|
| TC-1 | PP1 (100) | Diisoamyl ether (2700) |
| | | 2-methyl-1-butanol (270) |

Top coat polymer: PP1
Molecular weight (Mw) = 8,800
Dispersity (Mw/Mn) = 1.69

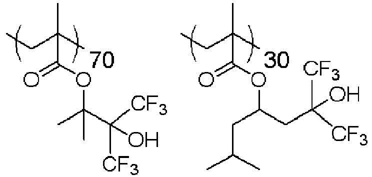

Next, the resulting substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked (PEB) at 100°C for 60 seconds, and developed with a 2.38 mass% aqueous solution of tetramethylammonium hydroxide (TMAH) for 30 seconds. Thus, a 40-nm 1:1 line-and-space pattern was obtained. Regarding this pattern, the sectional profile and roughness were observed with an electron microscope. The collapse limit (nm) was a minimum width of the lines which could be resolved without collapse when the line width was reduced by increasing the exposure dose. A smaller value indicates higher and better collapse resistance.

The cross-sectional profile of the obtained pattern was evaluated with an electron microscope (S-4700) manufactured by Hitachi, Ltd. and the pattern roughness was evaluated with an electron microscope (CG4000) manufactured by Hitachi High-Technologies Corp. Table 6 shows the results.

**[Table 6]**

| | Material for forming adhesive film | Pattern sectional profile after development | Pattern roughness (nm) | Collapse limit (nm) |
|---|---|---|---|---|
| Example 2-1 | AL-7 | Vertical profile | 1.9 | 34 |
| Example 2-2 | AL-8 | Vertical profile | 1.7 | 33 |
| Example 2-3 | AL-9 | Vertical profile | 1.8 | 35 |
| Example 2-4 | AL-25 | Vertical profile | 1.7 | 34 |
| Comparative Example 2-1 | Comparative AL-3 | Trailing profile | 2.3 | 35 |
| Comparative Example 2-2 | Comparative AL-6 | Vertical profile | 2.2 | 39 |
| Comparative Example 2-3 | Comparative AL-7 | Trailing profile | 2.1 | 37 |
| Comparative Example 2-4 | Comparative AL-9 | Trailing profile | 2.5 | 36 |
| Comparative Example 2-5 | Comparative AL-11 | Vertical profile | 2.4 | 38 |
| Comparative Example 2-6 | Comparative AL-12 | Trailing profile | 2.4 | 37 |

As shown in Table 6, it can be observed that in Examples 2-1 to 2-4, where the inventive materials (AL-7 to -9, AL-25) for forming an adhesive film were used, excellent collapse suppression performance was exhibited, and at the same time, the pattern profile was also a vertical profile. On the other hand, in Comparative Example 2-1 and Comparative Example 2-2, where no photo-acid generator was contained, it can be observed that no difference occurred between the amounts of polar groups in the exposed portions and the unexposed portions, and that therefore, either adhesiveness or pattern profile was degraded. Meanwhile, in Comparative Example 2-3, Comparative Example 2-4, and Comparative Example 2-6, where no acid-dissociable groups were contained, the pattern profile was a trailing profile, and adhesiveness was somewhat degraded compared to the Examples. Meanwhile, in Comparative Example 2-5, where a composition proposed in Patent Document 6 was used, pattern profile was good, but adhesiveness was degraded.

### Example 3: Patterning Test by ArF Immersion Exposure using Negative Resist (Examples 3-1 to 3-22, Comparative Examples 3-1 to 3-9)

In the same manner as in the patterning test where a positive resist was used, an organic underlayer film and a CVD-SiON hard mask middle layer film were formed on silicon wafers, and an adhesive film was further formed thereon. A monolayer resist for ArF of a negative resist upper layer film material shown in Table 7 was applied thereon and baked at 100°C for 60 seconds to form a photoresist layer having a film thickness of 100 nm. A liquid immersion top coat material (TC-1) was applied on the photoresist film and baked at 90°C for 60 seconds to form a top coat having a film thickness of 50 nm.

The negative resist upper layer film material was prepared by: dissolving the polymer (PRP-A1), an acid generator (PAG1), and a basic compound (Amine1) into a solvent containing 0.1 mass% FC-4430 (available from Sumitomo 3M Ltd.) in proportions shown in Table 7; and filtering the solution through a 0.1-pm filter made of a fluorinated resin.

**[Table 7]**

| | Polymer (parts by mass) | Acid generator (parts by mass) | Basic compound (parts by mass) | Solvent (parts by mass) |
|---|---|---|---|---|
| Negative resist composition | PRP-A1 (100) | PAG1 (7.0) | Amine1 (1.0) | PGMEA (2500) |

Next, the resulting substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask) and baked (PEB) at 100°C for 60 seconds. With a rotation of 30 rpm, a developer of butyl acetate was discharged from a developer nozzle for 3 seconds. Then the rotation was stopped to perform puddle-development for 27 seconds, spin-drying was performed after rinsing with diisoamyl ether, and baking was performed at 100°C for 20 seconds to evaporate the rinse solvent. A negative line-and-space pattern of 43 nm was obtained by this patterning. Regarding this pattern, the sectional profile was observed with an electron microscope. The collapse limit (nm) was a minimum width of the lines which could be resolved without collapse when the line width was reduced by decreasing the exposure dose. A smaller value indicates higher and better collapse resistance.

The cross-sectional profile of the obtained pattern was evaluated with an electron microscope (S-4700) manufactured by Hitachi, Ltd. and the pattern collapse after development was evaluated with an electron microscope (CG4000) manufactured by Hitachi High-Technologies Corp. Table 8 shows the results.

**[Table 8]**

| | Material for forming adhesive film | Pattern sectional profile after development | Collapse limit (nm) |
|---|---|---|---|
| Example 3-1 | AL-1 | Vertical profile | 30 |
| Example 3-2 | AL-2 | Vertical profile | 28 |
| Example 3-3 | AL-3 | Vertical profile | 32 |
| Example 3-4 | AL-4 | Vertical profile | 32 |
| Example 3-5 | AL-5 | Vertical profile | 31 |
| Example 3-6 | AL-6 | Vertical profile | 32 |
| Example 3-7 | AL-10 | Vertical profile | 29 |
| Example 3-8 | AL-11 | Vertical profile | 30 |
| Example 3-9 | AL-12 | Vertical profile | 28 |
| Example 3-10 | AL-13 | Vertical profile | 28 |
| Example 3-11 | AL-14 | Vertical profile | 29 |
| Example 3-12 | AL-15 | Vertical profile | 28 |
| Example 3-13 | AL-16 | Vertical profile | 30 |
| Example 3-14 | AL-17 | Vertical profile | 31 |
| Example 3-15 | AL-18 | Vertical profile | 29 |
| Example 3-16 | AL-19 | Vertical profile | 31 |
| Example 3-17 | AL-20 | Vertical profile | 32 |
| Example 3-18 | AL-21 | Vertical profile | 31 |
| Example 3-19 | AL-22 | Vertical profile | 31 |
| Example 3-20 | AL-23 | Vertical profile | 29 |
| Example 3-21 | AL-24 | Vertical profile | 30 |
| Example 3-22 | AL-26 | Vertical profile | 30 |
| Comparative Example 3-1 | Comparative AL-1 | Vertical profile | 36 |
| Comparative Example 3-2 | Comparative AL-2 | Vertical profile | 37 |
| Comparative Example 3-3 | Comparative AL-4 | Trailing profile | 34 |
| Comparative Example 3-4 | Comparative AL-5 | Trailing profile | 33 |
| Comparative Example 3-5 | Comparative AL-7 | Vertical profile | 34 |
| Comparative Example 3-6 | Comparative AL-8 | Vertical profile | 35 |
| Comparative Example 3-7 | Comparative AL-9 | Trailing profile | 33 |
| Comparative Example 3-8 | Comparative AL-11 | Vertical profile | 35 |
| Comparative Example 3-9 | Comparative AL-12 | Trailing profile | 32 |

As shown in Table 8, it can be seen that in each of Examples 3-1 to 3-22, where the inventive materials (AL-1 to -6, AL-10 to -24, AL-26) for forming an adhesive film in the patterning test using a negative resist were used, excellent adhesiveness and pattern rectangularity were achieved. On the other hand, in Comparative Examples 3-1 to 3-5, where no photo-acid generator was contained, it can be observed that no difference occurred between the amounts of polar groups in the exposed portions and the unexposed portions, and that therefore, either adhesiveness or pattern profile was degraded. Meanwhile, in Comparative Example 3-6, where only one kind of the structural unit represented by the formula (1) was contained, and in Comparative Example 3-8, where a composition proposed in Patent Document 6 was used, the pattern was rectangular, but adhesiveness was somewhat degraded compared to the adhesive films of the present invention. Meanwhile, in Comparative Example 3-7 and Comparative Example 3-9, where no acid-dissociable groups were contained, adhesiveness was excellent, but the pattern had a trailing profile.

### Example 4: Electron Beam Patterning Test (Examples 4-1 and 4-2, Comparative Examples 4-1 to 4-6)

The materials (AL-1, AL-4, comparative AL-1, -4, -7, -8, -10, -11) for forming an adhesive film were respectively applied to silicon wafer substrates and baked at 215°C for 60 seconds to form a 5-nm thick adhesive film. A metal-containing resist of a resist upper layer film material was applied thereon and baked at 180°C for 60 seconds to form a 60-nm thick resist upper layer film.

The resist upper layer film material (metal-containing resist) was prepared by: dissolving a titanium-containing compound (AM-1) and a metal salt sensitizer (S-1) into 4-methyl-2-pentanol (MIBC) containing 0.1 mass% of FC-4430 (available from Sumitomo 3M Ltd.) in proportions shown in Table 9; and filtering the solution through a 0.1-pm filter made of a fluorinated resin.

**[Table 9]**

| | Titanium-containing compound (parts by mass) | Metal salt sensitizer (parts by mass) | Organic solvent (parts by mass) |
|---|---|---|---|
| Metal-containing resist composition | AM-1 (100) | S-1 (1) | MIBC (2000) |

### Synthesis of Titanium-Containing Compound (AM-1)

To a solution of 284 g of titanium tetraisopropoxide (available from Tokyo Chemical Industry Co., Ltd.) in 500 g of 2-propanol (IPA), a solution of 27 g of deionized water in 500 g of IPA was dropped in while stirring at room temperature over 2 hours. To the obtained solution, 180 g of 2,4-dimethyl-2,4-octanediol was added, and this was stirred at room temperature for 30 minutes. This solution was concentrated at 30°C under reduced pressure, then was further heated to 60°C, and kept heated under reduced pressure until a distillate was no longer obtained. When the distillate was no longer observed, 1,200 g of 4-methyl-2-pentanol (MIBC) was added, and this was heated at 40°C under reduced pressure until the IPA distillate was no longer obtained to afford 1,000 g (compound concentration: 25 mass%) of a solution of a titanium-containing compound AM-1 in MIBC. The molecular weight of the solution was measured in terms of polystyrene to find that Mw = 1,200.

Metal salt sensitizer: S-1

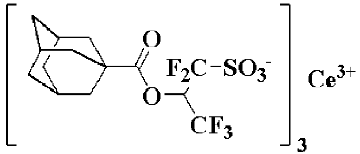

Next, drawing was performed in a vacuum chamber at an acceleration voltage of 50 kV by using JBX-9000MV (manufactured by JEOL Ltd.). Immediately after drawing, baking (PEB) was performed at 200°C for 60 seconds, puddle-development was performed with butyl acetate for 20 seconds to obtain a negative pattern.

The obtained resist patterns were evaluated as follows. The exposure dose to resolve a 100-nm line-and-space (LS) by 1:1 was defined as the sensitivity. The collapse limit (nm) was defined as a minimum width of the lines which could be resolved without collapse at the above exposure dose. A smaller value indicates higher and better collapse resistance. Table 10 shows the results.

**[Table 10]**

| | Material for forming adhesive film | Collapse limit (nm) | Pattern sectional profile after development |
|---|---|---|---|
| Example 4-1 | AL-1 | 42 | Vertical profile |
| Example 4-2 | AL-4 | 43 | Vertical profile |
| Comparative Example 4-1 | Comparative AL-1 | 65 | Vertical profile |
| Comparative Example 4-2 | Comparative AL-4 | 48 | Trailing profile |
| Comparative Example 4-3 | Comparative AL-7 | 45 | Trailing profile |
| Comparative Example 4-4 | Comparative AL-8 | 56 | Vertical profile |
| Comparative Example 4-5 | Comparative AL-10 | 54 | Vertical profile |
| Comparative Example 4-6 | Comparative AL-11 | 56 | Vertical profile |

As shown in Table 10, it can be observed that in Examples 4-1 and 4-2, where the inventive materials (AL-1, AL-4) for forming an adhesive film were used, the collapse limit was small and the pattern profile was also excellent. On the other hand, in Comparative Examples 4-1 and 4-2, where no photo-acid generator was contained, it can be observed that no difference occurred between the amounts of polar groups in the exposed portions and the unexposed portions, and that therefore, either adhesiveness or pattern profile was degraded. Meanwhile, in Comparative Example 4-3, adhesiveness was excellent, but the pattern had a trailing profile. In Comparative Examples 4-4 to 4-6, including Comparative Example 4-6, where a composition proposed in Patent Document 6 was used, the pattern was rectangular, but adhesiveness was somewhat degraded compared to the adhesive films of the present invention.

### Example 5: Patterning Test by EUV Exposure using Positive Resist (Examples 5-1 to 5-3, Comparative Examples 5-1 to 5-3)

Spin-on carbon ODL-301 (carbon content: 88 mass%) available from Shin-Etsu Chemical Co., Ltd. was applied to silicon wafer substrates and the resulting substrates were baked at 350°C for 60 seconds to form a 100-nm thick resist underlayer film. A silicon-containing spin-on hard mask SHB-A940 (silicon content: 43 mass%) available from Shin-Etsu Chemical Co., Ltd. was applied thereto and baked at 220°C for 60 seconds to form a 15-nm thick silicon-containing middle layer film. Furthermore, each of the compositions (AL-7 to AL-8, AL-25, comparative AL-3, comparative AL-6, comparative AL-11) for forming an adhesive film was respectively applied and baked at 220°C for 60 seconds to form a 5-nm thick (AL-7 to AL-8, comparative AL-3, comparative AL-6, comparative AL-11) or 20-nm thick (AL-25) adhesive film. A composition for forming a positive resist upper layer film shown in Table 11 was applied thereon and baked at 100°C for 60 seconds to form a resist upper layer film having a film thickness of 40 nm.

The composition (monolayer resist for EUV) for forming a positive resist upper layer film was prepared by: dissolving a polymer compound PRP1 and a quencher Q1 into a solvent containing 0.1 mass% of FC-4430 (available from Sumitomo 3M Ltd.) in proportions shown in Table 11; and filtering the solution through a 0.1-pm filter made of a fluorinated resin.

**[Table 11]**

| | Polymer compound (parts by mass) | Quencher (parts by mass) | Organic solvent (parts by mass) |
|---|---|---|---|
| Monolayer resist for EUV | PRP1 (100) | Q1 (0.25) | PGMEA/DAA (3,000/1,000) |

Polymer for resist: PRP1
Molecular weight Mw = 9,200
Dispersity Mw/Mn = 1.8

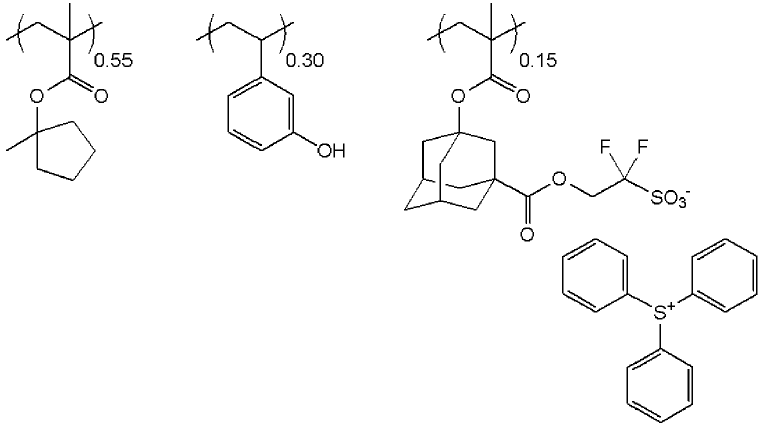

Quencher: Q1

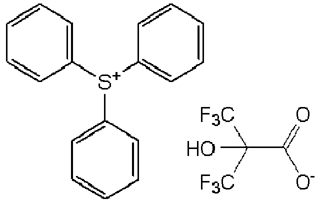

Next, an 18-nm 1:1 line-and-space (LS) pattern was exposed using an EUV exposure apparatus (EUV scanner NXE3400 manufactured by ASML, NA: 0.33, σ: 0.9, 90° dipole illumination), baked (PEB) at 90°C for 60 seconds, and developed with a 2.38 mass% aqueous solution of tetramethylammonium hydroxide (TMAH) for 30 seconds. Thus, a line-and-space pattern having a space width of 18 nm and a pitch of 36 nm was obtained. Regarding this pattern, the sectional profile and roughness were observed with an electron microscope. The collapse limit (nm) was a minimum width of the lines which could be resolved without collapse when the line width was reduced by gradually increasing the exposure dose from the exposure dose at which the line-and-space pattern was formed. A smaller value indicates higher and better collapse resistance.

The cross-sectional profile of the obtained pattern was evaluated with an electron microscope (S-4700) manufactured by Hitachi, Ltd. and the pattern roughness was evaluated with an electron microscope (CG6300) manufactured by Hitachi High-Technologies Corp. Table 12 shows the results.

**[Table 12]**

| | Material for forming adhesive film | Pattern roughness (nm) | Collapse limit (nm) | Pattern sectional profile after development |
|---|---|---|---|---|
| Example 5-1 | AL-7 | 1.7 | 15 | Vertical profile |
| Example 5-2 | AL-8 | 1.6 | 14 | Vertical profile |
| Example 5-3 | AL-25 | 1.5 | 15 | Vertical profile |
| Comparative Example 5-1 | Comparative AL-3 | 2.2 | 14 | Trailing profile |
| Comparative Example 5-2 | Comparative AL-6 | 2.5 | 19 | Vertical profile |
| Comparative Example 5-3 | Comparative AL-11 | 2.0 | 16 | Vertical profile |

As shown in Table 12, in Examples 5-1 to 5-3, where the compositions AL-7, AL-8, and AL-25 for forming an adhesive film were used, excellent collapse suppression performance was exhibited, and moreover, the pattern was rectangular. On the other hand, in Comparative Examples 5-1 and 5-2, where no photo-acid generator was contained, it can be observed that no difference occurred between the amounts of polar groups in the exposed portions and the unexposed portions, and that therefore, either adhesiveness or pattern profile was degraded. Meanwhile, in Comparative Example 5-3, where a composition proposed in Patent Document 6 was used, the pattern was rectangular, but adhesiveness was somewhat poor compared to that of the adhesive film of the present invention, and in addition, pattern roughness was rather high.

### Example 6: Etching Evaluation (Examples 6-1 to 6-3, Comparative Examples 6-1 to 6-3)

Following the resist upper layer film pattern formation of Example 5, the silicon-containing middle layer film was dry-etched (the pattern was transferred) by using an etching apparatus Telius manufactured by Tokyo Electron Ltd. while using the resist upper layer film pattern as a mask. Then, the resist underlayer film was dry-etched (the pattern was transferred) while using the obtained silicon-containing middle layer film pattern as a mask to form a resist underlayer film pattern. The etching conditions were as shown below.

Conditions in transferring resist upper layer film pattern to silicon-containing middle layer film
Chamber pressure: 10.0 Pa
RF-power: 1500 W
CF₄ gas flow rate: 75 mL/min
O₂ gas flow rate: 15 mL/min
Time: 15 sec

Conditions in transferring silicon-containing middle layer film pattern to resist underlayer film Chamber pressure: 2.0 Pa
RF-power: 500 W
Ar gas flow rate: 75 mL/min
O₂ gas flow rate: 45 mL/min
Time: 90 sec

It was confirmed whether or not it was possible to form a resist underlayer film pattern by a top-down SEM view of the wafer after the pattern transfer (dry-etching) to the resist underlayer film. Table 13 shows the evaluation results.

**[Table 13]**

| | Material for forming adhesive film | Resist underlayer film pattern |
|---|---|---|
| Example 6-1 | AL-7 | Formation possible |
| Example 6-2 | AL-8 | Formation possible |
| Example 6-3 | AL-25 | Formation possible |
| Comparative Example 6-1 | Comparative AL-3 | Formation not possible |
| Comparative Example 6-2 | Comparative AL-6 | Formation not possible |
| Comparative Example 6-3 | Comparative AL-11 | Formation not possible |

As shown in Table 13, in the inventive patterning processes (Example 6-1 to Example 6-3), the resist upper layer film pattern was transferred favorably to the resist underlayer film either in the case where the adhesive film had a thickness of 5 nm (Example 6-1 and Example 6-2) or in the case where the thickness was 20 nm (Example 6-3), and it can be seen that the adhesive films of the present invention are effective for fine patterning by a multilayer resist method. On the contrary, in Comparative Example 6-1 to Comparative Example 6-3, it was not possible to form a resist underlayer film pattern. This result is caused by the fact that profile defects occurred in the resist pattern.

From the above, the inventive materials for forming an adhesive film have high adhesiveness to a resist upper layer film, and at the same time, have an excellent effect of preventing scum in space portions, and are therefore extremely useful as adhesive film materials to be used in multilayer resist methods. In addition, according to the inventive patterning processes using these materials, a fine pattern can be formed in a substrate to be processed with high precision.

The present description includes the following embodiments.
[1]: A material for forming an adhesive film for an adhesive film formed directly under a resist upper layer film, comprising:
   (A) a resin having a structural unit containing an acid-dissociable group and having at least two kinds of structural units represented by the following general formula (1), the resin optionally having a structural unit that generates an acid due to light; and
   (C) an organic solvent, wherein the material for forming an adhesive film comprises
   (B) a photo-acid generator, the resin (A) having the structural unit that generates an acid due to light, or both the photo-acid generator (B) and the resin (A) having the acid-generating structural unit, 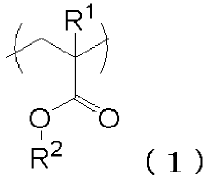 wherein R¹ represents a hydrogen atom or a methyl group and R² represents a group selected from the following formulae (1-1) to (1-3), 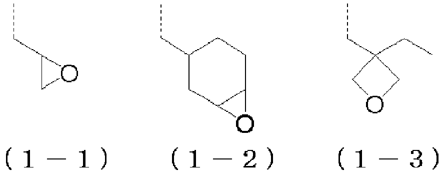 wherein a broken line represents an attachment point.
[2]: The material for forming an adhesive film of the above [1], wherein the structural unit containing an acid-dissociable group is represented by any of the following general formulae (2) to (4), 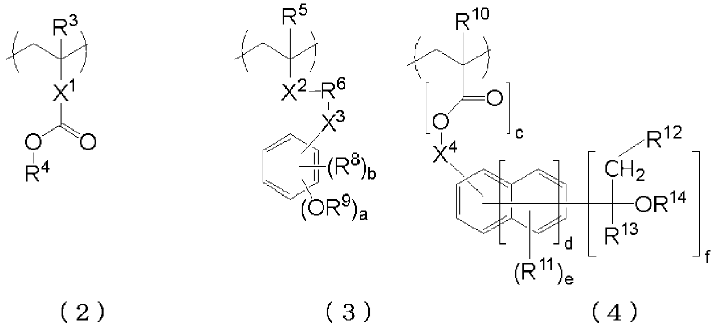 wherein R³, R⁵, and R¹⁰ each independently represent a hydrogen atom or a methyl group; R⁴ and R⁹ each independently represent an acid-dissociable group; X¹ represents a single bond or a linking group having 1 to 14 carbon atoms and containing a phenylene group, a naphthylene group, an ester bond, an ether bond, or a lactone ring; X² represents a single bond, an ester bond, or an amide bond; X³ represents a single bond, an ether bond, or an ester bond; R⁶ represents a single bond or a saturated hydrocarbylene group having 1 to 6 carbon atoms, part of the carbon atoms optionally being substituted with an ether bond or an ester bond; R⁸ represents a fluorine atom, a trifluoromethyl group, a cyano group, or a saturated hydrocarbyl group having 1 to 6 carbon atoms; "a" represents 1 or 2 and "b" represents an integer of 0 to 4, provided that 1 ≤ a + b ≤ 5; X⁴ represents a single bond or an alkylene group having 1 to 10 carbon atoms and optionally containing an ethereal oxygen atom in a chain thereof; each R¹¹ independently represents a hydrogen atom, a halogen atom, a linear, branched, or cyclic acyloxy group having 2 to 8 carbon atoms and optionally being halogenated, a linear, branched, or cyclic alkyl group having 1 to 6 carbon atoms and optionally being halogenated, or a linear, branched, or cyclic alkoxy group having 1 to 6 carbon atoms and optionally being halogenated; R¹² and R¹³ each independently represent a hydrogen atom, a linear or branched alkyl group having 1 to 15 carbon atoms and optionally being substituted with a hydroxy group or an alkoxy group, or a monovalent aromatic ring-containing group optionally having a substituent; R¹⁴ represents a hydrogen atom, a linear, branched, or cyclic monovalent aliphatic hydrocarbon group having 1 to 10 carbon atoms and optionally containing an ethereal oxygen atom in a chain or containing a carbonyl group or a carbonyloxy group in a chain or at an end of a chain, or a monovalent aromatic ring-containing group optionally having a substituent, OR¹⁴ being an acid-dissociable group; "c" represents 0 or 1; "d" represents an integer of 0 to 2; "f" represents an integer of 1 to 3; and "e" equals 5+2d-f.
[3]: The material for forming an adhesive film of the above [1] or [2], wherein the resin (A) further has at least one of structural units represented by the following general formulae (5) and (6), 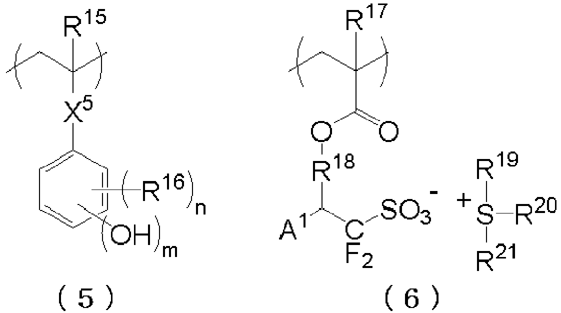 wherein R¹⁵ and R¹⁷ each independently represent a hydrogen atom or a methyl group; R¹⁶ represents an alkyl group having 1 to 3 carbon atoms; "m" represents an integer of 1 or 2 and "n" represents an integer of 0 to 4, provided that m+n is an integer of 1 or more and 5 or less; X⁵ represents a single bond or an alkylene group having 1 to 10 carbon atoms and optionally containing an oxygen atom; R¹⁸ represents a single bond, -Z²¹-C(=O)-O-, -Z²¹-O-, or -Z²¹-O-C(=O)-; Z²¹ represents a saturated hydrocarbylene group having 1 to 12 carbon atoms and optionally containing a carbonyl group, an ester bond, or an ether bond; R¹⁹ to R²¹ each independently represent a hydrocarbyl group having 1 to 20 carbon atoms and optionally containing a heteroatom, any two of R¹⁹, R²⁰, and R²¹ optionally bonding with each other to form a ring together with a sulfur atom bonded therewith; and A¹ represents a hydrogen atom or a trifluoromethyl group.
[4] : The material for forming an adhesive film of the above [3], wherein a total number of moles of the structural unit represented by the general formula (1) is 0.10 or more and 0.99 or less, a total number of moles of the structural unit containing an acid-dissociable group is 0.001 or more and 0.60 or less, and a total number of moles of the structural units represented by (5) and (6) is 0 or more and 0.60 or less where a total number of moles of all the structural units in the resin (A) is 1.0.
[5] : The material for forming an adhesive film of any one of the above [1] to [4], wherein the resin (A) has a weight-average molecular weight of 3,000 to 70,000.
[6] : The material for forming an adhesive film of any one of the above [1] to [5], further comprising one or more of (D) a surfactant, (E) a crosslinking agent, and (F) a thermal acid generator.
[7] : A material for forming an adhesive film for a negative resist film, being the material for forming an adhesive film of the above [2], wherein the structural unit containing an acid-dissociable group is represented by the general formula (2) or (3).
[8]: A material for forming an adhesive film for a positive resist film, being the material for forming an adhesive film of the above [2], wherein the structural unit containing an acid-dissociable group is represented by the general formula (4).
[9]: A coating film for forming an adhesive film, comprising the material for forming an adhesive film of any one of the above [1] to [6] and having a thickness of 2 nm or more and 50 nm or less.
[10]: A patterning process for forming a pattern in a substrate to be processed, comprising the steps of:
   (I-1) applying the material for forming an adhesive film of any one of the above [1] to [6] on a substrate to be processed and then performing a heat treatment to form an adhesive film;
   (I-2) forming a resist upper layer film on the adhesive film by using a photoresist material;
   (I-3) subjecting the resist upper layer film to pattern exposure and then to development with a developer to form a pattern in the resist upper layer film;
   (I-4) transferring the pattern to the adhesive film by dry etching while using the resist upper layer film having the formed pattern as a mask; and
   (I-5) forming the pattern in the substrate to be processed by etching the substrate to be processed while using the adhesive film having the formed pattern as a mask.
[11]: A patterning process for forming a pattern in a substrate to be processed, comprising the steps of:
   (II-1) forming a resist underlayer film on a substrate to be processed;
   (II-2) forming a silicon-containing resist middle layer film on the resist underlayer film;
   (II-3) applying the material for forming an adhesive film of any one of the above [1] to [6] on the silicon-containing resist middle layer film and then performing a heat treatment to form an adhesive film;
   (II-4) forming a resist upper layer film on the adhesive film by using a photoresist material;
   (II-5) subjecting the resist upper layer film to pattern exposure and then to development with a developer to form a pattern in the resist upper layer film;
   (II-6) transferring the pattern to the adhesive film by dry etching while using the resist upper layer film having the formed pattern as a mask;
   (II-7) transferring the pattern to the silicon-containing resist middle layer film by dry etching while using the adhesive film having the formed pattern as a mask;
   (II-8) transferring the pattern to the resist underlayer film by dry etching while using the silicon-containing resist middle layer film having the transferred pattern as a mask; and
   (II-9) forming the pattern in the substrate to be processed by etching the substrate to be processed while using the resist underlayer film having the formed pattern as a mask.
[12]: A patterning process for forming a pattern in a substrate to be processed, comprising the steps of:
   (III-1) forming a resist underlayer film on a substrate to be processed;
   (III-2) forming an inorganic hard mask middle layer film selected from a silicon oxide film, a silicon nitride film, and a silicon oxynitride film on the resist underlayer film;
   (III-3) applying the material for forming an adhesive film of any one of the above [1] to [6] on the inorganic hard mask middle layer film and then performing a heat treatment to form an adhesive film;
   (III-4) forming a resist upper layer film on the adhesive film by using a photoresist material;
   (III-5) subjecting the resist upper layer film to pattern exposure and then to development with a developer to form a pattern in the resist upper layer film;
   (III-6) transferring the pattern to the adhesive film by dry etching while using the resist upper layer film having the formed pattern as a mask;
   (III-7) transferring the pattern to the inorganic hard mask middle layer film by dry etching while using the adhesive film having the formed pattern as a mask;
   (III-8) transferring the pattern to the resist underlayer film by dry etching while using the inorganic hard mask middle layer film having the transferred pattern as a mask; and
   (III-9) forming the pattern in the substrate to be processed by etching the substrate to be processed while using the resist underlayer film having the formed pattern as a mask.
[13]: The patterning process of the above [12], wherein the inorganic hard mask middle layer film is formed by a CVD method or an ALD method.
[14]: The patterning process of any one of the above [10] to [13], wherein photolithography at a wavelength of 10 nm or more to 300 nm or less, a direct drawing by electron beam, a nanoimprinting, or a combination thereof is employed as a method for forming the pattern in the resist upper layer film.
[15]: The patterning process of any one of the above [10] to [14], wherein the development is selected from alkaline development or development with an organic solvent.
[16]: The patterning process of any one of the above [10] to [15], wherein the substrate to be processed is a semiconductor device substrate or the semiconductor device substrate coated with any of a metal film, a metal carbide film, a metal oxide film, a metal nitride film, a metal oxycarbide film, and a metal oxynitride film.
[17]: The patterning process of the above [16], wherein as the metal, silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof is used.
[18]: The patterning process of any one of the above [10] to [17], wherein the material for forming an adhesive film is applied to have a thickness of 2 nm or more and 50 nm or less in the step of forming the adhesive film.
[19]: The patterning process of any one of the above [10] to [18], wherein the resist upper layer film is formed using a resist upper layer film material containing at least an organic metal compound and a solvent.
[20]: The patterning process of the above [19], wherein the organic metal compound contains at least one selected from titanium, cobalt, copper, zinc, zirconium, lead, indium, tin, antimony, and hafnium.
[21]: A method for forming an adhesive film that functions as an adhesive layer employed in a semiconductor device manufacturing process, the method comprising:
   spin-coating a substrate to be processed with the material for forming an adhesive film of any one of the above [1] to [6]; and
   heating the substrate coated with the material for forming an adhesive film at a temperature of 100°C or higher to 300°C or lower for 10 to 600 seconds to form a cured film.
[22]: A method for forming an adhesive film that functions as an adhesive layer employed in a semiconductor device manufacturing process, the method comprising:
   spin-coating a substrate to be processed with the material for forming an adhesive film of any one of the above [1] to [6]; and
   heating the substrate coated with the material for forming an adhesive film in an atmosphere having an oxygen concentration of 0.1% or more to 21% or less to form a cured film.
[23]: A method for forming an adhesive film that functions as an adhesive layer employed in a semiconductor device manufacturing process, the method comprising:
   spin-coating a substrate to be processed with the material for forming an adhesive film of any one of the above [1] to [6]; and
   heating the substrate coated with the material for forming an adhesive film in an atmosphere having an oxygen concentration of less than 0.1% to form a cured film.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A material for forming an adhesive film for an adhesive film formed directly under a resist upper layer film, comprising:
(A) a resin having a structural unit containing an acid-dissociable group and having at least two kinds of structural units represented by the following general formula (1), the resin optionally having a structural unit that generates an acid due to light; and
(C) an organic solvent, wherein
the material for forming an adhesive film comprises
(B) a photo-acid generator, the resin (A) having the structural unit that generates an acid due to light, or both the photo-acid generator (B) and the resin (A) having the acid-generating structural unit, 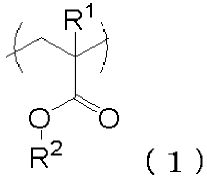 wherein R¹ represents a hydrogen atom or a methyl group and R² represents a group selected from the following formulae (1-1) to (1-3), 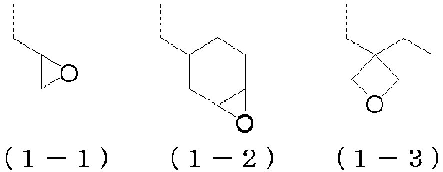 wherein a broken line represents an attachment point.

2. The material for forming an adhesive film according to claim 1, wherein the structural unit containing an acid-dissociable group is represented by any of the following general formulae (2) to (4), 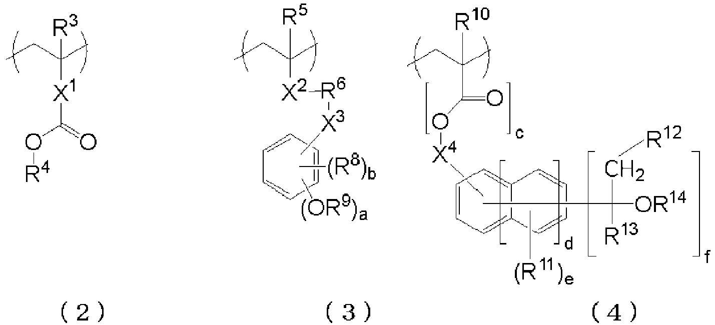 wherein R³, R⁵, and R¹⁰ each independently represent a hydrogen atom or a methyl group; R⁴ and R⁹ each independently represent an acid-dissociable group; X¹ represents a single bond or a linking group having 1 to 14 carbon atoms and containing a phenylene group, a naphthylene group, an ester bond, an ether bond, or a lactone ring; X² represents a single bond, an ester bond, or an amide bond; X³ represents a single bond, an ether bond, or an ester bond; R⁶ represents a single bond or a saturated hydrocarbylene group having 1 to 6 carbon atoms, part of the carbon atoms optionally being substituted with an ether bond or an ester bond; R⁸ represents a fluorine atom, a trifluoromethyl group, a cyano group, or a saturated hydrocarbyl group having 1 to 6 carbon atoms; "a" represents 1 or 2 and "b" represents an integer of 0 to 4, provided that 1 ≤ a + b ≤ 5; X⁴ represents a single bond or an alkylene group having 1 to 10 carbon atoms and optionally containing an ethereal oxygen atom in a chain thereof; each R¹¹ independently represents a hydrogen atom, a halogen atom, a linear, branched, or cyclic acyloxy group having 2 to 8 carbon atoms and optionally being halogenated, a linear, branched, or cyclic alkyl group having 1 to 6 carbon atoms and optionally being halogenated, or a linear, branched, or cyclic alkoxy group having 1 to 6 carbon atoms and optionally being halogenated; R¹² and R¹³ each independently represent a hydrogen atom, a linear or branched alkyl group having 1 to 15 carbon atoms and optionally being substituted with a hydroxy group or an alkoxy group, or a monovalent aromatic ring-containing group optionally having a substituent; R¹⁴ represents a hydrogen atom, a linear, branched, or cyclic monovalent aliphatic hydrocarbon group having 1 to 10 carbon atoms and optionally containing an ethereal oxygen atom in a chain or containing a carbonyl group or a carbonyloxy group in a chain or at an end of a chain, or a monovalent aromatic ring-containing group optionally having a substituent, OR¹⁴ being an acid-dissociable group; "c" represents 0 or 1; "d" represents an integer of 0 to 2; "f" represents an integer of 1 to 3; and "e" equals 5+2d-f.

3. The material for forming an adhesive film according to claim 1 or 2, wherein the resin (A) further has at least one of structural units represented by the following general formulae (5) and (6), 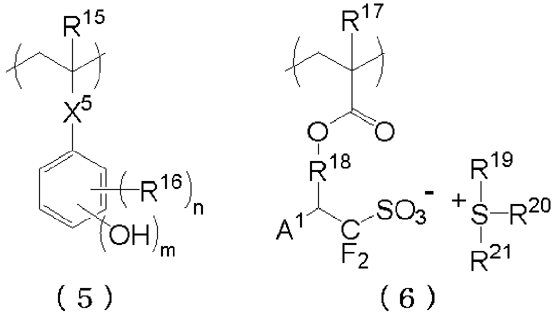 wherein R¹⁵ and R¹⁷ each independently represent a hydrogen atom or a methyl group; R¹⁶ represents an alkyl group having 1 to 3 carbon atoms; "m" represents an integer of 1 or 2 and "n" represents an integer of 0 to 4, provided that m+n is an integer of 1 or more and 5 or less; X⁵ represents a single bond or an alkylene group having 1 to 10 carbon atoms and optionally containing an oxygen atom; R¹⁸ represents a single bond, -Z²¹-C(=O)-O-, -Z²¹-O-, or -Z²¹-O-C(=O)-; Z²¹ represents a saturated hydrocarbylene group having 1 to 12 carbon atoms and optionally containing a carbonyl group, an ester bond, or an ether bond; R¹⁹ to R²¹ each independently represent a hydrocarbyl group having 1 to 20 carbon atoms and optionally containing a heteroatom, any two of R¹⁹, R²⁰, and R²¹ optionally bonding with each other to form a ring together with a sulfur atom bonded therewith; and A¹ represents a hydrogen atom or a trifluoromethyl group.

4. The material for forming an adhesive film according to claim 3, wherein a total number of moles of the structural unit represented by the general formula (1) is 0.10 or more and 0.99 or less, a total number of moles of the structural unit containing an acid-dissociable group is 0.001 or more and 0.60 or less, and a total number of moles of the structural units represented by (5) and (6) is 0 or more and 0.60 or less where a total number of moles of all the structural units in the resin (A) is 1.0.

5. The material for forming an adhesive film according to any one of claims 1 to 4, wherein the resin (A) has a weight-average molecular weight of 3,000 to 70,000.

6. The material for forming an adhesive film according to any one of claims 1 to 5, further comprising one or more of (D) a surfactant, (E) a crosslinking agent, and (F) a thermal acid generator.

7. A material for forming an adhesive film for a negative resist film, being the material for forming an adhesive film according to claim 2, wherein the structural unit containing an acid-dissociable group is represented by the general formula (2) or (3).

8. A material for forming an adhesive film for a positive resist film, being the material for forming an adhesive film according to claim 2, wherein the structural unit containing an acid-dissociable group is represented by the general formula (4).

9. A coating film for forming an adhesive film, comprising the material for forming an adhesive film according to any one of claims 1 to 6 and having a thickness of 2 nm or more and 50 nm or less.

10. A patterning process for forming a pattern in a substrate to be processed, comprising the steps of:
(A)
(I-1) applying the material for forming an adhesive film according to any one of claims 1 to 6 on a substrate to be processed and then performing a heat treatment to form an adhesive film;
(I-2) forming a resist upper layer film on the adhesive film by using a photoresist material;
(I-3) subjecting the resist upper layer film to pattern exposure and then to development with a developer to form a pattern in the resist upper layer film;
(I-4) transferring the pattern to the adhesive film by dry etching while using the resist upper layer film having the formed pattern as a mask; and
(I-5) forming the pattern in the substrate to be processed by etching the substrate to be processed while using the adhesive film having the formed pattern as a mask; or
(B)
(II-1) forming a resist underlayer film on a substrate to be processed;
(II-2) forming a silicon-containing resist middle layer film on the resist underlayer film;
(II-3) applying the material for forming an adhesive film according to any one of claims 1 to 6 on the silicon-containing resist middle layer film and then performing a heat treatment to form an adhesive film;
(II-4) forming a resist upper layer film on the adhesive film by using a photoresist material;
(II-5) subjecting the resist upper layer film to pattern exposure and then to development with a developer to form a pattern in the resist upper layer film;
(II-6) transferring the pattern to the adhesive film by dry etching while using the resist upper layer film having the formed pattern as a mask;
(II-7) transferring the pattern to the silicon-containing resist middle layer film by dry etching while using the adhesive film having the formed pattern as a mask;
(II-8) transferring the pattern to the resist underlayer film by dry etching while using the silicon-containing resist middle layer film having the transferred pattern as a mask; and
(II-9) forming the pattern in the substrate to be processed by etching the substrate to be processed while using the resist underlayer film having the formed pattern as a mask; or
(C)
(III-1) forming a resist underlayer film on a substrate to be processed;
(III-2) forming an inorganic hard mask middle layer film selected from a silicon oxide film, a silicon nitride film, and a silicon oxynitride film on the resist underlayer film;
(III-3) applying the material for forming an adhesive film according to any one of claims 1 to 6 on the inorganic hard mask middle layer film and then performing a heat treatment to form an adhesive film;
(III-4) forming a resist upper layer film on the adhesive film by using a photoresist material;
(III-5) subjecting the resist upper layer film to pattern exposure and then to development with a developer to form a pattern in the resist upper layer film;
(III-6) transferring the pattern to the adhesive film by dry etching while using the resist upper layer film having the formed pattern as a mask;
(III-7) transferring the pattern to the inorganic hard mask middle layer film by dry etching while using the adhesive film having the formed pattern as a mask;
(III-8) transferring the pattern to the resist underlayer film by dry etching while using the inorganic hard mask middle layer film having the transferred pattern as a mask; and
(III-9) forming the pattern in the substrate to be processed by etching the substrate to be processed while using the resist underlayer film having the formed pattern as a mask.

11. The patterning process according to claim 10(C), wherein the inorganic hard mask middle layer film is formed by a CVD method or an ALD method.

12. The patterning process according to claim 10 or 11,
(A) wherein photolithography at a wavelength of 10 nm or more to 300 nm or less, a direct drawing by electron beam, a nanoimprinting, or a combination thereof is employed as a method for forming the pattern in the resist upper layer film; or
(B) wherein the development is selected from alkaline development or development with an organic solvent; or
(C) wherein the substrate to be processed is a semiconductor device substrate or the semiconductor device substrate coated with any of a metal film, a metal carbide film, a metal oxide film, a metal nitride film, a metal oxycarbide film, and a metal oxynitride film, optionally where as the metal, silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof is used; or
(D) wherein the material for forming an adhesive film is applied to have a thickness of 2 nm or more and 50 nm or less in the step of forming the adhesive film.

13. The patterning process according to any one of claims 10 to 12, wherein the resist upper layer film is formed using a resist upper layer film material containing at least an organic metal compound and a solvent, optionally the organic metal compound containing at least one selected from titanium, cobalt, copper, zinc, zirconium, lead, indium, tin, antimony, and hafnium.

14. A method for forming an adhesive film that functions as an adhesive layer employed in a semiconductor device manufacturing process, the method comprising:
(A)
spin-coating a substrate to be processed with the material for forming an adhesive film according to any one of claims 1 to 6; and
heating the substrate coated with the material for forming an adhesive film at a temperature of 100°C or higher to 300°C or lower for 10 to 600 seconds to form a cured film; or
(B)
spin-coating a substrate to be processed with the material for forming an adhesive film according to any one of claims 1 to 6; and
heating the substrate coated with the material for forming an adhesive film in an atmosphere having an oxygen concentration of 0.1% or more to 21% or less to form a cured film; or
(C)
spin-coating a substrate to be processed with the material for forming an adhesive film according to any one of claims 1 to 6; and
heating the substrate coated with the material for forming an adhesive film in an atmosphere having an oxygen concentration of less than 0.1% to form a cured film.
